# EUROPÄISCHE PATENTSCHRIFT

(11) **EP 3 570 055 B1**
(45) Veröffentlichungstag und Bekanntmachung des Hinweises auf die Patenterteilung: **12.04.2023**
(21) Anmeldenummer: 19179304.1
(22) Anmeldetag: 18.01.2017
(51) Int. Cl.: G01R 31/3185, B60Q 1/00, G06F 13/00, H05B 47/18

(54) **JTAG-SCHNITTSTELLEN ZUR STEUERUNG DER ANSTEUERVORRICHTUNG VON LEUCHTMITTELN EINER LEUCHTKETTE**
JTAG INTERFACES FOR CONTROLLING THE CONTROL DEVICE OF LIGHTS IN A LIGHTING CHAIN
INTERFACES JTAG DESTINÉES À LA COMMANDE DU DISPOSITIF DE COMMANDE DES ÉLÉMENTS LUMINEUX D'UNE CHAÎNE LUMINEUSE

(30) Priorität: 19.01.2016 DE 102016100837; 19.01.2016 DE 102016100839; 19.01.2016 DE 102016100838; 19.01.2016 DE 102016100840; 19.01.2016 DE 102016100842; 19.01.2016 DE 102016100843; 19.01.2016 DE 102016100844; 19.01.2016 DE 102016100845; 19.01.2016 DE 102016100847; 19.01.2016 DE 102016100841; 23.01.2016 DE 102016101181; 05.12.2016 DE 102016123400
(43) Veröffentlichungstag der Anmeldung: 20.11.2019
(62) Teilanmeldung aus: 17701659.9
(73) Patentinhaber: Elmos Semiconductor SE, 44227 Dortmund (DE)
(72) Erfinder: Schmitz, Christian, 44575 Castrop-Rauxel (DE)
(74) Vertreter: dompatent von Kreisler Selting Werner - Partnerschaft von Patent- und Rechtsanwälten mbB

(56) Entgegenhaltungen:
- DE-T2- 69 612 092
- DE-U1-202008 012 029
- US-A1- 2004 061 528
- US-A1- 2007 033 465

## Beschreibung

Die Erfindung betrifft ein Verfahren zur Datenübertragung auf einen Datenbus.

In der Automobilindustrie sollen in Zukunft Leuchtbänder aus Leuchtdioden (LEDs) mit vorzugsweise mehreren Farben eingesetzt werden können. Diese LEDs sollen mittels der bekannten Puls-Modulations-Verfahren wie Puls-Weiten-Modulation (PWM), Puls-Code-Modulation (PCM), Puls-Count-Modulation (PCM), Phasen-Offset-Modulation (POM), Puls-Dichte-Modulation (PDM), Puls-Frequenz-Modulation (PFM) etc. angesteuert und mit Energie versorgt werden. Die entsprechenden Modulationsarten kann der Fachmann der einschlägigen Literatur entnehmen. Wenn im Folgenden von PWM die Rede ist, sind damit im Rahmen der Erfindung sämtliche Pulsmodulationsarten gemeint, die derzeit im Stand der Technik bekannt sind bzw. noch bekannt werden. Je nach dem mittleren Spannungs- oder Strompegel, dem die jeweilige LED ausgesetzt ist, kann die LED in der Helligkeit und ggf. in gewissem Umfang auch in der Farbtemperatur eingestellt werden. Somit bestimmen beispielsweise im Falle einer PWM-Modulation der Duty-Cycle und der Pegel die Helligkeitserscheinung und die wahrgenommene Farbtemperatur.

Die LEDs des Leuchtbandes sind üblicherweise über die Länge des Leuchtbandes gleichverteilt.

Im Stand der Technik ist es üblich, mehrere integrierte Schaltungen, die sich als Busknoten mehr oder weniger ebenfalls gleichverteilt auf dem Leuchtband befinden, zur Ansteuerung der LEDs zu benutzen. Typischerweise sind jedem Busknoten dabei mehrere Leuchtmittel, vorzugsweise LEDs, zugeordnet, die von einem Busknoten dann jeweils gesteuert werden.

Diese Ansteuerung erfolgt für die einzelne integrierte Schaltung für eine einzelne LED oder für mehrere auf dem Leuchtband typischerweise hintereinander angeordnete LEDs, also für einen Leuchtbandabschnitt, der dieser integrierten Schaltung zugeordnet ist.

Im Stand der Technik ist es nun üblich, diese integrierten Schaltungen jeweils mit einem Schieberegister mit einem Eingang und einem Ausgang zu versehen. Der Eingang eines nachfolgenden Schieberegisters einer auf dem Leuchtband nachfolgenden integrierten Schaltung ist dabei mit dem Ausgang des Schieberegisters der auf dem Leuchtband vorausgehenden integrierten Schaltung verbunden. Die erste integrierte Schaltung des Leuchtbandes ist statt mit einer vorausgehenden integrierten Schaltung mit einem Bus-Master (BM) verbunden, der die Daten und den Schiebetakt erzeugt. Typischerweise handelt es sich bei dem Bus-Master (BM) um einen Micro-Controller.

Der Bus-Master (BM) versorgt über eine Taktleitung alle Schieberegistersegmente aller integrierten Schaltungen entlang einer entsprechend zusammengesetzten Schieberegisterkette mit dem notwendigen Schiebetakt und einem Übernahmesignal, mit dem die aktuellen Werte in den Segmenten der Schieberegisterkette in Schatten-Register der integrierten Schaltungen geladen werden, welche die PWM-Erzeugung steuern.

Um die benötigten Informationen zu übertragen, erzeugt der Bus-Master (BM) also einen seriellen Datenstrom, der die Informationen über Helligkeit und/oder Farbtemperatur enthält, schiebt diese in der bit-richtigen Reihenfolge in die Schieberegisterkette und signalisiert im korrekten Takt den integrierten Schaltkreisen die Übernahme, woraufhin diese ihre Schattenregister entsprechend laden und die PWM-Modulation der LED-Treiber bezüglich Amplitude und Duty-Cycle bzw. Füllfaktor entsprechend den geladenen Helligkeits- und Farbtemperaturwerten einstellen.

Hierbei treten bei der Verwendung im Automobil mehrere Probleme auf, die zu lösen sind.

Zum Ersten erfordert die aus dem Stand der Technik bekannte Vorgehensweise und die aus dem Stand der Technik bekannte Anordnung zur Steuerung eines derartigen Leuchtbandes eine Versorgungsspannungsleitung, eine Masseleitung, eine Taktleitung, eine Signalisierungsleitung und eine Datenleitung, also insgesamt fünf Leitungen. Als Masseleitung kann ggf. die Karosserie des Autos genutzt werden, wenn diese nicht aus nicht leitendem Kunststoff oder einem anderen Isolator ist. Es verbleibt dann immer noch die Notwendigkeit von vier Leitungen. Dies führt zu Kosten und einer Gewichtszunahme.

Zum Zweiten ist kein Rückkanal vorgesehen, um beispielsweise Fehlerfälle erkennen zu können und/oder die Temperatur am Ort der LED messen zu können und/oder einen Selbsttest durchführen zu können etc.

Es ist also eine Lösung erforderlich, die die Programmierung und das Auslesen der integrierten Schaltungen über eine einzige Datenleitung ermöglicht.

Aus dem Stand der Technik ist das JTAG-Protokoll bekannt. Das JTAG-Protokoll hat sich zu einer der führenden Hilfsmittel bei der Programmierung, dem Test, dem Debugging und der Emulation von integrierten Schaltkreisen entwickelt. In einem Verfahren, das als Boundary-Scan-Verfahren bezeichnet wird, kann ein Host-Prozessor den Zustand einer integrierten Schaltung kontrollieren. Insbesondere ist der Host-Prozessor als Bus-Master über eine spezielle Schnittstelle, die JTAG-Schnittstelle nach IEEE 1149-Standard, in der Lage, die integrierte Schaltung als Busknoten geeignet zu programmieren und ggf. zu initialisieren. Des Weiteren ist der Host-Prozessor als Bus-Master in der Lage, den Zustand der integrierten Schaltung nach einer vorbestimmten Anzahl von Systemtaktperioden der JTAG-Schnittstelle nach IEEE 1149-Standard oder bei Erkennung eines vorbestimmten Ereignisses auszulesen oder während des Betriebs der integrierten Schaltung, d.h. des Busknotens, abzuändern. Dies umfasst auch das Anhalten der integrierten Schaltung oder den zwangsweisen Wechsel in andere Zustände oder das Ändern von Speicherinhalten. Das JTAG-Protokoll ist aber eine Punkt-zu-Punkt-Verbindung und damit für die Steuerung automobiler Leuchtbänder ungeeignet. Aus EP-B-0 503 117 ist zwar eine Verkettung von JTAG-Testschnittstellen seit langem bekannt. Diese Druckschrift offenbart aber die Verkettung von Vierdraht-JTAG-Schnittstellen. Damit erfüllt die bekannte Schnittstelle die Anforderung an die Ansteuerung automobiler LED basierender Lichtbänder durch einen Eindrahtdatenbus nicht.

Die im weiteren Verlauf beschriebene Erfindung betrifft somit ein Verfahren und eine Vorrichtung zur verketteten Steuerung und/oder zur Programmierung mehrerer integrierter Schaltungen, Mikrosysteme inkl. mikroelektromechanischer Systeme (MEMS) und integrierter mikroelektrooptischer Systeme (MEOS) mittels eines Eindrahtdatenbusses, wobei die zu steuernden integrierten Schaltungen, Mikrosysteme inkl. mikroelektromechanischer Systeme (MEMS) und integrierter mikroelektrooptischer Systeme (MEOS) jeweils die Rolle eines Busknotens einnehmen. Bei solchen Systemen ist es bereits heute üblich, diese für den Fertigungstest über einen JTAG-Test-Bus nach IEEE 1149-Standard in reiner Punkt-zu-Punkt-Konfiguration anzusteuern. Diese standardgemäße JTAG-Schnittstelle verfügt über einen Testdaten-Port mit typischerweise vier Testanschlüssen, nämlich über:
1. mindestens einen seriellen Dateneingang (Testdateneingang) TDI,
2. mindestens einen seriellen Datenausgang (Testausgang) TDo,
3. mindestens einen Mode-Eingang (Testmode-Eingang) TMS,
4. mindestens einen Takteingang (Testtakteingang) TCK,
5. einen optionalen Rücksetzeingang (Testrücksetzeingang) TRST.

Da das Verfahren seit mehreren Jahrzehnten bekannt ist, wird an dieser Stelle auf die entsprechende Fachliteratur und auf andere Publikationen verwiesen (z.B. IEEE 1149-Standards).

Hier sei nur so viel kurz beschrieben: Das JTAG-Protokoll nach IEEE 1149-Standard umfasst im Basisstandard fünf Signalgruppen, die zwischen der Emulationseinheit, die den Host-Prozessor enthält und damit als Bus-Master fungiert, und der integrierten Schaltung als Slave, im Folgenden jeweils mit Busknoten bezeichnet, ausgetauscht werden. Das TCK-Signal stellt den Systemtakt dar und synchronisiert zeitlich die interne Zustandsmaschine des Test-Controllers (TAPC) der JTAG-Testschnittstelle nach IEEE 1149-Standard der integrierten Schaltung. Das TMS-Signal steuert den Zustand dieses Test-Controllers (TAPC) der JTAG-Schnittstelle des Busknotens. Je nach Zustand des Test-Controllers (TAPC) führt die JTAG-Test-schnittstelle des Busknotens unterschiedliche Operationen durch. Der TDI-Eingang stellt einen seriellen Dateneingang dar. Der TDo-Ausgang stellt einen seriellen Datenausgang dar. Die beiden Eingänge TMS und TDI werden typischerweise (aber nicht notwendigerweise) mit der steigenden TCK-Flanke abgetastet. Der Datenausgang (TDo) wechselt sein Datum typischerweise ebenfalls mit der fallenden Flanke des TCK-Signals. Die TCK-, TMS- und TDI-Einzelsignale bilden im Stand der Technik die Testdateneingangssignale. Im Zusammenhang mit der Erfindung bilden sie die Dateneingangssignale. Das TDo-Signal stellt das Ausgangssignal dar. Mit der steigenden Systemtaktflanke (TCK-Flanke) und bei geeigneter Einstellung des internen Instruktionsregisters (IR) eines Test-Controllers (TAPC) werden die Daten seriell über den seriellen Dateneingang TDI in verschiedene Schieberegisterketten, sogenannte Scan-Pfade, in die integrierte Schaltung als Busknoten hinein verschoben. Gleichzeitig wird der ursprüngliche Inhalt der betreffenden Scan-Kette am seriellen Datenausgang (TDo) ausgegeben. Hierbei können Zustandsvektoren endlicher Automaten innerhalb des Busknotens Teil der Scan-Kette sein. Somit ist eine Änderung der Inhalte und Zustände bzw. die Kontrolle dieser Inhalte und Zustände der Speicherzellen der Scan-Ketten über diese Schnittstelle im Stand der Technik leicht möglich. Hier sei nochmals auf die Fachliteratur verwiesen.

### Fig. 1 (Stand der Technik)

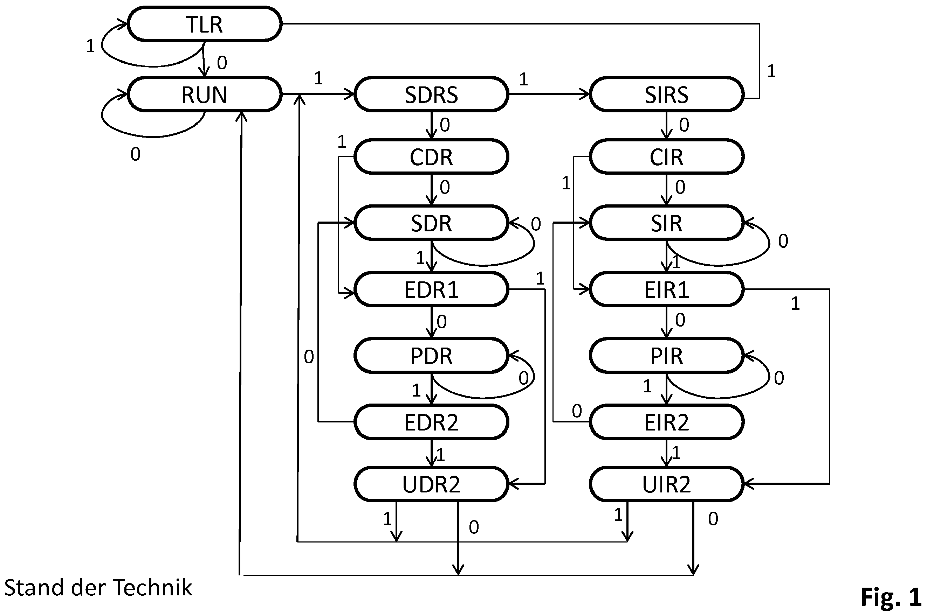

Fig. 1 zeigt das standardisierte Zustandsdiagramm für einen JTAG-Test-Controller (TAPC) entsprechend dem Stand der Technik und der relevanten Normen. Nach dem Zurücksetzen des Systems befindet sich der Test-Controller (TAPC) in dem Zustand "Test-Logik zurücksetzen" (TLR). In diesem verbleibt er, solange das Test-Mode-Signal (TMS) 1 ist. Wird das Test-Mode-Signal (TMS) 0, so wechselt der Test-Controller (TAPC) synchron zum Systemtakt (TCK) in den "Wartezustand" (RUN). In diesem verbleibt der Test-Controller (TAPC), bis am Test-Mode-Signal (TMS) eine 1 anliegt. Dann wechselt der Test-Controller (TAPC) in den Zustand "Start des Datenregisterschiebens" (SDRS). Sofern das Test-Mode-Signal (TMS) auch beim nächsten Mal wieder eine 1 zeigt, wechselt der Test-Controller (TAPC) dann in den Zustand "Start Instruktionsregisterschieben" (SIRS). Sofern auch dann mit dem nächsten Takt wieder eine 1 auf dem Test-Mode-Signal (TMS) anliegt, wechselt der Test-Controller (TAPC) wieder in den Zustand "Testlogik zurücksetzen" (TLR) und setzt die Datenschnittstellenlogik zurück.

Liegt jedoch im Zustand "Start des Instruktionsregisterschiebens" (SIRS) eine 0 auf dem Test-Mode-Signal (TMS) vor, so wechselt der Test-Controller (TAPC) in den Zustand "Instruktionsregisterdaten laden" (CIR) in dem die Daten, die in einem Instruktionsschattenregister verfügbar sind, in das Instruktionsregister (IR) geladen werden. Insofern ist das Instruktionsregister (IR) ein zweistufiges Register, bei dem der Vordergrund durch ein Schieberegister gebildet wird und die eigentlichen Daten sich in einem Schattenregister befinden, das nur in diesem Zustand gelesen wird. Das Schieberegister des Instruktionsregisters (IR) dient der Zu- und Abführung der Daten, während das Schattenregister des Instruktionsregisters (IR) die eigentlichen, gültigen Daten enthält. Diese Zweistufigkeit gilt für alle Register, insbesondere auch für die Datenregister (DR) der JTAG-Schnittstelle und auch für die im Folgenden beschriebenen erfindungsgemäßen Register der erfindungsgemäßen Schnittstelle. Ggf. Kann das Schattenregister des Instruktionsregisters (IR) noch ganz oder teilweise in eines für Lese- und eines für Schreibvorgänge unterteilt sein. Weitere Sichtbarkeits- und Zugriffsmöglichkeitenänderungen in Abhängigkeit von inneren Zuständen sind möglich. Liegt im Zustand "Instruktionsregisterdaten laden" (CIR) beim nächsten Takt des Test-Mode-Signals (TMS) eine 1 an, so wechselt der Test-Controller (TAPC) direkt in den später beschriebenen Zustand "Instruktionsregister Exit 1" (EIR1). Liegt jedoch ein 0 an, so wechselt der Test-Controller (TAPC) in den Zustand "Schieben Instruktionsregister" (SIR) in dem er verbleibt, solange eine 0 am Test-Mode-Signal (TMS) anliegt. Nur in diesem Zustand wird das Schieberegister des Instruktionsregisters (IR) in der Funktion eines Schieberegisters betrieben und sein Dateninhalt mit jedem Takt des Systemtakts (TCK) um ein Bit in Richtung auf den seriellen Datenausgang (TDI) verschoben, mit dem die letzte Speicherzelle des Schieberegisters des Instruktionsregisters (IR) verbunden ist. Das Schattenregister des Instruktionsregisters (IR) wird diesem Schiebevorgang nicht unterworfen. Die am Dateneingang (TDI) anliegende Dateninformation wird mit jedem Takt des Systemtakts (TCK) in die erste Zelle des Schieberegisters des Instruktionsregisters (IR) geladen und von dort während des Schiebens mit jedem weiteren Takt weiterbefördert. Sofern aber bei einem Takt eine 1 an dem Test-Mode-Signal anliegt, verlässt der Test-Controller (TAPC) den Zustand "Instruktionsregister schieben" (SIR) und wechselt in den schon zuvor erwähnten Zustand "Instruktionsregister Exit 1" (EIR1). Sofern beim nächsten Takt des Systemtakts (TCK) wieder eine 1 anliegt, wechselt der Test-Controller (TAPC) in den Zustand "Instruktionsregister schreiben" (UIR2), indem der Wert des Schieberegisterteils des Instruktionsregisters (IR) in das Schattenregister des Instruktionsregisters (IR) geschrieben wird. Liegt jedoch im Zustand "Instruktionsregister Exit 1" (EIR1) eine 0 am Test-Mode-Signal (TMS) an, so wechselt der Test-Controller (TAPC) in den Zustand "Pause Instruktionsregister" (PIR), wo er verbleibt, solange als Test-Mode-Signal (TMS) eine 0 anliegt. Liegt im Zustand "Pause Instruktionsregister" (PIR) eine 1 auf dem Test-Mode-Signal (TMS) an, so wechselt der Test-Controller (TAPC) in den Zustand "Instruktionsregister Exit 2" (EIR2). Sofern mit dem nächsten Systemtakt (TCK) eine 0 auf dem Test-Mode-Signal (TMS) anliegt, wechselt der Test-Controller (TAPC) wieder zum bereits beschriebenen Zustand "Instruktionsregister schieben" (SIR) zurück. Sofern jedoch im Zustand "Instruktionsregister Exit 2" (EIR2) mit dem nächsten Systemtakt (TCK) eine 1 auf dem Test-Mode-Signal (TMS) anliegt, wechselt der Test-Controller (TAPC) in den Zustand "Instruktionsregister schreiben" (UIR2). Im darauf folgenden Takt wechselt der Test-Controller (TAPC) in den Zustand "Start des Datenregisterschiebens"(SDRS), wenn bei diesem Takt als Test-Mode-Signal (TMS) eine 1 anliegt, und in den Zustand "Warten" (RUN), wenn eine 0 anliegt.

Liegt im Zustand "Start des Datenregisterschiebens" (SDRS) als Test-Mode-Signal (TMS) eine 0 vor, so wechselt der Test-Controller (TAPC) in den Zustand "Datenregisterdaten laden" (CDR), in dem die Daten, die in einem Datenschattenregister verfügbar sind, in das jeweilige Datenregister (DR) geladen werden. Welches Datenregister (DR) von mehreren Datenregistern ausgewählt wird, bestimmen dabei standardgemäß zumindest ein Teil der gültigen Bits des Schattenregisters des Datenregisters (DR). Auch hier ist typischerweise das Datenregister (DR) ein zweistufiges Register, bei dem der Vordergrund durch ein Schieberegister gebildet wird und die eigentlichen Daten sich in einem Schattenregister befinden, das nur in diesem Zustand gelesen wird. Das Schieberegister des Datenregisters (DR) dient auch hier der Zu- und der Abführung der Daten, während das Schattenregister des Datenregisters (DR) die eigentlichen Daten enthält. Diese Zweistufigkeit gilt, wie gesagt, für alle Register der JTAG-Schnittstelle, auch die im Folgenden beschriebenen erfindungsgemäßen Register der erfindungsgemäßen Schnittstelle, die standardgemäß als Datenregister (DR) ausgeführt werden. Ggf. Kann das Schattenregister des Datenregisters (DR) wieder ganz oder teilweise in eines für Lese- und eines für Schreibvorgänge unterteilt sein. Weitere Sichtbarkeits- und Zugriffsmöglichkeitenänderungen in Abhängigkeit von inneren Zuständen sind auch hier möglich. Liegt im Zustand "Datenregisterdaten laden" (CDR) beim nächsten Takt des Test-Mode-Signals (TMS) eine 1 an, so wechselt der Test-Controller (TAPC) direkt in den später beschriebenen Zustand "Datenregister Exit 1" (EDR1). Liegt jedoch ein 0 an, so wechselt der Test-Controller (TAPC) in den Zustand "Schieben Datenregister" (SDR), in dem er verbleibt, solange eine 0 am Test-Mode-Signal (TMS) anliegt. Nur in diesem Zustand und sonst nicht wird das Schieberegister des Datenregisters (DR) in der Funktion eines Schieberegisters betrieben und sein Dateninhalt mit jedem Takt des Systemtakts (TCK) um ein Bit in Richtung auf den seriellen Datenausgang (TDI) verschoben, mit dem die letzte Speicherzelle des Schieberegisters des Datenregisters (DR) verbunden ist. Das Schattenregister des Datenregisters (DR) wird diesem Schiebevorgang nicht unterworfen. Die am Dateneingang (TDI) anliegende Dateninformation wird mit jedem Takt des Systemtakts (TCK) in die erste Zelle des Schieberegisters des Datenregisters (DR) geladen und von dort während des Schiebens mit jedem weiteren Takt weiterbefördert. Sofern aber bei einem Takt als Test-Mode-Signal (TMS) eine 1 anliegt, verlässt der Test-Controller (TAPC) den Zustand "Datenregister schieben" (SDR) und wechselt in den schon zuvor erwähnten Zustand "Datenregister Exit 1" (EDR1). Sofern beim nächsten Takt des Systemtakts (TCK) wieder eine 1 anliegt, wechselt der Test-Controller (TAPC) in den Zustand "Datenregister schreiben" (UIR2), in dem der Wert, des Schieberegisterteils des Datenregisters (DR) in das Schatten-register des Datenregisters (DR) geschrieben wird. Liegt jedoch im Zustand "Datenregister Exit 1" (EDR1) als Test-Mode-Signal (TMS) eine 0 an, so wechselt der Test-Controller (TAPC) in den Zustand "Pause Datenregister" (PDR), in dem er verbleibt, solange als Test-Mode-Signal (TMS) eine 0 anliegt. Liegt im Zustand "Pause Datenregister" (PDR) als Test-Mode-Signal (TMS) eine 1 an, so wechselt der Test-Controller (TAPC) in den Zustand "Datenregister Exit 2" (EDR2). Sofern mit dem nächsten Systemtakt (TCK) als Test-Mode-Signal (TMS) eine 0 anliegt, wechselt der Test-Controller (TAPC) wieder zum bereits beschriebenen Zustand "Datenregister schieben" (SDR) zurück. Sofern jedoch im Zustand "Datenregister Exit 2" (EDR2) mit dem nächsten Systemtakt (TCK) eine 1 auf dem Test-Mode-Signal (TMS) anliegt, wechselt der Test-Controller (TAPC) in den Zustand "Datenregister schreiben" (UDR2). Im darauf folgenden Takt wechselt der Test-Controller (TAPC) in den Zustand "Start des Datenregisterschiebens" (SDRS), wenn bei diesem Takt als Test-Mode-Signal (TMS) eine 1 anliegt, und in den Zustand "Warten" (RUN), wenn eine 0 anliegt.

Es ist besonders sinnvoll, dieses Zustandsschema des IEEE 1149-JTAG-Standards zu verwenden, um kompatibel zu dem bereits großflächig im Einsatz befindlichen Standard auf Software-Eben zu bleiben. Selbstverständlich sind Abweichungen von diesem JTAG-Standard denkbar. Die Beschreibung der Erfindung erfolgt anhand des Beispiels, dass dieser JTAG-Standard für das Zustandsdiagramm des Test-Controllers (TAPC) eingehalten wird.

Die Halbleiterindustrie hat in den vergangenen Jahren mehrfach versucht, die Anzahl der zu verwendenden Anschlüsse für solche JTAG-Schnittstellen zu reduzieren, um die Größe der benötigten Gehäuse und damit die Herstellkosten zu beschränken. In US-A-2007/0033465 ist eine Technik beschrieben, die keine konsistente Wandlung der Daten des IEEE 1149.1 4-Wire-JTAG-Protokolls in die Daten des dort beschriebenen Verfahrens und umgekehrt erlaubt. Die dort beschriebene Vorrichtungsanordnung und das dort beschriebene Verfahren erfordern synchronisierte Zeitschlitze zwischen dem Bus-Master, also dem Host-Prozessor, und dem Busknoten als Slave, also der integrierten Schaltung, die getestet, programmiert oder debugged werden soll. Im Falle einer fehlenden zeitlichen Synchronisation des Zugriffs von Bus-Master und Busknoten auf den Testdatenbus kann der TDo-Ausgangstreiber des Busknotens und der Bus-Master-Ausgangstreiber (typischerweise eine Push-Pull-Stufe) bei gleichzeitigem sendenden Zugriff auf die Testdatenleitung einen Kurzschluss erzeugen. Außerdem offenbart sie nur eine Punkt-zu-Punkt-Verbindung.

Aus der US-A-2007/0033465 ist eine Mehrpegel-Eindraht-Punkt-zu-Punkt-Anordnung bekannt, die bereits nur mit einer Datenleitung auskommt, aber nicht für eine Ansteuerung mehrerer Busknoten geeignet ist. Die Erweiterung durch die in der EP-B-0 503 117 ist nicht möglich, da diese keine geeignete Methode zur bidirektionalen Weiterschaltung der Zwischenpegel offenbart.

Verschiedene Ausgestaltungen von Datenübertragungsbussystemen sind beschrieben in DE-C-196 43 013, DE-A-102 15 720, DE-A-102 56 631, DE-B-102 61 174, DE-A-10 2006 022 985, DE-B-10 2007 060 441, DE-A-10 2010 042 311, DE-B-10 2015 004 434, US-A-6 105 077, US-A-2004/0208200, US-A-2008/0255791, US-A-2009/0252210, US-A-2011/0150065, US-A-2012/0144078, US-A-2013/0073761 und US-A-2014/0281076.

### Aufgabe der Erfindung

Es ist die Aufgabe der Erfindung eine bidirektionale, frei konfigurierbare Übertragung von Beleuchtungsdaten mit nur einer Datenleitung für mehr als einen Busknoten (BS1,BS2,BS3) als Slave eines Bus-Masters (BM) zu ermöglichen.

Diese Aufgabe wird durch den Gegenstand des Anspruchs 1 gelöst.

### Beschreibung der Erfindung

Erfindungsgemäß wurde erkannt, dass sich ein Eindraht-Test-Bus, wie er mit dem zugehörigen Betriebsverfahren beispielsweise in den Schriften DE-B-10 2015 004 434, DE-B-10 2015 004 433, DE-B-10 2015 004 435 und DE-B-10 2015 004 436 beschrieben ist, ganz besonders für die Übertragung solcher Daten, insbesondere für die Steuerung der Leuchtmittel von Leuchtbändern, eignet, wenn jeder Busknoten eine geeignete Teilvorrichtung zur bidirektionalen Weiterschaltung aufweist.

Im Gegensatz zum Gegenstand der DE-B-10 2015 004 434, DE-B-10 2015 004 433.8, DE-B-10 2015 004 435 und DE-B-10 2015 004 436 werden nun jedoch keine Testdaten, sondern Nutzdaten zur Beleuchtungssteuerung übertragen. Des Weiteren ist auch der in DE-B-10 2015 004 434, DE-B-10 2015 004 433, DE-B-10 2015 004 435 und DE-B-10 2015 004 436 offenbarte Test-Bus nur für eine Punkt-zu-Punkt-Verbindung ausgelegt. Erfindungsgemäß ist dieser Test-Bus nun so zu modifizieren, dass mehrere Bus-Slaves als Busknoten angesteuert und betrieben werden können. Die Steuerdaten werden dabei erfindungsgemäß in ein spezielles Datenregister (DR) einer JTAG-Schnittstelle geschrieben bzw. von einem solchen gelesen.

Die vorstehenden und anderen Aufgaben werden können durch die Bereitstellung einer Schnittstelleneinheit mit einer JTAG-Schnittstelle für das erfindungsgemäße Verfahren gelöst werden, die eine zeitliche Abfolge zeitlich gemultiplexter Signale mittels einer Schnittstelleneinrichtung mit der integrierten Schaltung austauschen kann. Die Signale werden so formatiert, dass alle Informationen, die durch die JTAG-Schnittstelle für die Steuerung des Datenflusses und die Einstellung der Beleuchtungsparameter der angeschlossenen Leuchtmittel benötigt werden, über diese Schnittstelle seriell übertragen werden. Hierbei werden alle Datenwerte des JTAG-Boundary-Protokolls in dafür vorgesehenen Zeitschlitzen übertragen. Neben dem zeitlichen Multiplexen der JTAG-Steuersignale kann die erfindungsgemäße Schnittstellenvorrichtung drei verschiedene Spannungsbereiche (V_{B1},V_{B2},V_{B3}) verwenden, um
1. mindestens die Daten des seriellen Testdateneingangs TDI und
2. mindestens die Daten des einen seriellen Testausgangs TDo und
3. mindestens die Steuerdaten des Testmode-Eingangs TMS zur Steuerung des Test-Controllers der integrierten Schaltung und
4. mindestens den Testtakt zur Versorgung des Test-Controllers mit seinem Test-SystemTakt TCK und
5. ein optionalen Testrücksetzsignal TRST zu übertragen.

Die im Folgenden in Klammern gesetzten Zeichenketten sollen das Verständnis der Erfindung erleichtern, indem auf die Figuren verwiesen wird, was jedoch die Allgemeingültigkeit der nachfolgenden Erfindungsbeschreibung nicht einschränkt.

Die Erfindung betrifft einen bidirektionalen Datenbus zwischen einer ersten Teilvorrichtung, dem Bus-Master (BM), und mindestens zwei weiteren Teilvorrichtungen, den Busknoten. Dabei ist der Busknoten identisch mit der zuvor erwähnten integrierten Schaltung zur Steuerung von Leuchtmitteln mittels im weitesten Sinne PWM, deren Zustände kontrolliert bzw. geändert werden sollen. Der bidirektionale Datenbus ist auch für die Steuerung anderer Verbraucher elektrischer Energie geeignet. Dieser bidirektionale Datenbus weist vorzugsweise nur eine Masseleitung (GND) und eine einzelne Datenleitung in Form eines Eindrahtdatenbusses (b1,b2,b3) auf, der durch die Busknoten (BS1,BS2,BS3) in verschiedene Eindrahtdatenbusabschnitte (b1,b2,b3) unterteilt wird. Hierdurch benötigen die Busknoten jeweils nur zwei einzelne zusätzliche elektrische Anschlüsse. Um nun sowohl Daten in einen der Busknoten, im Folgenden "betrachteter Busknoten" genannt, hinein senden zu können, als auch Daten aus dem betrachteten Busknoten auslesen zu können, können die Daten über den Eindrahtdatenbus (b1,b2,b3) bidirektional übertragen werden. Dabei entsteht das Problem, dass neben der Datenübertragung auch ein Synchronisationssignal übertragen werden muss. Hierfür wird über den Eindrahtdatenbus (b1,b2,b3) der Systemtakt durch ein Taktsignal, das TCK-Signal, insbesondere vom Bus-Master zu den Busknoten zusätzlich übertragen. Um diese Kommunikation zu ermöglichen, verfügen die Busknoten über eine erste Einrichtung, die den Pegel auf dem Eindrahtdatenbus (b1,b2,b3) oder auf einem angeschlossenen Eindrahtdatenbusabschnitt (b1,b2,b3) des Eindrahtdatenbusses (b1,b2,b3) mit einem ersten Schwellwert vergleicht. Bevorzugt ist eine Realisierung dieser ersten Einrichtung in Form eines ersten Komparators (C_{2H}), der den besagten Pegel mit dem eines ersten Schwellwertsignals (V_{2H}), vergleicht. Entsprechend verfügt der Busknoten des Weiteren über eine zweite Einrichtung, die den Signalpegel in Form einer Signalspannung auf dem Eindrahtdatenbus (b1,b2,b3) oder auf einem angeschlossenen Eindrahtdatenbusabschnitt (b1,b2,b3) des Eindrahtdatenbusses (b1,b2,b3) mit einem zweiten Schwellwert vergleicht. Dies geschieht bevorzugt durch einen zweiten Komparator (C_{2L}), der den Signalpegel in Form einer Signalspannung auf den Eindrahtdatenbus (b1,b2,b3) oder auf einem angeschlossenen Eindrahtdatenbusabschnitt (b1,b2,b3) des Eindrahtdatenbusses (b1,b2,b3) mit dem Spannungspegel eines zweiten Schwellwertsignals (V_{2L}) vergleicht. Ist der erste Schwellwert (V_{2H}) vom zweiten Schwellwert (V_{2L}) verschieden und liegen die Schwellwerte innerhalb des Versorgungsspannungsbereiches, so werden durch diese zwei Schwellwerte (V_{2H},V_{2L}) drei Spannungsbereiche(V_{B1},V_{B2},V_{B3}) definiert und festgelegt. Dabei messen der erste und zweite Komparator (C_{2H},C_{2L}) auf Busknoten-Seite, in welchem Spannungsbereich (V_{B1},V_{B2},V_{B3}) sich der Eindrahtdatenbus (b1,b2,b3) oder der jeweils an den betrachteten Busknoten angeschlossene Eindrahtdatenbusabschnitt (b1,b2,b3) des Eindrahtdatenbusses (b1,b2,b3) gerade befindet. Der erste und zweite Schwellwert definieren somit zwischen der Betriebsspannung (V_{IO}) und dem Bezugspotenzial (V₀) der Bezugspotenzialleitung (GND) die drei besagten Signalspannungsbereiche (V_{B1},V_{B2},V_{B3}). Zur besseren Klarheit sei der mittlere Spannungsbereich als zweiter Spannungsbereich (V_{B2}) benannt. Dieser wird von einem ersten Spannungsbereich (V_{B1}) nach oben oder unten hin begrenzt. Es ist hierbei bewusst offengelassen, ob es sich beim ersten Spannungsbereich (V_{B1}) um einen Spannungsbereich mit positiveren oder negativeren Spannungen als die Spannungen des mittleren, zweiten Spannungsbereichs (V_{B2}) handelt, da das System auch mit umgekehrten Spannungspolaritäten funktioniert. Gleichzeitig wird korrespondierend der zweite Spannungsbereich (V_{B2}) zur anderen Spannungsseite hin, also nach unten oder oben hin, aber andersherum als beim ersten Spannungsbereich (V_{B1}) durch einen dritten Spannungsbereich (V_{B3}) begrenzt.

Um die Daten vom Bus-Master (BM), also dem Host-Prozessor, zu einem Busknoten (BS1,BS2,BS3) zu übertragen, werden in mindestens drei aufeinanderfolgenden Zeitschlitzen (TIN0,TIN1,TDO) durch den Bus-Master (BM) oder den betrachteten Busknoten (BS1,BS2,BS3) Daten über den Eindrahtdatenbus (b1,b2,b3) oder den an den Busknoten (BS1,BS2,BS3) angeschlossenen Eindrahtdatenbusabschnitt (b1,b2,b3) des Eindrahtdatenbusses (b1,b2,b3) übertragen. Welcher Busknoten (BS1,BS2,BS3) dabei eine Sendeberechtigung hat, wird durch die zeitliche Position des jeweiligen Zeitschlitzes (TIN0,TIN1,TDO) sowie durch den Inhalt der Busknotenadressregister (BKADR) der Busknoten und die durch den Bus-Master (BM) zuvor übermittelte Sendeadresse festgelegt. Hierbei werden in dem Paket der drei aufeinanderfolgenden Zeitschlitze (TIN0,TIN1,TDO) dem Bus-Master (BM) typischerweise zwei Zeitschlitze (TINO,TIN 1) und dem betrachteten Busknoten (BS1,BS2,BS3) typischerweise ein Zeitschlitz (TDO) zugewiesen. Welche(r) der Busknoten (BS1,BS2,BS3) senden darf (dürfen), wird vorteilhafterweise durch ein Datum, nämlich die Sendeadresse des betrachteten Busknotens (BS1,BS2,BS3), festgelegt, das der Bus-Master in allen Senderegistern (SR) aller erreichbaren Busknoten, deren Einzeldrahtdatenbusabschnitte gerade eine Verbindung zum Bus-Master (BM) ermöglichen, gleichzeitig übermittelt und ablegt. Alle Busknoten vergleichen diese Sendeadresse in ihren jeweiligen Senderegistern (SR) mit einer ihnen in ihren Busknotenadressregistern (BKADR) während der Businitialisierung eingespeicherten eigenen Busknotenadresse und senden nur dann, wenn die übermittelte Sendeadresse in ihrem Senderegister (SR) mit der eigenen eingespeicherten Busknotenadresse in ihrem Busknotenadressregister (BKADR) übereinstimmt und dann auch nur zu den vorbestimmten Zeiten. Die relative Zeitschlitzposition innerhalb des Paketes aus mindestens drei Zeitschlitzen (TIN0,TIN1,TDO) ist dabei vorzugsweise (aber nicht notwendigerweise) für vorzugsweise alle Busknoten immer gleich. Besonders bevorzugt enthalten der erste Zeitschlitz (TINO) und der zweite Zeitschlitz (TIN1) ein Kontrolldatum und/oder ein erstes Datum, das vom Bus-Master (BM) zu den Busknoten (BS1,BS2,BS3) übertragen wird, wobei das Kontrolldatum und das erste Datum insbesondere und vorzugsweise mit den Daten des Vierdraht-Testdatenbusses gemäß IEEE1149 kompatibel sein sollten und wobei die Busknoten das Kontrolldatum und das erste Datum empfangen. Hierdurch können beispielsweise Busknotenadressen, Sendeadressen und Beleuchtungsdaten übertragen werden.

Im Gegensatz zum Stand der Technik wird nun jedoch im dritten Zeitschlitz das Datum vom betrachteten Busknoten (BSₙ) zum Bus-Master (BM) nur im zweiten und dritten Spannungsbereich(V_{B3}) und eben nicht im ersten Spannungsbereich (V_{B1}) übertragen, wenn die übermittelte und im Senderegister (SR) der JTAG-Schnittstelle des Busknotens abgelegte Sendeadresse mit der im Busknotenadressregister (BKADR) des Busknotens während der Businitialisierung abgelegten eingespeicherten Busknotenadresse übereinstimmt. Somit enthält der dritte Zeitschlitz vorteilhafterweise ein zweites Datum, das vom betrachteten Busknoten (BS1,BS2,BS3) zum Bus-Master (BM) übertragen wird, wobei der Bus-Master (BM) dieses zweite Datum empfängt und wobei das zweite Datum nur im zweiten Spannungsbereich (V_{B2}) und im dritten Spannungsbereich (V_{B3}) übertragen wird. Gleichzeitig wird der Takt durch den Bus-Master (BM) in jedem Zeitschlitz übertragen. Das Taktsignal (TCK) wird dabei durch ein Taktsignal signalisiert, das zwischen dem ersten Spannungsbereich (V_{B1}) in einer ersten Halbtaktperiode der mindestens zwei Halbtaktperioden (T_{1H},T_{2H}) einer Systemtaktperiode (T) auf der einen Seite und dem zweiten Spannungsbereich (V_{B2}) oder dritten Spannungsbereich (V_{B3}) in der zweiten Halbtaktperiode der mindestens zwei Halbtaktperioden (T_{1H},T_{2H}) einer Systemtaktperiode (T) schwankt. Das Taktsignal kann daher dadurch detektiert werden, dass die Spannung auf dem Eindrahtdatenbus (b1,b2,b3) oder auf einem angeschlossenen Eindrahtdatenbusabschnitt (b1,b2,b3) des Eindrahtdatenbusses (b1,b2,b3) aus dem zweiten Spannungsbereich (V_{B2}) oder dritten Spannungsbereich (V_{B3}) in den ersten Spannungsbereich (V_{B1}) und umgekehrt wechselt. Der Wechsel der entsprechenden Schwellspannung (V_{2L}) kann durch den zugehörigen Komparator (C_{2L}) oder die entsprechende Einrichtung erkannt werden. Somit wird es möglich, den Systemtakt (TCK) auf der Busknoten-Seite, also der Seite der integrierten Schaltung, sicher zu extrahieren. Hierbei ist die Konstruktion der Takteinprägung im Vergleich zur Konstruktion der Einprägung der anderen Signale mit Vorteil so gewählt, dass der Takt-Sender auf Seiten des Bus-Masters (BM) alle anderen Pegelquellen, die an der Datenleitung parallel aktiv sein können, überschreiben kann. Dies ist ein wesentlicher Unterschied zum Stand der Technik. In der Realität kann es daher erforderlich sein, externe größere Transistoren für die Einprägung des Taktes auf dem Eindrahtdatenbus (b1,b2,b3) oder auf einem angeschlossenen Eindrahtdatenbusabschnitt (b1,b2,b3) des Eindrahtdatenbusses (b1,b2,b3) vorzusehen, um möglichst viele Busknoten mit einem Takt versorgen zu können.

In einer vorteilhaften Ausprägung der Erfindung zeichnet sich diese daher dadurch aus, dass drei logische Zustände beim bidirektionalen Senden der Daten auf dem Eindrahtdatenbus (b1,b2,b3) oder auf einem angeschlossenen Eindrahtdatenbusabschnitt (b1,b2,b3) des Eindrahtdatenbusses (b1,b2,b3) durch den Bus-Master (B) und die Busknoten (BS1,BS2,BS3) verwendet werden, wobei diese logischen Zustände eine Hierarchie haben und ein Taktzustand, hier der in dem der Eindrahtdatenbus (b1,b2,b3) oder ein angeschlossener Eindrahtdatenbusabschnitt (b1,b2,b3) des Eindrahtdatenbusses (b1,b2,b3) sich im ersten Spannungsbereich (V_{B1}) befindet, die höchste Priorität hat und nicht durch andere Sendeeinrichtungen überschrieben werden kann. Hierdurch ist sichergestellt, dass der Bus-Master und die Busknoten zumindest hinsichtlich des Basistaktes stets synchron arbeiten können. Um diesen ersten logischen Zustand, bei dem der Eindrahtdatenbus (b1,b2,b3) oder ein angeschlossener Eindrahtdatenbusabschnitt (b1,b2,b3) des Eindrahtdatenbusses (b1,b2,b3) in den ersten Spannungsbereich (V_{B1}) gezwungen wird, herstellen zu können, weist die Master-Eindrahtdatenbusschnittstelle (OWM) des Bus-Masters (BM), vorzugsweise einen (dominanten) Schalter (S_{1L}) auf, der den Eindrahtdatenbus (b1,b2,b3) oder einen angeschlossenen Eindrahtdatenbusabschnitt (b1,b2,b3) des Eindrahtdatenbusses (b1,b2,b3) beispielsweise gegen das Bezugspotenzial (V₀) der Bezugspotenzialleitung (GND) in den zugehörigen Halbtaktperioden der mindestens zwei Halbtaktperioden (T_{1H}, T_{2H}) der jeweiligen Systemtaktperiode (T) kurzschließt. Dieser periodische Kurzschluss kann dann durch andere Sender nicht mehr überschrieben werden, wenn deren Innenwiderstand höher ist, als der des dominanten Schalters (S_{1L}). Beispielsweise wird der Eindrahtdatenbus (b1,b2,b3) oder ein angeschlossener Eindrahtdatenbusabschnitt (b1,b2,b3) des Eindrahtdatenbusses (b1,b2,b3) durch einen Spannungsteiler aus einem ersten Spannungsteilerwiderstand (R_{0H}) gegen eine Spannung, beispielsweise die Versorgungsspannung (V_{IO}), und einem zweiten Spannungsteilerwiderstand (R_{0L}) gegen eine andere Spannung, beispielsweise das Bezugspotenzial (V₀) im zweiten Spannungsbereich (V_{B2}) gehalten bzw. in diesen zurückgeführt, wenn keiner der anderen Sender (S_{1L},S_{1H},I₁,S_{2H},I₂) des Bus-Masters (BM) oder der Busknoten (BS1,BS2,BS3) sendet. Um nun Daten zu übertragen, wird der Eindrahtdatenbus (b1,b2,b3) oder ein angeschlossener Eindrahtdatenbusabschnitt (b1,b2,b3) des Eindrahtdatenbusses (b1,b2,b3) im Gegensatz zum Stand der Technik durch die Sender des Bus-Masters (BM) und/oder der Busknoten (BS1,BS2,BS3) aus dem zweiten Spannungsbereich (V_{B2}) in den dritten Spannungsbereich (V_{B3}) gebracht, wenn ein dem logischen Datenwert des zweiten Spannungsbereichs (V_{B2}) entgegengesetzter logischer Wert übertragen werden soll. Hierzu speist die jeweilige sendende Einheit, also der Bus-Master oder der betrachtete Busknoten (BS1,BS2,BS3), einen Strom in den Eindrahtdatenbus (b1,b2,b3) oder den betreffenden, angeschlossenen Eindrahtdatenbusabschnitt (b1,b2,b3) des Eindrahtdatenbusses (b1,b2,b3) ein. Dieser eingespeiste Strom führt zu einem geänderten Spannungsabfall über die Spannungsteilerwiderstände (R_{0H}, R_{0L}). Bei einer geeigneten Polarität des eingespeisten Stroms wird der Spannungspegel auf dem Eindrahtdatenbus (b1,b2,b3) oder auf einem angeschlossenen Eindrahtdatenbusabschnitt (b1,b2,b3) des Eindrahtdatenbusses (b1,b2,b3) vom zweiten Spannungsbereich(V_{B2}) in den dritten Spannungsbereich (V_{B3}) verschoben. Sollte es zu einem gleichzeitigen Senden mittels eines solchen Datenstromes, und dem gleichzeitigen Schließen des dominanten Schalters (S_{1L}) kommen, so wird der dominante Schalter, sofern er vorteilhafterweise niederohmig genug ausgelegt ist, den Sendestrom des jeweiligen Senders abführen und somit diesen Spannungspegel und ggf. auch den durch den Spannungsteiler (R_{0H}, R_{0L}) erzeugten Spannungspegel überschreiben. Es kommt jedoch nicht, wie möglicherweise im Stand der Technik, zu einem Kurzschluss. Insbesondere kommt es nicht zu dem aus US-A-2007/0033465 bekannten Kurzschluss zwischen der Busknoten-Seite und dem Sender des Bus-Masters. Es ist somit ein besonderes Merkmal, dass ein zweiter der drei logischen Zustände auf dem Datenbus durch eine erste schaltbare Stromquelle (I₁,S_{1H}) in dem Bus-Master und/oder durch eine zweite schaltbare Stromquelle (I₂,S_{2H}), d.h. nicht durch eine Spannungsquelle erzeugt wird. Gleichzeitig wird vorteilhafterweise ein dritter der drei logischen Zustände auf dem Datenbus durch einen Pull-Schaltkreis (R_{0H},R_{0L}) in Form eines Spannungsteilers erzeugt. Natürlich sind auch andere Möglichkeiten für einen solchen Pull-Schaltkreis denkbar. Im Prinzip handelt es sich bei dem Pull-Schaltkreis in Form eines Spannungsteilers um eine Spannungsquelle, die die Datenleitung auf eine zweite Spannung legt, welche innerhalb des zweiten Spannungsbereiches (V_{B2}) liegt, wobei diese Spannungsquelle einen Innenwiderstand aufweist, der so groß ist, dass der mögliche Eingangsstrom derart begrenzt ist, dass die geschalteten Stromquellen (I₁,S_{H1}) und (I₂,S_{H2}) einen größeren Strom liefern, als dieser Pull-Schaltkreis (R_{0H},R_{0L}) abführen kann. Somit ergibt sich eine klare Hierarchie:
- Es dominiert als erstes der Schaltzustand des dominierenden Schalters (S_{1L}) des Bus-Masters (BM), dann folgen
- als Zweites in der Hierarchie der spannungsbestimmenden Elemente für die Spannung auf dem Eindrahtdatenbus (b1,b2,b3) oder dem betreffenden, angeschlossener Eindrahtdatenbusabschnitt (b1,b2,b3) des Eindrahtdatenbusses (b1,b2,b3) die beiden geschalteten Stromquellen des Bus-Masters (I₁,S_{1H}) und des betrachteten Busknotens (I₂,S_{2H}), die typischerweise untereinander gleichberechtigt sind, und
- als Drittes und Letztes mit niedrigster Priorität der Pull-Schaltkreis, hier in Form eines Spannungsteilers (R_{0H},R_{0L}), der typischerweise nur einmal pro Eindrahtdatenbussystem vorgesehen ist.

Bevorzugt korrespondiert
- der erste logische Zustand mit einem Spannungspegel (V₀) im ersten Spannungsbereich (V_{B1}) auf dem Eindrahtdatenbus (b1,b2,b3) oder einem angeschlossenen Eindrahtdatenbusabschnitt (b1,b2,b3) des Eindrahtdatenbusses (b1,b2,b3),
- der zweite logische Zustand mit einem Spannungspegel (V_{M}) im zweiten Spannungsbereich (V_{B2}) auf dem Eindrahtdatenbus (b1,b2,b3) oder einem angeschlossenen Eindrahtdatenbusabschnitt (b1,b2,b3) des Eindrahtdatenbusses (b1,b2,b3) und
- der dritte logische Zustand mit einem Spannungspegel (V_{IO}) im dritten Spannungsbereich (V_{B3}) auf dem Eindrahtdatenbus (b1,b2,b3) oder einem angeschlossenen Eindrahtdatenbusabschnitt (b1,b2,b3) des Eindrahtdatenbusses (b1,b2,b3).

Vorteilhafterweise wird der erste logische Zustand auf dem Eindrahtdatenbus (b1,b2,b3) oder einem angeschlossenen Eindrahtdatenbusabschnitt (b1,b2,b3) des Eindrahtdatenbusses (b1,b2,b3) ausschließlich zur Übertragung eines ersten logischen Zustands (beispielsweise "low") eines Systemtaktes benutzt und der zweite und dritte logische Zustand auf dem Eindrahtdatenbus (b1,b2,b3) oder einem angeschlossenen Eindrahtdatenbusabschnitt (b1,b2,b3) des Eindrahtdatenbusses (b1,b2,b3) für die Übertragung eines zweiten logischen Zustands (beispielsweise "high") des Systemtaktes benutzt.

Vorteilhafterweise wird der zweite logische Zustand auf dem Eindrahtdatenbus (b1,b2,b3) oder einem angeschlossenen Eindrahtdatenbusabschnitt (b1,b2,b3) des Eindrahtdatenbusses (b1,b2,b3) zur Übertragung eines ersten logischen Zustands (beispielsweise "low") eines Datensignals benutzt und der dritte logische Zustand auf dem Eindrahtdatenbus (b1,b2,b3) oder einem angeschlossenen Eindrahtdatenbusabschnitt (b1,b2,b3) des Eindrahtdatenbusses (b1,b2,b3) für die Übertragung eines zweiten logischen Zustands (beispielsweise "high") des Datensignals benutzt. Befindet sich die Datenleitung im ersten logischen Zustand, so wird dieser für die Datenübertragung ignoriert.

Vorteilhafterweise wird der erste logische Zustand auf dem Eindrahtdatenbus (b1,b2,b3) oder einem angeschlossenen Eindrahtdatenbusabschnitt (b1,b2,b3) des Eindrahtdatenbusses (b1,b2,b3) zur Übertragung eines ersten logischen Zustands (beispielsweise "low") eines Systemtaktsignals benutzt und der dritte oder zweite logische Zustand auf dem Eindrahtdatenbus (b1,b2,b3) oder einem angeschlossenen Eindrahtdatenbusabschnitt (b1,b2,b3) des Eindrahtdatenbusses (b1,b2,b3) für die Übertragung eines zweiten logischen Zustands (beispielsweise "high") des Systemtaktsignals benutzt. Wechselt der logische Zustand auf dem Eindrahtdatenbus (b1,b2,b3) oder einem angeschlossenen Eindrahtdatenbusabschnitt (b1,b2,b3) des Eindrahtdatenbusses (b1,b2,b3) zwischen dem zweiten oder dritten logischen Zustand auf dem Eindrahtdatenbus (b1,b2,b3) oder einem angeschlossenen Eindrahtdatenbusabschnitt (b1,b2,b3) des Eindrahtdatenbusses (b1,b2,b3), so wird dieser Wechsel für die Übertragung des Systemtaktes ignoriert und typischerweise weiterhin als zweiter logischer Zustand (d.h. beispielsweise "high") interpretiert.

In einer vorteilhaften Ausprägung der Erfindung handelt es sich also um ein Datenbussystem mit einer Bezugspotenzialleitung (GND) und einem Eindrahtdatenbus (b1,b2,b3) zur Übertragung von Daten zwischen einem Bus-Master (BM) und mindestens zwei Busknoten (BS1,BS2,BS3), insbesondere Leuchtmittel-Busknoten. Dabei ist der Eindrahtdatenbus (b1,b2,b3) durch die Busknoten (BS1,BS2,BS3) in mindestens zwei Eindrahtdatenbusabschnitte (b1,b2,b3) unterteilt. Er wird durch einen der Busknoten, nämlich den abschließenden Busknoten (BS3), abgeschlossen. Jeder der Busknoten (BS1,BS2,BS3) ist bis auf einen Busknoten, nämlich den ersten Busknoten (BS1), durch einen vorausgehenden Eindrahtdatenbusabschnitt (b1,b2,b3) mit einem vorausgehenden Busknoten (BS1, BS2) verbunden. Der eine erste Busknoten (BS1) ist durch einen vorausgehenden Eindrahtdatenbusabschnitt (b1) mit dem Bus-Master (BM) verbunden. Jeder Busknoten (BS1,BS2,BS3) ist bis auf einen abschließenden Busknoten (BS3) durch einen nachfolgenden Eindrahtdatenbusabschnitt (b2, b3) mit einem nachfolgenden Busknoten (BS3, BS4) der Busknoten (BS1,BS2,BS3) verbunden. Dies gilt nicht für den abschließenden Busknoten (B3). Der Bus-Master (BM) ist mit einer Master-Eindrahtdatenbusschnittstelle (OWM) versehen, wobei die Master-Eindrahtdatenbusschnittstelle (OWM) dazu vorgesehen ist, mittels eines Datenbusprotokolls mit mehr als zwei physikalischen Spannungs- und/oder Strompegeln bidirektional Daten über den Eindrahtdatenbus (b1,b2,b3) oder zumindest einen der Eindrahtdatenbusabschnitte (b1,b2,b3), im Folgenden "als betrachteter Eindrahtdatenbusabschnitt (b1,b2,b3)" bezeichnet, zu senden und von diesem zu empfangen. Der betrachtete Eindrahtdatenbusabschnitt (b1,b2,b3) umfasst dabei nur eine einzige Signalleitung. An den betrachteten Eindrahtdatenbusabschnitt (b1,b2,b3) sind eine Eindrahtdatenbusschnittstelle (OWS1, OWS2, OWS3) eines Busknotens (BS1,BS2,BS3) der Busknoten (BS1,BS2,BS3), im Folgenden als "betrachteter Busknoten" bezeichnet, und ein erstes Transfer-Gate (TG1) des betrachteten Bus-Knotens (BS1,BS2,BS3) elektrisch angeschlossen. Die Eindrahtdatenbusschnittstelle (OWS1,OWS2,OWS3) des betrachteten Busknotens ist dazu vorgesehen, mittels eines Datenbusprotokolls mit mehr als zwei physikalischen Spannungs- und/oder Strompegeln bidirektional Daten über den betrachteten Eindrahtdatenbusabschnitt (b1,b2,b3) zu senden und von diesem zu empfangen. Die Eindrahtdatenbusschnittstelle (OWS1,OWS2,OWS3) des betrachteten Busknotens ist dazu vorgesehen, mittels eines Datenbusprotokolls mit mindestens zwei physikalischen Spannungs- und/oder Strompegeln Daten über den betrachteten Eindrahtdatenbusabschnitt (b1,b2,b3) zu senden. Das Transfer-Gate (TG1,TG2,TG3) des betrachteten Busknotens ist dazu vorgesehen, den betrachteten Eindrahtdatenbusabschnitt (b1,b2) von einem optionalen nachfolgenden Eindrahtdatenbusabschnitt (b2,b3) zu trennen und/oder mit diesem elektrisch zu verbinden. Der betrachtete Bus-Knoten (BS1,BS2,BS3) verfügt über ein erstes Transfer-Gate-Control-Register (TGCR), das dazu ausgelegt ist, das Transfer-Gate (TG) des betrachteten Busknotens zusteuern. Der Bus-Master (BM) kann das Transfer-Gate-Control-Register (TGCR) des betrachteten Busknotens (BS1,BS2,BS3) über die Master-Eindrahtdatenbusschnittstelle (OWM) und den Eindrahtdatenbus (b1,b2,b3) oder den betrachteten Eindrahtdatenbusabschnitt (b1,b2,b3) und die Eindrahtdatenbusschnittstelle (OWS1,OWS2,OWS3) des betrachteten Busknotens beschreiben. Somit ist der Bus-Master in der Lage, den Zustand des Transfer-Gates (TG1) des betrachteten Busknotens (BS1,BS2,BS3) zusteuern.

In einer weiteren Ausprägung weist der betrachtete Busknoten (BS1,BS2,BS3) intern mindestens eine IEEE 1149 konforme Schnittstelle, auch als JTAG-Schnittstelle bekannt, auf, die über die Eindrahtdatenbusschnittstelle (OWS1,OWS2,OWS3) des betrachteten Busknotens mit dem Eindrahtdatenbus (b1,b2,b3) oder zumindest dem betrachten Eindrahtdatenbusabschnitt (b1,b2,b3) verbunden ist, so dass der Bus-Master (BM) diese JTAG-Schnittstelle über den Eindrahtdatenbus (b1,b2,b3) oder zumindest den betrachten Eindrahtdatenbusabschnitt (b1,b2,b3) bedienen kann. Dabei ist eine JTAG-Schnittstelle im Sinne der Erfindung dadurch gekennzeichnet, dass sie einen Test-Controller (TAPC) in Form eines endlichen Automaten - auch "Finite-State-Machine" genannt - aufweist, der ein IEEE 1149 konformes Zustandsdiagramm entsprechend Fig. 1 und der einleitenden Beschreibung dieser Anmeldung besitzt.

In einer weiteren vorteilhaften Ausprägung der Erfindung ist der Datenbus dadurch gekennzeichnet, dass das jeweilige Transfer-Gate-Control-Register (TGCR) des betrachteten Bus-knotens (BS1,BS2,BS3) mittels der mindestens einen JTAG-Test-Schnittstelle des betrachteten Busknotens (BS1,BS2,BS3) über den Eindrahtdatenbus (b1,b2,b3) oder zumindest den betrachten Eindrahtdatenbusabschnitt (b1,b2,b3) durch den Bus-Master (BM) beschrieben werden kann.

In einer weiteren vorteilhaften Ausprägung ist ein erfindungsgemäßes Datenbussystem dadurch gekennzeichnet, dass zumindest der betrachtete Busknoten, d.h. der Leuchtmittel-Bus-Knoten, dazu vorgesehen ist, ihm zugeordnete Leuchtmittel, im Folgenden als "betrachtete Leuchtmittel" bezeichnet, in Abhängigkeit von Datenanzusteuern, die über den Eindrahtdatenbus (b1,b2,b3) oder den betrachteten Eindrahtdatenbusabschnitt (b1,b2,b3) von dem Bus-Master (BM) zum betrachteten Busknoten (BS1,BS2,BS3) übertragen werden.

In einer weiteren vorteilhaften Ausprägung ist ein erfindungsgemäßes Datenbussystem dadurch gekennzeichnet, dass die JTAG-Schnittstelle des betrachteten Busknotens mindestens ein Beleuchtungsregister (ILR) als Datenregister (DR) der JTAG-Schnittstelle des betrachteten Busknotens umfasst, von dessen zumindest zeitweiligem Inhalt zumindest zeitweilig die Ansteuerung der betrachteten Leuchtmittel, insbesondere in Helligkeit und/oder Farbtemperatur durch den betrachteten Busknotens mittels dessen PWM-Einheiten (PWM1,PWM2,PWM3) abhängt.

In einer weiteren vorteilhaften Ausprägung ist ein erfindungsgemäßes Datenbussystem dadurch gekennzeichnet, dass die JTAG-Schnittstelle des betrachteten Busknotens mindestens ein Beleuchtungskontrollregister (ILCR) als Datenregister (DR) der JTAG-Schnittstelle des betrachteten Busknotens und ein Beleuchtungsregister (ILR) als Datenregister (DR) der JTAG-Schnittstelle des betrachteten Busknotens umfasst. Zumindest von Teilen des Inhalts des Beleuchtungskontrollregisters (ILCR) hängt ab, ob das Beleuchtungsregister (ILR) über die JTAG-Schnittstelle mittels des kombinierten TMS-TDI-Signals (TMS_TDI) der JTAG-Schnittstelle des betrachteten Busknotens oder über einen separaten Dateneingang (SILDI) des betrachteten Busknotens die seriellen Beleuchtungsdaten zur Ansteuerung der betrachteten Leuchtmittel von dem Bus-Master (BM) oder einem anderen Busknoten erhält. Vom dem zumindest zeitweiligen Inhalt des Beleuchtungsregisters (ILR) hängt in diesem Fall zumindest zeitweilig die Ansteuerung der betrachteten Leuchtmittel durch den betrachteten Bus-Knoten ab.

Das erfindungsgemäße Datenbussystem ist in einer weiteren vorteilhaften Ausgestaltung versehen mit einer Bezugspotenzialleitung (GND) und einem Eindrahtdatenbus (b1,b2,b3) zur Übertragung von Daten zwischen einen Bus-Master (BM) und mindestens zwei Busknoten (BS1,BS2,BS3), insbesondere Leuchtmittel-Bus-Knoten. Dabei wird der Eindrahtdatenbus (b1,b2,b3) durch die Busknoten (BS1,BS2,BS3) in mindestens zwei Eindrahtdatenbusabschnitte (b1,b2,b3) unterteilt. Er wird durch einen Busknoten, den abschließenden Busknoten (BS3) abgeschlossen. Jeder der Busknoten (BS1,BS2,BS3) bis auf den zum Bus-Master (BM) nächst gelegenen, ersten Busknoten (BS1) wird durch einen vorausgehenden Eindrahtdatenbusabschnitt (b2, b3) mit einem vorausgehenden Busknoten (BS1,BS2) verbunden. Der erste Busknoten (BS1) wird durch einen vorausgehenden Eindrahtdatenbusabschnitt (b1) mit dem Bus-Master (BM) verbunden. Jeder Busknoten (BS1,BS2,BS3) bis auf einen abschließenden Busknoten (BS3) ist durch einen nachfolgenden Eindrahtdatenbusabschnitt (b2, b3) mit einem nachfolgenden Busknoten (BS3, BS4) verbunden. Das Datenbussystem verfügt über den Bus-Master (BM) mit einer Master-Eindrahtdatenbusschnittstelle (OWM). Die Master-Eindrahtdatenbusschnittstelle (OWM) ist dabei wie beschrieben dazu vorgesehen, mittels eines Datenbusprotokolls mit mehr als zwei physikalischen Spannungs- und/oder Strompegeln bidirektional Daten über den Eindrahtdatenbus (b1,b2,b3) oder zumindest einen der Eindrahtdatenbusabschnitte (b1,b2,b3), im Folgenden als "betrachteter Eindrahtdatenbusabschnitt" (b1,b2,b3) bezeichnet, zu senden und von diesem zu empfangen. Der betrachtete Eindrahtdatenbusabschnitt (b1,b2,b3) umfasst nur eine einzige Signalleitung. An den betrachteten Eindrahtdatenbusabschnitt (b1,b2,b3) ist die Eindrahtdatenbusschnittstelle (OWS1,OWS2,OWS3) eines der Busknoten (BS1,BS2,BS3), im Folgenden als "betrachteter Busknoten" bezeichnet, elektrisch angeschlossen. Die Eindrahtdatenbusschnittstelle (OWS1,OWS2,OWS3) des betrachteten Busknotens ist dazu vorgesehen, mittels eines Datenbusprotokolls mit mehr als zwei physikalischen Spannungs- und/oder Strompegeln Daten von dem betrachteten Eindrahtdatenbusabschnitt (b1,b2,b3) zu empfangen. Der betrachtete Busknoten (BS1,BS2,BS3) umfasst ein Busknotenadressregister (BKADR) als Datenregister (DR) einer JTAG-Schnittstelle, das durch den Bus-Master (BM) vorzugsweise nur bei geöffnetem Transfer-Gate (TG) beschrieben werden kann, wobei von dessen Inhalt sowie vom Inhalt des Senderegisters (SR) der JTAG-Schnittstelle des Bus-knotens abhängt, ob die Eindrahtdatenbusschnittstelle (OWS1,OWS2,OWS3) des betrachteten Busknotens Daten zu dafür vorgesehenen Zeitpunkten und/oder nach Übersendung spezifischer Daten, beispielsweise einer Sendeadresse für die Senderegister (SR) der Bus-knoten, durch den Bus-Master (BM) oder einen anderen der Busknoten (BS1,BS2,BS3) auf den Eindrahtdatenbus (b1,b2,b3) und/oder auf den betrachteten Eindrahtdatenbusabschnitt (b1,b2,b3) Daten ausgeben darf. Die Eindrahtdatenbusschnittstelle (OWS1,OWS2,OWS3) des betrachteten Busknotens ist dazu vorgesehen, mittels eines Datenbusprotokolls mit mindestens zwei physikalischen Spannungs- und/oder Strompegeln Daten über den betrachteten Eindrahtdatenbusabschnitt (b1,b2,b3) zu senden.

In einer weiteren zweckmäßigen Ausprägung ist ein erfindungsgemäßes Datenbussystem dadurch gekennzeichnet, dass der betrachtete Busknoten (BS1,BS2,BS3) intern mindestens eine IEEE 1149 konforme Schnittstelle, auch als JTAG-Schnittstelle bekannt, aufweist, die über die Eindrahtdatenbusschnittstelle (OWS1,OWS2,OWS3) des betrachteten Busknotens (BS1,BS2,BS3) mit dem Eindrahtdatenbus (b1,b2,b3) oder zumindest dem betrachten Eindrahtdatenbusabschnitt (b1,b2,b3) verbunden ist, so dass der Bus-Master (BM) über den Eindrahtdatenbus (b1,b2,b3) oder zumindest den betrachten Eindrahtdatenbusabschnitt (b1,b2,b3) diese JTAG-Schnittstelle bedienen kann. Dabei ist eine JTAG-Schnittstelle im Sinne der Erfindung dadurch gekennzeichnet, dass sie einen Test-Controller (TAPC) in Form eines endlichen Automaten - auch Finite-State-Machine genannt - aufweist, der ein IEEE1149 konformes Zustandsdiagramm entsprechend Fig. 1 besitzt.

In einer weiteren vorteilhaften Ausprägung ist ein erfindungsgemäßes Datenbussystem dadurch gekennzeichnet, dass an den betrachteten Eindrahtdatenbusabschnitt (b1,b2,b3) ein erstes Transfer-Gate (TG1) des betrachteten Bus-Knotens (BS1,BS2,BS3) elektrisch angeschlossen ist. Das erste Transfer-Gate (TG1, TG2, TG3) des betrachteten Busknotens ist dazu vorgesehen, den betrachteten Eindrahtdatenbusabschnitt (b1,b2) von dem optionalen, nachfolgenden Eindrahtdatenbusabschnitt (b2,b3) zu trennen und/oder mit diesem elektrisch zu verbinden. Der betrachtete Bus-Knoten (BS1,BS2,BS3) verfügt über ein erstes Transfer-Gate-Control-Register (TGCR) als Datenregister (DR) der JTAG-Schnittstelle, das dazu ausgelegt ist, das erste Transfer-Gate (TG1) zusteuern. Das jeweilige Transfer-Gate-Control-Register (TGCR) des betrachteten Busknotens (BS1,BS2,BS3) kann mittels der mindestens einen JTAG-Test-Schnittstelle des betrachteten Busknotens (BS1,BS2,BS3) über den Eindrahtdatenbus (b1,b2,b3) oder zumindest den betrachten Eindrahtdatenbusabschnitt (b1,b2,b3) zumindest durch den Bus-Master (BM) beschrieben werden.

In einer weiteren vorteilhaften Ausprägung ist ein erfindungsgemäßes Datenbussystem dadurch gekennzeichnet, dass zumindest der betrachtete Busknoten, d.h. der Leuchtmittel-Bus-Knoten, dazu vorgesehen ist, ihm zugeordnete Leuchtmittel (LM), im Folgenden als "betrachtete Leuchtmittel" (LM) bezeichnet, in Abhängigkeit von Daten anzusteuern, die über den Eindrahtdatenbus (b1,b2,b3) oder den betrachteten Eindrahtdatenbusabschnitt (b1,b2,b3) von dem Bus-Master (BM) zum betrachteten Busknoten (BS1,BS2,BS3) übertragen werden.

In einer weiteren zweckmäßigen Ausprägung ist ein erfindungsgemäßes Datenbussystem dadurch gekennzeichnet, dass die JTAG-Schnittstelle des betrachteten Busknotens mindestens ein Beleuchtungsregister (ILR) als Datenregister (DR) der JTAG-Schnittstelle des betrachteten Busknotens umfasst, von dessen zumindest zeitweiligem Inhalt zumindest zeitweilig die Ansteuerung der betrachteten Leuchtmittel (LM) durch den betrachteten Busknotens abhängt. Dies kann z.B. den Duty-Cycle, die Amplitude, die Frequenz und andere Parameter der PWM-Ansteuerung betreffen.

In einer weiteren zweckmäßigen Ausprägung ist ein erfindungsgemäßes Datenbussystem dadurch gekennzeichnet, dass die JTAG-Schnittstelle des betrachteten Busknotens mindestens ein Beleuchtungskontrollregister (ILCR) als Datenregister der JTAG-Schnittstelle des betrachteten Busknotens und ein Beleuchtungsregister (ILR) als Datenregister der JTAG-Schnittstelle des betrachteten Busknotens umfasst. Zumindest von Teilen des Inhalts des Beleuchtungskontrollregisters (ILCR) hängt ab, ob das Beleuchtungsregister (ILR) über die Testdatenschnittstelle (TMS_TDI) der JTAG-Schnittstelle des betrachteten Busknotens oder einen separaten Dateneingang (SILDI) des betrachteten Busknotens die vorzugsweise seriellen Beleuchtungsdaten zur Steuerung der Ansteuervorrichtung der betrachteten Leuchtmittel von dem Bus-Master oder einem anderen Busknoten erhält. Vom dem zumindest zeitweiligem Inhalt des Beleuchtungsregisters (ILR) hängt dabei zumindest zeitweilig die Ansteuerung der betrachteten Leuchtmittel (LM) durch den betrachteten Bus-Knoten ab.

Eine JTAG-Schnittstelle eines Busknotens (BS1,BS2,BS3) zur Steuerung der Ansteuervorrichtung für Leuchtmittel (LM) durch einen Busknoten (BS1,BS2,BS3) einer Leuchtkette ist vorteilhafterweise dadurch gekennzeichnet, dass sie mindestens ein Beleuchtungsregister (ILR) als Datenregister (DR) dieser JTAG-Schnittstelle umfasst, von dessen zumindest zeitweiligem Inhalt zumindest zeitweilig die Ansteuerung der Leuchtmittel (LM) durch den Bus-knoten (BS1,BS2,BS3) abhängt. Wie im Stand der Technik bekannt, ist eine JTAG-Schnittstelle dadurch gekennzeichnet, dass der Test-Controller (TAPC) ein Zustandsdiagramm entsprechend dem IEEE 1149-Standard (siehe auch Fig. 1) und insbesondere einem oder mehreren dessen Unterstandards IEEE 1149.1 bis IEEE 1149.8 und deren Weiterentwicklungen umfasst. Diese Definition einer JTAG-Schnittstelle gilt für das ganze Dokument.

Ein Verfahren zur Ansteuerung eines Leuchtmittels (LM) mittels einer elektrischen Regelvorrichtung innerhalb eines Busknotens (BS1,BS2,BS3) von mehreren Busknoten (BS1,BS2,BS3), des betrachteten Busknotens, umfasst danach folgende Schritte:
Übertragung von Steuerdaten für die Einstellung von Leuchtwerten für mindestens ein Leuchtmittel durch Ansteuerung eines JTAG-Controllers (TAPC) einer JTAG-Schnittstelle innerhalb des betrachteten Busknotens (BSₙ), der mindestens ein Leuchtmittel (LM) mit steuerbarer elektrischer Energie in Abhängigkeit von diesen Steuerdaten versorgt. Dabei ist die JTAG-Schnittstelle dadurch gekennzeichnet, dass der Test-Controller (TAPC) ein Zustandsdiagramm entsprechend dem IEEE 1149-Standard und/oder insbesondere einem oder mehreren der Unterstandards IEEE 1149.1 bis IEEE 1149.8 und deren Weiterentwicklungen umfasst.

Eine JTAG-Schnittstelle zur Steuerung der Ansteuervorrichtung für Leuchtmitteln durch einen Busknoten (BS1,BS2,BS3) einer Leuchtkette kann auch dadurch gekennzeichnet sein, dass sie mindestens ein Beleuchtungskontrollregister (ILCR) als Datenregister der JTAG-Schnittstelle und ein Beleuchtungsregister (ILR) als Datenregister der JTAG-Schnittstelle umfasst. Zumindest von Teilen des Inhalts des Beleuchtungskontrollregisters (ILCR) hängt dann erfindungsgemäß ab, ob das Beleuchtungsregister (ILR) die Beleuchtungsdaten zur Steuerung der Ansteuervorrichtung der Leuchtmittel durch den Busknoten über die Testdatenschnittstelle (TMS_TDI) der JTAG-Schnittstelle oder über einen separaten Dateneingang (SILDI) erhält. Diese Register können auch Teilregister des Instruktionsregisters (IR) oder eines anderen Datenregisters der JTAG-Schnittstelle sein. Die separate Realisierung ist aber in der Regel vorzuziehen. Vom zumindest zeitweiligen Inhalt des Beleuchtungsregisters (ILR) hängt dann zumindest zeitweilig die Ansteuerung der Leuchtmittel durch den Busknoten (BS1,BS2,BS3) ab. Dabei ist die JTAG-Schnittstelle dadurch gekennzeichnet, dass sie einen Test-Controller (TAPC) umfasst, der ein Zustandsdiagramm entsprechend dem IEEE 1149-Standard und insbesondere einem oder mehreren der Unterstandards IEEE 1149.1 bis IEEE 1149.8 und deren Weiterentwicklungen aufweist.

Ein erfindungsgemäßer Datenbus zwischen einer ersten Teilvorrichtung, dem Bus-Master (BM), und mindestens zwei weiteren Teilvorrichtungen, den Busknoten (BS1,BS2,BS3) weist eine Bezugspotenzialleitung (GND) mit einem Bezugspotenzial (V₀) und einen Eindrahtdatenbus (b1,b2,b3) zur Datenübertragung und zur Systemtaktübertragung zwischen dem Bus-Master (BM) und den Busknoten (BS1, BS2) auf. Dabei wird der Eindrahtdatenbus (b1,b2,b3) durch die Busknoten (BS1,BS2,BS3) in mindestens zwei Eindrahtdatenbusabschnitte (b1,b2,b3) unterteilt. Jeder dieser Busknoten (BS1,BS2,BS3) ist bis auf den zum Bus-Master nächstgelegenen ersten Busknoten (BS1) über einen vorausgehenden Eindrahtdatenbusabschnitt (b1,b2,b3) mit einem vorausgehenden Busknoten (BS1, BS2) verbunden. Der erste Busknoten (BS1) ist durch einen vorausgehenden Eindrahtdatenbusabschnitt (b1) mit dem Bus-Master (BM) verbunden. Jeder dieser Busknoten (BS1,BS2,BS3) ist bis auf den abschließenden Busknoten (BS3) durch einen nachfolgenden Eindrahtdatenbusabschnitt (b2, b3) mit einem nachfolgenden Busknoten (BS2, BS3) verbunden. Dies gilt, wenn der Busknoten nicht der letzte Busknoten (B3) der Kette der Busknoten (BS1,BS2,BS3) vom Bus-Master (BM) aus in der Folge der Busknoten (BS1,BS2,BS3) ist. Über den Eindrahtdatenbus (b1,b2,b3) oder zumindest über einen der Eindrahtdatenbusabschnitte (b1,b2,b3) (im Folgenden "betrachteter Eindrahtdatenbusabschnitt (b1,b2,b3)" genannt), werden bidirektional Daten zwischen dem Bus-Master (BM) und einem Busknoten (BS1 BS2, BS3) (im Folgenden "betrachteter Busknoten (BS1,BS2,BS3)" genannt) übertragen oder können übertragen werden. Über den Eindrahtdatenbus (b1,b2,b3) oder zumindest über den betrachteten Eindrahtdatenbusabschnitt (b1,b2,b3) wird ein Systemtakt mit einer Systemtaktperiode (T), die mindestens in eine erste Halbtaktperiode (T_{1H}) und eine zweite Halbtaktperiode (T_{2H}) unterteilt ist, welche eine unterschiedliche zeitliche Dauer haben können, vom Bus-Master (M) zu dem betrachteten Busknoten (BS1,BS2,BS3) zusätzlich übertragen. Zumindest der betrachtete Busknoten (BS1,BS2,BS3) verfügt über eine erste Einrichtung, insbesondere über einen ersten Komparator (C_{2H}), die bzw. der den Signalpegel in Form einer Signalspannung zwischen dem Bezugspotenzial (V₀) der Bezugspotenzialleitung (GND) und dem Potenzial des betrachteten Eindrahtdatenbusabschnitts (b1,b2,b3) mit einem ersten Schwellwert, insbesondere dem eines ersten Schwellwertsignals (V_{2H}), vergleicht. Der betrachtete Busknoten verfügt über eine zweite Einrichtung, insbesondere über einen zweiten Komparator (C_{2L}), der den Signalpegel in Form einer Signalspannung zwischen dem Bezugspotenzial (V₀) der Bezugspotenzialleitung (GND) und dem Potenzial des betrachteten Eindrahtdatenbusabschnitts (b1,b2,b3) mit einem zweiten Schwellwert, insbesondere dem eines zweiten Schwellwertsignals (V_{2L}), vergleicht. Der erste Schwellwert ist dabei vom zweiten Schwellwert verschieden. Der erste Schwellwert und zweite Schwellwert definieren dabei zwischen der Betriebsspannung (V_{IO},V_{IO1},V_{IO2}) und dem Bezugspotenzial (V₀) der Bezugspotenzialleitung (GND) drei Signalspannungsbereiche (V_{B1},V_{B2},V_{B3}). Dabei wird ein mittlerer Spannungsbereich als zweiter Spannungsbereich (V_{B2}) von einem ersten Spannungsbereich (V_{B1}) nach oben - alternativ -oder unten hin begrenzt. Der zweite Spannungsbereich (V_{B2}) wird nach unten - alternativ - oder oben hin durch einen dritten Spannungsbereich (V_{B3}) begrenzt. Dabei werden Daten auf dem betrachteten Eindrahtdatenbusabschnitt (b2,b3) in zeitlich beabstandeten oder aufeinander folgenden Zeitschlitzpaketen von zumindest drei aufeinanderfolgenden Zeitschlitzen (TIN0,TIN1,TDO) mit jeweils einer Dauer einer Systemtaktperiode (T) übertragen. Ein erster Zeitschlitz (TINO) und ein zweiter Zeitschlitz (TIN1) enthalten zumindest ein Kontrolldatum und/oder ein erstes Datum, das jeweils vom Bus-Master (BM) zum betrachteten Busknoten (BS1,BS2,BS3) übertragen wird, wobei das Kontrolldatum und das erste Datum insbesondere mit den Daten des IEEE 1149.1 Vierdraht-Testdatenbusses oder zu einem andren Unterstandard des IEEE 1149-Standards kompatibel sein können und wobei der betrachtete Busknoten (BS1,BS2,BS3) das Kontrolldatum und das erste Datum empfängt. Ein dritter Zeitschlitz (TDO) enthält ein zweites Datum, das der betrachtete Busknoten (BS1,BS2,BS3) zum Bus-Master (BM) überträgt, wobei der Bus-Master (BM) dieses zweite Datum empfängt und wobei das zweite Datum nur im zweiten Spannungsbereich (V_{B2}) und dritten Spannungsbereich (V_{B3}) übertragen wird. Die Übertragung der Daten erfolgt in einer Taktperiode der mindestens zwei (z.B. Halb-)Taktperioden (T_{1H},T2_{H}) einer Systemtaktperiode (T). Der Systemtakt wird durch ein Taktsignal im ersten Spannungsbereich (V_{B1}) während der jeweils anderen Halbtaktperiode der mindestens zwei Halbtaktperioden (T_{1H},T_{2H}) der Systemtaktperiode (T) übertragen wird.

In einer anderen vorteilhaften Ausprägung der Erfindung zeichnet sich der zwischen einer ersten Teilvorrichtung (dem Bus-Master (BM)) und mindestens zwei weiteren Teilvorrichtungen (den Busknoten (BS1,BS2,BS3)) angeordnete erfindungsgemäße Datenbus dadurch aus, dass beim bidirektionalen Senden der Daten auf dem Eindrahtdatenbus (b1,b2,b3) oder zumindest dem betrachteten Eindrahtdatenbusabschnitt (b1,b2,b3) durch den Bus-Master (BM) und die Busknoten (BS1,BS2,BS3) mindestens drei logische Zustände verwendet werden.

In einer weiteren zweckmäßigen Ausprägung der Erfindung zeichnet sich der zwischen einer ersten Teilvorrichtung (dem Bus-Master (BM)) und mindestens zwei weiteren Teilvorrichtungen (den Busknoten (BS1,BS2,BS3)) angeordnete erfindungsgemäße Datenbus dadurch aus, dass ein erster der mindestens drei logischen Zustände auf dem Eindrahtdatenbus (b1,b2,b3) oder zumindest dem betrachteten Eindrahtdatenbusabschnitt (b1,b2,b3) durch einen ersten dominanten Schalter (S_{1L}) des Bus-Masters (BM) erzeugt wird, der das Potenzial des Eindrahtdatenbusses (b1,b2,b3) oder zumindest des betrachteten Eindrahtdatenbusabschnitts (b1,b2,b3) in den ersten Spannungsbereich (V_{B1}) zwingt.

In einer anderen zweckmäßigen Ausprägung der Erfindung zeichnet sich der zwischen einer ersten Teilvorrichtung (dem Bus-Master (BM)) und mindestens zwei weiteren Teilvorrichtungen (den Busknoten (BS1,BS2,BS3)) angeordnete erfindungsgemäße Datenbus dadurch aus, dass ein zweiter der mindestens drei logischen Zustände auf dem Eindrahtdatenbus (b1,b2,b3) oder zumindest dem betrachteten Eindrahtdatenbusabschnitt (b1,b2,b3) durch Einschalten einer ersten schaltbaren Stromquelle (I₁,S_{1H}) in dem Bus-Master (BM) und/oder durch Einschalten einer zweiten schaltbaren Stromquelle (I₂,S_{2H}) in dem Bus-Master (BM) erzeugt wird.

In einer anderen vorteilhaften Ausprägung der Erfindung zeichnet sich der zwischen einer ersten Teilvorrichtung (dem Bus-Master (BM)) und mindestens zwei weiteren Teilvorrichtungen (den Busknoten (BS1,BS2,BS3)) angeordnete erfindungsgemäße Datenbus dadurch aus, dass das Einschalten der ersten schaltbaren Stromquelle (I₁,S_{1H}) in dem Bus-Master (BM) und/oder das Einschalten der zweiten schaltbaren Stromquelle (I₂,S_{2H}) in dem Bus-Master (BM) das Potenzial auf dem Eindrahtdatenbus oder zumindest dem betrachteten Eindrahtdatenbusabschnitt (b1,b2,b3) auf ein Potenzial im dritten Spannungsbereich (V_{B3}) zwingt, sofern der erste dominante Schalter (S_{1L}) des Bus-Masters (BM) nicht eingeschaltet ist, der das Potenzial des Eindrahtdatenbusses oder zumindest des betrachteten Eindrahtdatenbusabschnitts (b1) beim Einschalten in den ersten Spannungsbereich zwingt und die schaltbaren Stromquellen (I₁,S_{1H},I₂,S_{2H}) überschreibt.

In einer anderen vorteilhaften Ausprägung der Erfindung zeichnet sich der zwischen einer ersten Teilvorrichtung ( dem Bus-Master (BM)) und mindestens zwei weiteren Teilvorrichtungen (den Busknoten (BS1,BS2,BS3)) angeordnete erfindungsgemäße Datenbus dadurch aus, dass ein dritter der mindestens drei logischen Zustände auf der dem Eindrahtdatenbus (b1,b2, b3) oder zumindest dem betrachteten Eindrahtdatenbusabschnitt (b1,b2,b3) durch einen Pull-Schaltkreis (R_{0H},R_{0L}) erzeugt wird, wenn keiner der anderen logischen Zustände vorliegt, indem der Pull-Schaltkreis (R_{0H},R_{0L}) das Potenzial des Eindrahtdatenbusses oder zumindest des betrachteten Eindrahtdatenbusabschnitts (b1,b2,b3) auf ein mittleres Potenzial (VM) im zweiten Spannungsbereich (V_{B3}) bringt.

In einer anderen vorteilhaften Ausprägung der Erfindung zeichnet sich der zwischen einer ersten Teilvorrichtung (dem Bus-Master (BM)) und mindestens zwei weiteren Teilvorrichtungen (den Busknoten (BS1,BS2,BS3)) angeordnete erfindungsgemäße Datenbus dadurch aus, dass Wechsel vom einem zweiten oder einem dritten logischen Zustand auf dem Eindrahtdatenbus (b1,b2, b3) oder zumindest dem betrachteten Eindrahtdatenbusabschnitt (b1,b2,b3) auf der einen Seite zu einem ersten logischen Zustand auf dem Eindrahtdatenbus (b1,b2,b3) oder zumindest dem betrachteten Eindrahtdatenbusabschnitt (b1,b2,b3) auf der anderen Seite und Wechsel in die umgekehrte Richtung zur Übertragung eines Taktsignals benutzt werden.

In einer anderen vorteilhaften Ausprägung der Erfindung zeichnet sich der zwischen einer ersten Teilvorrichtung (dem Bus-Master (BM)) und mindestens zwei weiteren Teilvorrichtungen (den Busknoten (BS1,BS2,BS3)) angeordnete erfindungsgemäße Datenbus dadurch aus, dass Wechsel von einem ersten oder einem zweiten logischen Zustand auf dem Eindrahtdatenbus (b1,b2,b3) oder zumindest dem betrachteten Eindrahtdatenbusabschnitt (b1,b2,b3) auf der einen Seite zu einem dritten logischen Zustand auf dem Eindrahtdatenbus (b1,b2,b3) oder zumindest dem betrachteten Eindrahtdatenbusabschnitt (b1,b2,b3) auf der anderen Seite und Wechsel in die umgekehrte Richtung zur Übertragung eines Datensignals vom Bus-Master (BM) zum betrachteten Busknoten und/oder von dem betrachteten Busknoten zum Bus-Master (BM) benutzt werden.

In einer anderen zweckmäßigen Ausprägung der Erfindung zeichnet sich der zwischen einer ersten Teilvorrichtung (dem Bus-Master (BM)) und mindestens zwei weiteren Teilvorrichtungen (den Busknoten (BS1,BS2,BS3)) angeordnete erfindungsgemäße Datenbus dadurch aus, dass die Daten in einer Halbtaktperiode der mindestens zwei Halbtaktperioden (T_{1H},T_{2H}) eines Zeitschlitzes übertragen werden und der Systemtakt in einer anderen Halbtaktperiode der mindestens zwei Halbtaktperioden (T_{1H},T_{2H}) eines Zeitschlitzes wobei der Zeitschlitz eine Länge einer Systemtaktperiode (T) mit mindestens zwei Halbtaktperioden (T_{1H},T_{2H}) aufweist. Ein erfindungsgemäßer Datenbus zwischen einer ersten Teilvorrichtung, dem Bus-Master (BM), und mindestens zwei weiteren Teilvorrichtungen, den Busknoten (BS1,BS2,BS3) (,wobei der Datenbus eine Bezugspotenzialleitung (GND) mit einem Bezugspotenzial (V₀) und einen Eindrahtdatenbus (b1,b2,b3) mit einer einzelnen Datenleitung aufweist, der durch die Busknoten (BS1,BS2,BS3) in mehrere Eindrahtdatenbusabschnitte (b1,b2,b3) unterteilt wird und durch einen letzten Busknoten (BS3) der Busknoten (BS1,BS2,BS3) (den abschließenden Busknoten (BS3)) abgeschlossen wird,) kann auch wie folgt gekennzeichnet werden: Der Bus-Master (BM) weist eine Master-Eindrahtdatenbusschnittstelle (OWM) auf. Die Master-Eindrahtdatenbusschnittstelle (OWM) weist weiter eine erste schaltbare Spannungsquelle (S_{1L}) mit einem ersten Innenwiderstand (R_{1L}) auf, die den Eindrahtdatenbus (b1,b2,b3) oder zumindest einen Eindrahtdatenbusabschnitt (b1,b2,b3) (im Folgenden "betrachteter Eindrahtdatenbusabschnitt" genannt) mit einem ersten Potenzial (V0) verbinden kann. Die Master-Eindrahtdatenbusschnittstelle (OWM) weist eine zweite schaltbare Spannungsquelle (S_{1H},I₁) mit einem zweiten Innenwiderstand (R_{1H}) auf, die zumindest den betrachteten Eindrahtdatenbusabschnitt (b1,b2,b3) des Eindrahtdatenbusses (b1,b2,b3) oder den Eindrahtdatenbus (b1,b2,b3) mit einem zweiten Potenzial (V_{IO1}) verbinden kann, wobei die zweite schaltbare Spannungsquelle auch eine Stromquelle (S_{1H},I₁) mit einem zweiten Innenwiderstand (R_{1H}) und dem Stromwert (I₁=V_{IO1}/R_{1H}) sein kann. Zumindest einer der Busknoten (BS1,BS2,BS3) (im Folgenden als "betrachteter Busknoten" bezeichnet) weist eine Eindrahtdatenbusschnittstelle (OWS1,OWS2,OWS3) (im Folgenden mit "betrachteter Eindrahtdatenbusschnittstelle" bezeichnet) auf. Zumindest diese betrachtete Eindrahtdatenbusschnittstelle (OWS1,OWS2,OWS3) des betrachteten Busknotens weist eine dritte schaltbare Spannungsquelle (S_{2H},I₂) mit einem dritten Innenwiderstand (R_{2H}) auf, die zumindest den betrachteten Eindrahtdatenbusabschnitt (b1,b2,b3) des Eindrahtdatenbusses (b1,b2,b3) oder den Eindrahtdatenbus (b1,b2,b3) mit einem dritten Potenzial (V_{IO2}) verbinden kann, das vorzugsweise gleich dem zweiten Potenzial (V_{IO1}) ist und wobei die dritte schaltbare Spannungsquelle auch eine Stromquelle (S_{2H},I₂) mit einem dritten Innenwiderstand (R_{2H}) und dem Stromwert (I₂=V_{IO2}/R_{2H}) sein kann. Zumindest der betrachtete Eindrahtdatenbusabschnitt (b1,b2,b3) des Eindrahtdatenbusses (b1,b2,b3) oder der Eindrahtdatenbus (b1,b2,b3) wird durch eine vierte Spannungsquelle, insbesondere einen Pull-Schaltkreis (R_{0H}, R_{0L}) zwischen einem vierten Potenzial (V_{IO}), das vorzugsweise gleich dem zweiten und dem dritten Potenzial (V_{IO1},V_{IO2}) ist, und dem ersten Potenzial (V₀), mit einem vierten Innenwiderstand (R₀) auf einem mittleren Potenzial (V_{M}) gehalten. Der Wert des mittleren Potenzials (V_{M}) liegt dabei zwischen dem Wert des ersten Potenzials (V₀) und dem Wert des zweiten Potenzials (V_{IO1}) und/oder zwischen dem Wert des ersten Potenzials (V₀) und dem Wert des dritten Potenzial s(V_{IO2}). Der erste Innenwiderstand (R_{1L}) ist dabei kleiner als die anderen Innenwiderstände (R_{1H},R_{2H},R₀). Der vierte Innenwiderstand (R₀) ist größer als die anderen Innenwiderstände (R_{1H},R_{1L},R_{2H}).

Entsprechend lässt sich ein Verfahren zum Betreiben eines Datenbusses zwischen einer ersten Teilvorrichtung (dem Bus-Master (BM)) und mindestens zwei weiteren Teilvorrichtungen (den Busknoten (BS1,BS2,BS3)) formulieren. Dabei weist der Datenbus eine Bezugspotenzialleitung (GND) mit einem Bezugspotenzial (V0) und einen Eindrahtdatenbus (b1,b2,b3) auf, der durch die mindestens zwei Busknoten (BS1,BS2,BS3) in mindestens zwei Eindrahtdatenbusabschnitte (b1,b2,b3) unterteilt wird und durch mindestens einen der Busknoten (BS1,BS2,BS3) (den abschließenden Busknoten (BS3)) abgeschlossen wird. Das Verfahren umfasst die Schritte: Als ersten Schritt eine bidirektionale Übertragung von Daten über den Eindrahtdatenbus (b1,b2,b3) oder zumindest einen der Eindrahtdatenbusabschnitte (b1,b2,b3) (im Folgenden "betrachteter Eindrahtdatenbusabschnitt" genannt) zwischen dem Bus-Master (BM) und mindestens einem Busknoten (BS1,BS2,BS3) (im Folgenden "betrachteter Busknoten" genannt). Als zweiten Schritt die Übertragung eines Taktsignals über den Eindrahtdatenbus (b1,b2,b3) oder zumindest dem besagten Eindrahtdatenbusabschnitt (b1,b2,b3) vom Bus-Master (BM) zu zumindest dem betrachteten Busknoten (BS1,BS2,BS3) mit einer Systemtaktperiode (T), die in mindestens eine erste Halbtaktperiode (T_{1H}) und eine zweite Halbtaktperiode (T_{2H}) unterteilt ist. Als dritten Schritt das Vergleichen des Signalpegels auf dem Eindrahtdatenbus (b1,b2,b3) oder zumindest dem betrachteten Eindrahtdatenbusabschnitt (b1,b2,b3) in Form einer Signalspannung zwischen dem Bezugspotenzial (V0) der Bezugspotenzialleitung (GND) und dem Potenzial des Eindrahtdatenbusses (b1,b2,b3) oder zumindest des betrachteten Eindrahtdatenbusabschnitts (b1,b2,b3) mit einem ersten Schwellwert, insbesondere dem eines ersten Schwellwertsignals (V_{2H}), durch eine erste Einrichtung des betrachteten Busknotens (BS1,BS2,BS3), insbesondere einen ersten Komparator (C_{2H}); Als vierten Schritt das Vergleichen des Signalpegels auf dem Eindrahtdatenbus (b1,b2,b3) oder zumindest dem betrachteten Eindrahtdatenbusabschnitt (b1,b2,b3) in Form einer Signalspannung zwischen dem Bezugspotenzial (V₀) auf der Bezugspotenzialleitung (GND) und dem Potenzial des Eindrahtdatenbusses (b1,b2,b3) oder zumindest des betrachteten Eindrahtdatenbusabschnitts (b1,b2,b3) mit einem zweiten, vom ersten Schwellwert verschiedenen Schwellwert, insbesondere dem eines zweiten Schwellwertsignals (V_{2L}), durch eine zweite Einrichtung des betrachteten Busknotens (BS1,BS2,BS3), insbesondere einen zweiten Komparator (C_{2L}). Dabei definieren der erste und zweite Schwellwert drei Signalspannungsbereiche (V_{B1},V_{B2},V_{B3}) zwischen einer Betriebsspannung (V_{IO},V_{IO1},V_{IO2}) und dem Bezugspotenzial (V₀) der Bezugspotenzialleitung (GND). Ein mittlerer Spannungsbereich wird dabei als zweiter Spannungsbereich (V_{B2}) von einem ersten Spannungsbereich (V_{B1}) nach oben (alternativ nach unten) hin begrenzt wird, wobei der zweite Spannungsbereich (V_{B2}) nach unten (alternativ nach oben) hin durch einen dritten Spannungsbereich (V_{B3}) begrenzt wird; Als fünften Schritt die Übertragung der Daten auf dem Eindrahtdatenbus (b1,b2,b3) oder zumindest dem betrachteten Eindrahtdatenbusabschnitt (b1,b2,b3) in Zeitschlitzpaketen von zumindest drei aufeinanderfolgenden Zeitschlitzen (TIN0,TIN1,TDO) mit jeweils einer Dauer einer Systemtaktperiode (T), wobei die Reihenfolge der Zeitschlitze (TIN0,TIN1,TDO) innerhalb der Folge dieser mindestens drei Zeitschlitze (TIN0,TIN1,TDO) systemspezifisch gewählt werden kann; Als sechsten Schritt das Übertragen zumindest eines Kontrolldatums und/oder eines ersten Datums in einem ersten Zeitschlitz (TINO) und in einem zweiten Zeitschlitz (TIN1) vom Bus-Master (BM) zum betrachteten Busknoten (BS1,BS2,BS3), wobei das Kontrolldatum und das erste Datum insbesondere mit den Daten des IEEE 1149-Standards kompatibel sind und wobei der betrachte Busknoten (BS1,BS2,BS3) das Kontrolldatum und das erste Datum empfängt. Als siebten Schritt das Übertragen eines zweiten Datums in einer Halbtaktperiode der mindestens zwei Halbtaktperioden (T_{1H},T_{2H}) der Systemtaktperiode (T) im zweiten Spannungsbereich (V_{B2}) und im dritten Spannungsbereich (V_{B3}) auf dem Eindrahtdatenbus (b1,b2,b3) oder zumindest dem betrachteten Eindrahtdatenbusabschnitt (b1,b2,b3) vom betrachteten Busknoten (BS1,BS2,BS3) zum Bus-Master (BM) in einem dritten Zeitschlitz (TDO) der mindestens drei aufeinanderfolgenden Zeitschlitze (TIN0,TIN1,TDO), wobei der Bus-Master (BM) dieses zweite Datum empfängt; Als achten Schritt das Übertragen eines Kontrolldatums und/oder eines ersten Datums in einer Halbtaktperiode der mindestens zwei Halbtaktperioden (T_{1H}, T_{2H}) der Systemtaktperiode (T) des betreffenden Zeitschlitzes, im zweiten Spannungsbereich (V_{B2}) und dritten Spannungsbereich (V_{B3}) auf dem Eindrahtdatenbus (b1,b2,b3) oder zumindest dem betrachteten Eindrahtdatenbusabschnitt (b1,b2,b3) vom betrachteten Busknoten (BS1,BS2,BS3) zum Bus-Master (BM) in dem ersten und/oder zweiten Zeitschlitz (TIN0,TIN1) der mindestens drei aufeinanderfolgenden Zeitschlitze (TIN0,TIN1,TDO), wobei der betrachtete Busknoten (BS1,BS2,BS3) das Kontrolldatum und das erstes Datums empfängt, wobei die Übertragung der Daten durch Wechsel des Potenzials auf dem Eindrahtdatenbus (b1,b2,b3) oder zumindest dem betrachteten Eindrahtdatenbusabschnitt (b1,b2,b3) zwischen dem ersten Spannungsbereich (V_{B1}) und/oder zweiten Spannungsbereich (V_{B2}) auf der einen Seite und dem dritten Spannungsbereich (VB3) auf der anderen Seite und Wechsel in die Gegenrichtung erfolgt. Als neunten Schritt das Übertragen eines Systemtaktes in der jeweils anderen Halbtaktperiode der mindestens zwei Halbtaktperioden (T_{1H},T_{2H}) der Systemtaktperiode (T) des betreffenden Zeitschlitzes, typischerweise in jedem der mindestens drei Zeitschlitze (TIN0,TIN1,TDO), wobei in dieser Halbtaktperiode keine Daten gesendet werden und wobei die Übertragung des Systemtaktes in dem betreffenden Zeitschlitz durch einen Wechsel des Potenzials auf dem Eindrahtdatenbus (b1,b2,b3) oder zumindest dem betrachteten Eindrahtdatenbusabschnitt (b1,b2,b3) zwischen dem ersten Spannungsbereich (V_{B1}) auf der einen Seite und dem zweiten Spannungsbereich (V_{B2}) und/oder dritten Spannungsbereich (V_{B3}) auf der anderen Seite und durch den Wechsel in die Gegenrichtung erfolgt.

Eine Variante dieses Verfahren zeichnet sich dadurch aus, dass drei logische Zustände beim bidirektionalen Senden der Daten auf dem Eindrahtdatenbus (b1,b2,b3) oder zumindest dem betrachteten Eindrahtdatenbusabschnitt (b1,b2,b3) durch den Bus-Master (BM) und dem betrachteten Busknoten verwendet werden, wobei jeder logische Zustand einem, typischerweise genau einem, Spannungsbereich (V_{B1},V_{B2},V_{B3}) des Potenzials des Eindrahtdatenbusses (b1,b2,b3) oder zumindest des betrachteten Eindrahtdatenbusabschnitts (b1,b2,b3) zugeordnet ist.

Eine weitere Variante dieses Verfahren zeichnet sich aus durch ein zeitweises Schließen eines dominanten Schalters (S_{1L}) des Bus-Masters (BM), der auch ein Transistor oder ein anderer Halbleiterschalter sein kann, zur zeitweisen Erzeugung eines ersten der drei logischen Zustände auf dem Eindrahtdatenbus (b1,b2,b3) oder zumindest dem betrachteten Eindrahtdatenbusabschnitt (b1,b2,b3), wobei das Potenzial des Eindrahtdatenbusses (b1,b2,b3) oder zumindest des betrachteten Eindrahtdatenbusabschnitts (b1,b2,b3) in den ersten Spannungsbereich (V_{B1}) gezwungen wird.

Eine weitere Variante dieses Verfahren zeichnet sich aus durch ein zeitweises Einschalten einer ersten schaltbaren Stromquelle (I₁,S_{1H}) in dem Bus-Master (BM) und/oder durch zeitweises Einschalten einer zweiten schaltbaren Stromquelle (I₂,S_{2H}) in dem betrachteten Bus-knoten zur Erzeugung eines zweiten der drei logischen Zustände auf dem Eindrahtdatenbus (b1,b2,b3) oder zumindest dem betrachteten Eindrahtdatenbusabschnitt (b1,b2,b3).

Eine weitere Variante dieses Verfahren zeichnet sich dadurch aus, dass das Einschalten der ersten schaltbaren Stromquelle (I₁, S_{1H}) in dem Bus-Master (BM) und/oder das Einschalten der zweiten schaltbaren Stromquelle (I₂, S_{2H}) in dem betrachteten Busknoten das Potenzial auf dem Eindrahtdatenbus (b1,b2,b3) oder zumindest dem betrachteten Eindrahtdatenbusabschnitt (b1,b2,b3) auf ein drittes Potenzial zwingt, sofern der erste dominante Schalter (S_{1L}) des Bus-Masters (BM) nicht eingeschaltet ist, der das Potenzial des Eindrahtdatenbusses (b1,b2,b3) oder zumindest des betrachteten Eindrahtdatenbusabschnitts (b1,b2,b3) in den ersten Spannungsbereich (V_{B1}) zwingt und die Stromquellen überschreibt, d.h. das Potential auf b1, das durch den Spannungsabfall über (R_{0L}) durch den Strom (I₂) entsteht, auf Masse zwingt.

Eine weitere Variante dieses Verfahren zeichnet sich durch das Erzeugen eines dritten der drei logischen Zustände auf dem Eindrahtdatenbus (b1,b2,b3) oder zumindest dem betrachteten Eindrahtdatenbusabschnitt (b1,b2,b3) durch einen Pull-Schaltkreis (R_{0H},R_{0L}) aus, wenn keiner der anderen logischen Zustände auf dem Eindrahtdatenbus (b1,b2,b3) oder zumindest dem betrachteten Eindrahtdatenbusabschnitt (b1,b2,b3) vorliegt, indem der Pull-Schaltkreis (R_{0H},R_{0L}) das Potenzial des Eindrahtdatenbusses (b1,b2,b3) oder zumindest des betrachteten Eindrahtdatenbusabschnitts (b1,b2,b3) auf ein mittleres Potenzial (V_{M}) im zweiten Spannungsbereich (V_{B2}) hebt.

Eine weitere Variante dieses Verfahren zeichnet sich durch die Übertragung eines Systemtakts durch das Wechseln vom zweiten oder dritten logischen Zustand auf dem Eindrahtdatenbus (b1,b2,b3) oder zumindest dem betrachteten Eindrahtdatenbusabschnitt (b1,b2,b3) auf der einen Seite zu einem ersten logischen Zustand auf dem Eindrahtdatenbus (b1,b2,b3) oder zumindest dem betrachteten Eindrahtdatenbusabschnitt (b1,b2,b3) auf der anderen Seite und durch den Wechsel in die umgekehrte Richtung aus.

Eine weitere Variante dieses Verfahren zeichnet sich durch die Übertragung von Daten durch das Wechseln vom ersten oder zweiten logischen Zustand auf dem Eindrahtdatenbus (b1,b2,b3) oder zumindest dem betrachteten Eindrahtdatenbusabschnitt (b1,b2,b3) auf der einen Seite zu einem dritten logischen Zustand auf dem Eindrahtdatenbus (b1,b2,b3) oder zumindest dem betrachteten Eindrahtdatenbusabschnitt (b1,b2,b3) auf der anderen Seite und durch den Wechsel in die umgekehrte Richtung aus.

Eine weitere Variante dieses Verfahren zeichnet sich durch aus, dass ein erstes oder zweites Datum oder ein Kontrolldatum oder anderes Datum in einer Halbtaktperiode der mindestens zwei Halbtaktperioden (T_{1H},T_{2H}) eines Zeitschlitzes der mindestens drei aufeinander folgenden Zeitschlitze (TIN0,TIN1,TDO) übertragen wird und ein Systemtakt in der anderen Halbtaktperiode der mindestens zwei Halbtaktperioden (T_{1H},T_{2H}) dieses Zeitschlitzes übertragen wird, wobei der Zeitschlitz die Länge einer Systemtaktperiode (T) mit mindestens zwei Halbtaktperioden (T_{1H},T_{2H}) aufweist.

Ein anderes Verfahren betrifft das Betreiben eines Datenbusses zwischen einer ersten Teilvorrichtung (dem Bus-Master (BM)) und mindestens zwei weiteren Teilvorrichtungen (den Busknoten (BS1,BS2,BS3)), wobei der Datenbus eine Bezugspotenzialleitung (GND) mit einem Bezugspotenzial (V₀) und einen Eindrahtdatenbus (b1,b2,b3) aufweist, der durch die mindestens zwei Busknoten in mindestens zwei Eindrahtdatenbusabschnitte (b1,b2,b3) unterteilt wird und durch mindestens einen der Busknoten (BS1,BS2,BS3) (den abschließenden Busknoten (BS3)) abgeschlossen wird. Das Verfahren umfasst als ersten Schritt das zeitweise Verbinden des Eindrahtdatenbusses (b1,b2,b3) oder zumindest der Eindrahtdatenbusabschnitte (b1,b2,b3) (im Folgenden als "betrachteter Eindrahtdatenbusabschnitt" bezeichnet) mit einem ersten Potenzial (V₀), und zwar mittels einer ersten zuschaltbaren Spannungsquelle (S_{1L}) des Bus-Masters (BM), die einen ersten Innenwiderstand (R_{1L}) hat. Als zweiten Schritt umfasst es das zeitweise Verbinden des Eindrahtdatenbusses (b1,b2,b3) oder zumindest des betrachteten Eindrahtdatenbusabschnitts (b1,b2,b3) mit einem zweiten Potenzial (V_{IO1}), und zwar mittels einer zweiten zuschaltbaren Spannungsquelle (S_{1H},I₁) des Bus-Masters (BM), die einen zweiten Innenwiderstand (R_{1H}) hat, wobei die zweite zuschaltbare Spannungsquelle auch eine Stromquelle (S_{1H},I₁) sein kann, die einen zweiten Innenwiderstand (R_{1H}) und dem Stromwert (I₁=V_{IO1}/R_{1H}) hat. Als dritten Schritt umfasst das Verfahren das zeitweise Verbinden des Eindrahtdatenbusses (b1,b2,b3) oder zumindest des betrachteten Eindrahtdatenbusabschnitts (b1,b2,b3) mit einem dritten Potenzial (V_{IO2}), das vorzugsweise gleich dem zweiten Potenzial (V_{IO1}) ist, und zwar mittels einer dritten zuschaltbaren Spannungsquelle (S_{2H},I₂) eines Busknotens (BS1,BS2,BS3) (im Folgenden "betrachteter Busknoten" genannt), wobei die dritte zuschaltbare Spannungsquelle (S_{2H}, I₂) einen dritten Innenwiderstand (R_{2H}) hat und wobei die dritte zuschaltbare Spannungsquelle auch eine Stromquelle (S_{2H},I₂) sein kann, die einen dritten Innenwiderstand (R_{2H}) und dem Stromwert (I₂=V_{IO2}/R_{2H}) hat. Als vierten Schritt umfasst das Verfahren das zeitweise Halten des Eindrahtdatenbusses (b1,b2,b3) oder zumindest des betrachteten Eindrahtdatenbusabschnitts (b1,b2,b3) durch eine vierte Spannungsquelle, insbesondere einen Pull-Schaltkreis (R_{0H},R_{0L}) zwischen einem vierten Potenzial (V_{IO}), das vorzugsweise gleich dem zweiten und dem dritten Potenzial (V_{IO1},V_{IO2}) ist, und dem ersten Potenzial (V₀), mit einem vierten Innenwiderstand (R₀) auf einem mittleren Potenzial (V_{M}). Dabei liegt der Wert des mittleren Potenzials (V_{M}) zwischen dem Wert des ersten Potenzials (V₀) und dem Wert des zweiten Potenzials (V_{IO1}) und/oder zwischen dem Wert des ersten Potenzials (V₀) und dem Wert des dritten Potenzials (V_{IO2}). Der erste Innenwiderstand (R_{1L}) ist dabei kleiner als die anderen Innenwiderstände (R_{1H},R_{2H},R₀). Der vierte Innenwiderstand (R₀) ist dabei größer als die anderen Innenwiderstände (R_{1H},R_{1L},R_{2H}).

Ein weiteres Verfahren zur Initialisierung eines Eindrahtdatenbusses, wie er hier beschrieben ist, und zwischen einer ersten Teilvorrichtung (dem Bus-Master (BM)) und mindestens zwei weiteren Teilvorrichtungen (den Busknoten (BS1,BS2,BS3)) angeordnet ist. Dabei weist der Datenbus eine Bezugspotenzialleitung (GND) mit einem Bezugspotenzial (V₀) und einen Eindrahtdatenbus (b1,b2,b3) auf, der durch den Bus-Master (BM) und die mindestens zwei Busknoten in mindestens zwei Eindrahtdatenbusabschnitte (b1,b2,b3) unterteilt wird und durch mindestens einen der Busknoten (BS1,BS2,BS3) (den abschließenden Busknoten (BS3)) abgeschlossen wird. Das erfindungsgemäße Verfahren umfasst als ersten Schritt das Bereitstellen einer neuen Busknotenadresse durch den Bus-Master. Dies kann beispielsweise durch einfaches Hochzählen eines internen Wertes im Bus-Master erfolgen. Es folgt als zweiter Schritt das Ablegen dieser Busknotenadresse in einem Busknotenadressregister (BKADR) eines Busknotens (BS1,BS2,BS3) (des betrachteten Busknotens) durch den Bus-Master (BM). Dabei sind der Bus-Master (BM) und der betrachtete Busknoten durch einen oder mehrere Eindrahtdatenbusabschnitte (b1,b2,b3) miteinander datenmäßig verbunden. Vorzugsweise wird das Busknotenadressregister (BKADR) als eigenständiges Datenregister (DR) im Busknoten realisiert. Es kann aber auch als Teil eines Daten- oder Instruktionsregisters (IR) der JTAG-Schnittstelle des betrachteten Busknotens realisiert werden. Die Programmierung wird dann aber ggf. aufwändiger. Wie zuvor ist die JATG-Schnittstelle im Sinne dieser Erfindung dadurch gekennzeichnet, dass sie einen Test-Controller (TAPC) mit einem Zustandsdiagram entsprechend dem IEEE 1149-Standard oder eines seiner Unterstandards, wie im Zusammenhang mit Fig. 1 erläutert, aufweist. Als dritten Schritt folgt nach dieser Busknotenadressvergabe das Verbinden der bereits mit dem betrachteten Busknoten und dem Bus-Mater (BM) verbundenen einen oder mehrere Eindrahtdatenbusabschnitte (b1,b2,b3) mit einem oder mehreren weiteren Eindrahtdatenbusabschnitten (b1,b2,b3), und zwar durch das Schließen des Transfer-Gates (TG) des betrachteten Bus-knotens. Um bei der nächsten Busknotenadressvergabe ein Überschreiben der zuvor vergebenen Busknotenadresse im Busknotenadressregister (BKADR) des betrachteten Busknotens zu verhindern, verhindert eine Logik innerhalb des Busknotens eine solche Ablage einer Busknotenadresse in dem Busknotenadressregister (BKADR) des betrachteten Busknotens (BS1,BS2,BS3) so lange, wie das Transfer-Gate (TG) des betrachteten Busknotens geschlossen ist. Ein Beschreiben des Busknotenadressregisters ist daher erfindungsgemäß nur mit geöffnetem Transfer-Gate des betrachteten Busknotens (b1,b2,b3) möglich.

Eine weitere Ausprägung des zuvor genannten Verfahrens umfasst als weiteren Schritt das Ablegen eines Befehls zum Öffnen eines Transfer-Gates (TG) in dem Instruktionsregister (IR) oder einem Transfer-Gate-Control-Register (TGCR) der JTAG-Schnittstelle des betrachteten Busknotens. Hierdurch kann der Bus-Master (BM) den Bus jederzeit neu initialisieren. Vorzugsweise wird das Transfer-Gate-Control-Register (TGCR) hierfür benutzt und mit einer identischen Instruktion im Instruktionsregister (IR) angesprochen.

Eine weitere Ausprägung des zuvor genannten Verfahrens umfasst als weiteren Schritt das Überprüfen der korrekten Adressierung zumindest eines Busknotens durch zyklisches Schreiben und Lesen, insbesondere eines Bypass-Registers.

Eine weitere Ausprägung des zuvor genannten Verfahrens umfasst als weiteren Schritt das Ermitteln der Anzahl korrekt adressierbarer Busknoten durch den Bus-Master (BM). Es folgt dann das Vergleichen der Anzahl korrekt adressierbarer Busknoten mit einer Sollanzahl und das durch den Bus-Master oder ein angeschlossenes System erfolgende oder initiierte Auslösen mindestens eines Signals oder einer Maßnahme in Abhängigkeit von der Anzahl.

Eine weitere Ausprägung des zuvor genannten Verfahrens umfasst als weiteren Schritt das gleichzeitige Übermitteln einer Sendeadresse an alle erreichbaren Busknoten durch Beschreiben von Senderegistern (SR) aller Busknoten durch den Bus-Master (BM) mit dieser Sendeadresse, wobei das Senderegister (SR) des jeweiligen Busknotens ein Datenregister oder ein Teil eines Datenregisters oder ein Teil des Instruktionsregisters (IR) der JTAG-Schnittstelle dieses Busknotens ist, und wobei das Busknotenadressregister (BKADR) kein Teil des betreffenden Registers ist. Als zweiter Schritt folgt der Vergleich der Sendeadresse im Senderegister (SR) mit der Busknotenadresse im Busknotenadressregister (BKADR) durch jeden Busknoten mittels eines vorbestimmten Vergleichsalgorithmus. Vorzugsweise wird auf Gleichheit geprüft. Andere Algorithmen sind aber denkbar. Als dritter Schritt folgt entweder die Aktivierung der Sendefähigkeit für den jeweiligen Busknoten zu den dafür vorgesehenen Zeitpunkten, wenn der Vergleichsalgorithmus des zuvor durch diesen jeweiligen Busknoten ausgeführten Vergleiches eine ausreichende Übereinstimmung mit der für die Sendeerlaubnis erwarteten Kombination aus der in seinem Busknotenadressregister (BKADR) abgelegten Busknotenadresse und der in seinem Senderegister (SR) abgelegten Sendeadresse ergibt, oder es erfolgt als alternativer dritter Schritt die Deaktivierung der Sendefähigkeit für den jeweiligen Busknoten, wenn der Vergleichsalgorithmus des zuvor durch diesen jeweiligen Busknoten ausgeführten Vergleiches keine ausreichende Übereinstimmung mit der für die Sendeerlaubnis erwarteten Kombination aus der in seinem Busknotenadressregister (BKADR) abgelegten Busknotenadresse und der in seinem Senderegister (SR) abgelegten Sendeadresse ergibt.

Um sicherzustellen, dass nur der Busknoten die für ihn bestimmten Daten erhält, kann es sinnvoll sein, wenn nicht nur das Senden des Busknotens gesteuert wird, sondern auch das Empfangen des Busknotens. Hierzu werden bestimmte Register ganz oder teilweise für ein Beschreiben durch den Bus-Master gesperrt, bis die Sendeadresse im Senderegister (SR) mit der Busknotenadresse im Busknotenadressregister (BKADR) übereinstimmt. Diese Sperrung kann die Sperrung des Schieberegisterteils eines oder mehrerer Datenregister (DR) oder die Datenübernahme vom Schieberegisterteil eines oder mehrerer Datenregister (DR) oder des Instruktionsregisters in das Schattenregister betreffen. Dabei können ggf. auch nur einzelne oder mehrere Bits durch eine Sperrung der Datenübernahme betroffen sein. Es ist notwendig, stets die Übertragung bestimmter Befehle (zumindest das Schreiben des Senderegisters (SR)) zuzulassen. Daher beginnt die Übertragung eines Kommandos oder von Daten an einen zuvor nicht angesprochenen Busknoten wie zuvor mit dem gleichzeitigen Übermitteln einer Sendeadresse an alle erreichbaren Busknoten durch Beschreiben der Senderegister (SR) aller Busknoten durch den Bus-Master (BM) mit dieser Sendeadresse. Dabei ist das jeweilige Senderegister (SR) des betrachteten Busknotens ein Datenregister oder ein Teil eines Datenregisters oder ein Teil des Instruktionsregisters (IR) der JTAG-Schnittstelle dieses Busknotens. Wie zuvor darf das Busknotenadressregister (BKADR) kein Teil des betreffenden Registers sein. Es folgt wieder der Vergleich der Sendeadresse im Senderegister (SR) mit der Busknotenadresse im Busknotenadressregister (BKADR) durch jeden Busknoten mittels des besagten Vergleichsalgorithmus. Schließlich folgt die Aktivierung der Empfangsfähigkeit des jeweiligen Busknotens für den Inhalt eines vorbestimmten Datenregisters des jeweiligen Busknotens, wenn der Vergleichsalgorithmus des zuvor durch diesen jeweiligen Busknoten ausgeführten Vergleiches eine ausreichende Übereinstimmung mit der für die Sendeerlaubnis erwarteten Kombination aus der in seinem Busknotenadressregister (BKADR) abgelegten Busknotenadresse und der in seinem Senderegister (SR) abgelegten Sendeadresse ergibt. Im anderen Fall folgt die Deaktivierung der Empfangsfähigkeit des jeweiligen Busknotens für den Inhalt eines vorbestimmten Datenregisters des jeweiligen Busknotens auf die Sendefähigkeit für den jeweiligen Busknoten, wenn der Vergleichsalgorithmus des zuvor durch diesen jeweiligen Busknoten ausgeführten Vergleiches keine ausreichende Übereinstimmung mit der für die Sendeerlaubnis erwarteten Kombination aus der in seinem Busknotenadressregister (BKADR) abgelegten Busknotenadresse und der in seinem Senderegister (SR) abgelegten Sendeadresse ergibt.

Sofern das Beschreiben von Teilen des Instruktionsregisters (IR) oder von Teilen des Datenregisters gesperrt bzw. entsperrt werden soll, beginnt das entsprechende Verfahren mit dem gleichzeitigen Übermitteln einer Sendeadresse an alle erreichbaren Busknoten durch Beschreiben der Senderegister (SR) aller Busknoten seitens des Bus-Masters (BM) mit dieser Sendeadresse, wobei das Senderegister (SR) eines jeweiligen Busknotens ein Datenregister oder ein Teil eines Datenregisters oder ein Teil des Instruktionsregisters (IR) der JTAG-Schnittstelle dieses Busknotens ist, und wobei das Busknotenadressregister (BKADR) kein Teil des betreffenden Registers ist. Es folgt wieder der Vergleich der Sendeadresse im Senderegister (SR) mit der Busknotenadresse im Busknotenadressregister (BKADR) durch jeden Busknoten mittels des besagten Vergleichsalgorithmus. Je nach Ergebnis des Vergleiches folgt die Aktivierung der Empfangsfähigkeit des jeweiligen Busknotens für den Inhalt vorbestimmter Inhalte des Instruktionsregisters (IR) des jeweiligen Busknotens zur Zulassung vorbestimmter Befehle für einen Instruktionsdecoder (IRDC) der JTAG-Schnittstelle des jeweiligen Busknotens, wenn der Vergleichsalgorithmus des zuvor durch diesen jeweiligen Busknoten ausgeführten Vergleichs eine ausreichende Übereinstimmung mit der für die Sendeerlaubnis erwarteten Kombination aus der in seinem Busknotenadressregister (BKADR) abgelegten Busknotenadresse und der in seinem Senderegister (SR) abgelegten Sendeadresse ergibt. Im anderen Fall erfolgt die Deaktivierung der Empfangsfähigkeit des jeweiligen Busknotens für den Inhalt vorbestimmter Inhalte des Instruktionsregisters (IR) des jeweiligen Busknotens zur Unterdrückung vorbestimmter Befehle für einen Instruktionsdecoder (IRDC) der JTAG-Schnittstelle des jeweiligen Busknotens, wenn der Vergleichsalgorithmus des zuvor durch diesen jeweiligen Busknoten ausgeführten Vergleiches keine ausreichende Übereinstimmung mit der für die Sendeerlaubnis erwarteten Kombination aus der in seinem Busknotenadressregister (BKADR) abgelegten Busknotenadresse und der in seinem Senderegister (SR) abgelegten Sendeadresse ergibt.

### Beschreibung der Figuren

Die Erfindung wird nachfolgend anhand diverser Ausführungsbeispiele und unter Bezugnahme auf die Zeichnung näher erläutert. Im Einzelnen zeigen dabei:
- Fig. 1: das Zustandsdiagramm eines Test-Controllers nach dem Stand der Technik gemäß dem IEEE 1149-Standard,
- Fig. 2: die grundlegenden Signalformen des Datenprotokolls auf dem Eindrahtdatenbus (b1,b2,b3) oder einem angeschlossenen Eindrahtdatenbusabschnitt (b1,b2,b3) des Eindrahtdatenbusses (b1,b2,b3),
- Fig. 3: einen Realisierungsvorschlag in schematischer Form,
- Fig. 4: beispielhafte Pegelfolgen für jeweils ein Zeitschlitzpaket aus drei aufeinanderfolgenden Zeitschlitzen,
- Fig. 5: beispielhaft die Extraktion der Daten im betrachteten Busknoten für drei aufeinanderfolgende Zeitschlitze,
- Fig. 6: schematisch ein beispielhaftes Eindrahtdatenbussystem,
- Fig. 7: ein Detail aus dem beispielhaften Eindrahtdatenbussystem: Die Verbindung zweier aufeinanderfolgender Busknoten,
- Fig. 8: schematisch vereinfacht eine beispielhafte Implementierung einer Bus-Master-Eindrahtdatenbusschnittstelle,
- Fig. 9: schematisch vereinfacht eine beispielhafte Implementierung einer Busknoten-Eindrahtdatenbusschnittstelle,
- Fig. 10: vereinfacht eine JTAG-Schnittstelle mit Beleuchtungsregister (ILR),
- Fig.11: vereinfacht eine JTAG-Schnittstelle mit Beleuchtungsregister (ILR) und separatem zuschaltbaren seriellen Dateneingang für das Beleuchtungsregister,
- Fig. 12: schematisch ein beispielhaftes Eindrahtdatenbussystem mit separatem seriellen Datenbus für Beleuchtungsdaten und
- Fig. 13: vereinfacht eine JTAG-Schnittstelle mit Beleuchtungsregister (ILR) und Transfer-Gate-Control-Register (TGCR),

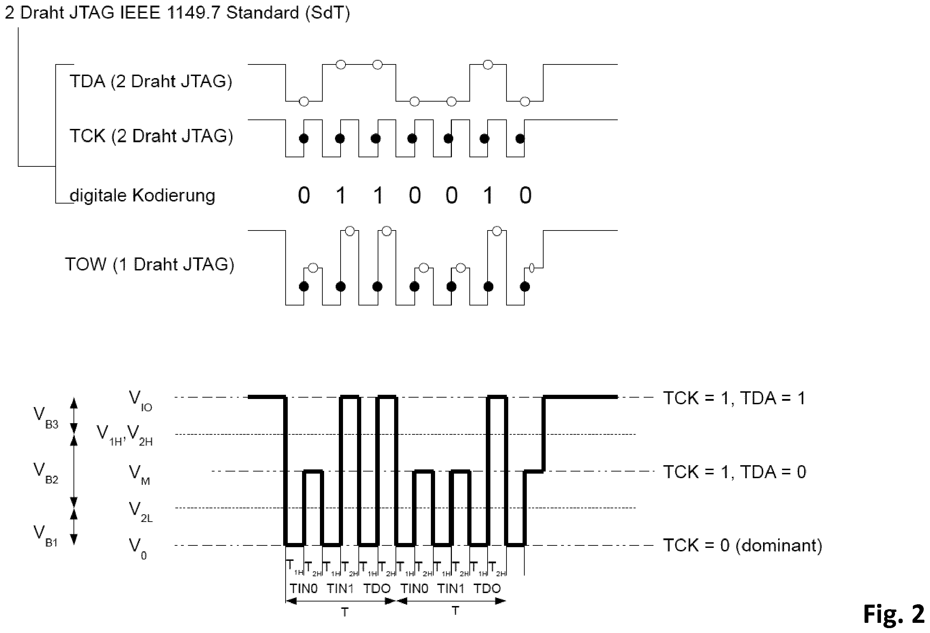

Fig. 2 zeigt die grundlegenden Signalformen eines Datenprotokolls auf dem Eindrahtdatenbus (b1,b2,b3) oder einem angeschlossenen Eindrahtdatenbusabschnitt (b1,b2,b3) des Eindrahtdatenbusses (b1,b2,b3). Im oberen Teil der Fig. 2 sind die Signalformen für einen Zweidraht-Test-Bus gemäß IEEE 1149-Standard schematisch skizziert, wie sie aus dem Stand der Technik bekannt sind. Das oberste Signal (TDA) zeigt das Datensignal. Das zweite Signal (TCK) zeigt den zugehörigen Takt. Beide Signale sind als Stand der Technik markiert und gehören zum Zweidraht-JTAG-Standard. Darunter ist beispielhaft die digitale Kodierung vermerkt. Hierbei wird noch nicht dargestellt, ob der betrachtete Busknoten oder der Master sendet. Hier ist nur die Signalform skizziert.

Darunter ist eine vorteilhafte Signalform auf dem Eindrahtdatenbus (b1,b2,b3) oder einem angeschlossenen Eindrahtdatenbusabschnitt (b1,b2,b3) des Eindrahtdatenbusses (b1,b2,b3) skizziert, die den Takt und die Daten kombiniert.

Ganz unten sind die verschiedenen Spannungspegel skizziert. Das Signal weist beim Senden drei Spannungspegel auf:
1. Einen ersten Spannungspegel, der typischerweise gleich einer Versorgungsspannung (V_{IO}) ist. Dabei kann diese gleich der Versorgungsspannung (V_{IO2}) auf Busknoten-Seite oder gleich der Versorgungsspannung (V_{IO1}) auf Seiten des Bus-Masters sein. Im Folgenden meint V_{IO} eine dieser beiden Versorgungsspannungen oder eine Kombination der beiden oder eine andere, vergleichbare Versorgungsspannung mit gleicher Wirkung. Vorzugsweise sollten Bus-Master (BM) und Busknoten (BS1,BS2,BS3) die gleiche Versorgungsspannung als Referenz benutzen.
2. Einen zweiten, mittleren Spannungspegel (V_{M}).
3. Einen dritten Spannungspegel, der typischerweise gleich einem Bezugspotenzial (V₀) ist.

Für die Extraktion des Systemtaktes ist eine zweite Schwellspannung (V_{2L}) definiert, die zwischen dem Bezugspotenzial (V₀) und dem mittleren Potenzial (V_{M}) liegt.

Für die Extraktion der Daten sind seitens des Bus-Maters (BM) eine dritte Schwellspannung (V_{1H}) und seitens der der Busknoten (BS1,BS2,BS3) eine erste Schwellspannung (V_{2H}) definiert, die jeweils zwischen der Versorgungsspannung (V_{IO}) und dem mittleren Potenzial (V_{M}) liegen und in etwa gleich sein sollten.

Durch die zweite Schwellspannung (V_{2L}) der Busknoten (BS1,BS2,BS3) und durch das Bezugspotenzial (V₀) wird ein erster Spannungsbereich (V_{B1}) definiert und begrenzt.

Durch die erste Schwellspannung (V_{2H}) der Busknoten (BS1,BS2,BS3) bzw. die dritte Schwellspannung (V_{1H}) des Bus-Masters (BM) einerseits und die zweite Schwellspannung (V_{2L}) der Busknoten (BS1,BS2,BS3) andererseits wird ein zweiter Spannungsbereich (V_{B2}) definiert und begrenzt.

Durch die erste Schwellspannung (V_{2H}) der Busknoten (BS1,BS2,BS3) bzw. die dritte Schwellspannung (V_{1H}) des Bus-Masters (BM) einerseits und die Versorgungsspannung andererseits wird ein dritter Spannungsbereich (V_{B3}) definiert und begrenzt.

Das Signal auf dem Eindrahtdatenbus (b1,b2,b3) oder einem angeschlossenen Eindrahtdatenbusabschnitt (b1,b2,b3) des Eindrahtdatenbusses (b1,b2,b3)ist zeitlich in Zeitschlitzpakete mit mindestens drei Zeitschlitzen (TIN0,TIN1,TDO) unterteilt. Die Zeitschlitze eines Zeitschlitzpaketes folgen typischerweise aufeinander, wobei jeder Zeitschlitz gleich der Dauer einer Systemtaktperiode (T) ist. Die Reihenfolge der Zeitschlitze innerhalb eines Zeitschlitzpaketes kann für ein System beliebig, aber vorzugsweise für alle Zeitschlitzpakete gleich gewählt werden. Jede Systemtaktperiode (T) gliedert sich in mindestens zwei Halbtaktperioden (T_{1H},T_{2H}), deren Längen vorzugsweise aber nicht notwendigerweise gleich ist.

In einer Halbtaktperiode der mindestens zwei Halbtaktperioden (T_{1H}, T_{2H}) wird der Systemtakt übertragen.

Hierbei befindet sich der Pegel auf dem Eindrahtdatenbus (b1,b2,b3) oder dem angeschlossenen Eindrahtdatenbusabschnitt (b1,b2,b3) des Eindrahtdatenbusses (b1,b2,b3) in einer Halbtaktperiode der mindestens zwei Halbtaktperioden (T_{1H},T_{2H}) im ersten Spannungsbereich (V_{B1}). Hierdurch wird ein erster logischer Wert des Systemtaktes übertragen. In dem Beispiel reicht es aus, dass sich der Pegel auf dem Eindrahtdatenbus (b1,b2,b3) oder dem angeschlossenen Eindrahtdatenbusabschnitt (b1,b2,b3) des Eindrahtdatenbusses (b1,b2,b3) unterhalb der zweiten Schwelle (V_{2L}) befindet. Eine Begrenzung nach unten durch das Bezugspotenzial (V₀) ist für die Entscheidung, ob sich der Pegel auf dem Eindrahtdatenbus (b1,b2,b3) oder dem angeschlossenen Eindrahtdatenbusabschnitt (b1,b2,b3) des Eindrahtdatenbusses (b1,b2,b3) im ersten Spannungsbereich (V_{B1}) befindet, nicht relevant und wird daher in der Praxis nicht verwendet. Daher kann der erste Spannungsbereich (V_{B1}) in vielen Anwendungsfällen auch als nach unten offen angesehen werden.

In der anderen Halbtaktperiode der mindestens zwei Halbtaktperioden (T_{1H}, T_{2H}) befindet sich der Pegel auf dem Eindrahtdatenbus (b1,b2,b3) oder dem angeschlossenen Eindrahtdatenbusabschnitt (b1,b2,b3) des Eindrahtdatenbusses (b1,b2,b3) im zweiten Spannungsbereich (V_{B2}) oder dritten Spannungsbereich (V_{B3}). Hierdurch wird ein zweiter logischer Wert des Systemtaktes übertragen, der vom ersten logischen Wert des Systemtaktes verschieden ist. In dem Beispiel reicht es aus, dass sich der Pegel auf dem Eindrahtdatenbus (b1,b2,b3) oder dem angeschlossenen Eindrahtdatenbusabschnitt (b1,b2,b3) des Eindrahtdatenbusses (b1,b2,b3) sich oberhalb der zweiten Schwelle (V_{2L}) befindet. Eine Begrenzung nach oben durch die Versorgungsspannung (V_{IO}) ist für die Entscheidung, ob sich der Pegel auf dem Eindrahtdatenbus (b1,b2,b3) oder dem angeschlossenen Eindrahtdatenbusabschnitt (b1,b2,b3) des Eindrahtdatenbusses (b1,b2,b3) im zweiten Spannungsbereich (V_{B2}) oder dritten Spannungsbereich (V_{B3}) befindet, nicht relevant und wird daher in der Praxis nicht verwendet. Daher kann der dritte Spannungsbereich (V_{B3}) in vielen Anwendungsfällen auch als nach oben offen angesehen werden.

Da es für die Extraktion des Systemtaktes innerhalb dieser anderen Halbtaktperiode der mindestens zwei Halbtaktperioden (T_{1H},T_{2H}) nicht relevant ist, ob der Pegel auf dem Eindrahtdatenbus (b1,b2,b3) oder dem angeschlossenen Eindrahtdatenbusabschnitt (b1,b2,b3) des Eindrahtdatenbusses (b1,b2,b3) sich im dritten Spannungsbereich (V_{B3}) oder zweiten Spannungsbereich (V_{B2}) befindet, können nun durch eine Unterscheidung zwischen dem dritten Spannungsbereich (V_{B3}) und dem zweiten Spannungsbereich (V_{B2}) innerhalb dieser anderen Halbtaktperiode der mindestens zwei Halbtaktperioden (T_{1H},T_{2H}) Daten übertragen werden.

Wenn ein erster logischer Datenwert übertragen wird, so befindet sich in dieser anderen Halbtaktperiode der mindestens zwei Halbtaktperioden (T_{1H},T_{2H}) der Pegel auf dem Eindrahtdatenbus (b1,b2,b3) oder dem angeschlossenen Eindrahtdatenbusabschnitt (b1,b2,b3) des Eindrahtdatenbusses (b1,b2,b3) im zweiten Spannungsbereich (V_{B2}), während er sich im dritten Spannungsbereich (V_{B3}) befindet, wenn ein zweiter logischer Datenwert übertragen wird.

Rechts neben dem unteren Signal sind in Fig. 2 zur besseren Verdeutlichung beispielhafte logische Zustände für die drei Pegel eingezeichnet.

Der obere Pegel entspricht in dem Beispiel einem beispielhaften logischen Wert des Systemtakts (TCK) von 1 und einem beispielhaften logischen Wert des Datensignals (TDA) von 1.

Der mittlere Pegel entspricht in dem Beispiel einem beispielhaften logischen Wert des Systemtakts (TCK) von 1 und einem beispielhaften logischen Wert des Datensignals (TDA) von 0.

Der untere Pegel entspricht in dem Beispiel einem beispielhaften logischen Wert des Systemtakts (TCK) von 0 und einem beispielhaften logischen Wert des Datensignals (TDA) von 0.

Die Kombination eines beispielhaften logischen Werts des Systemtakts (TCK) von 1 und eines beispielhaften logischen Wert des Datensignals (TDA) von 0 ist nicht zulässig und deutet ggf. auf einen Systemfehler hin.

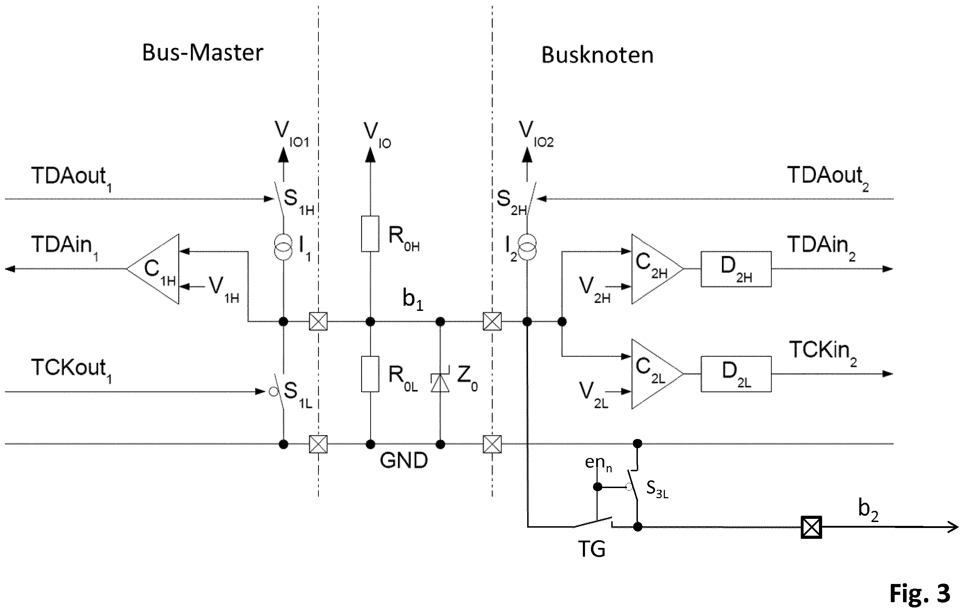

In Fig. 3 sind die wichtigsten Teile einer Schnittstelle zur Realisierung des zuvor beschriebenen Protokolls auf dem Eindrahtdatenbus (b1,b2,b3) oder auf dem hier beispielhaft angeschlossenen ersten Eindrahtdatenbusabschnitt (b1) des Eindrahtdatenbusses (b1,b2,b3) zwischen dem Bus-Master und dem betrachteten Busknoten dargestellt. Als Bezugspotenzial für die Signale auf dem Eindrahtdatenbus (b1,b2,b3) und dem angeschlossenen ersten Eindrahtdatenbusabschnitt (b1) des Eindrahtdatenbusses (b1,b2,b3) dient hier beispielhaft die Masse mit der Bezugspotenzialleitung (GND), die auf dem Bezugspotenzial (V₀) liegt. Durch den Spannungsteiler aus einem unteren Widerstand (R_{0L}), der zwischen dem Eindrahtdatenbus (b1,b2,b3), d.h. zwischen dem angeschlossenen ersten Eindrahtdatenbusabschnitt (b1) des Eindrahtdatenbusses (b1,b2,b3) und dem Bezugspotenzial (GND) geschaltet ist, und einem oberen Widerstand (R_{0H}), der zwischen dem Eindrahtdatenbus (b1,b2,b3), d.h. zwischen den angeschlossenen ersten Eindrahtdatenbusabschnitt (b1) des Eindrahtdatenbusses (b1,b2,b3) und das vom Bezugspotenzial (V₀) verschiedene Versorgungspotenzial (V_{IO}) geschaltet ist, wird der Eindrahtdatenbus (b1,b2,b3) in Form des angeschlossenen ersten Eindrahtdatenbusabschnitts (b1) zunächst auf einem mittleren Potenzial (V_{M}) zwischen diesen beiden Potenzialen (V₀,V_{IO}) gehalten. Auf der Masterseite wird nun immer in einer Halbtaktperiode der mindestens zwei Halbtaktperioden (T_{1H},T_{2H}) einer Systemtaktperiode (T) des Systemtaktes (TCKout₁) der dominierende Schalter (S_{1L}) geschlossen, der zwischen dem Eindrahtdatenbus (b1,b2,b3) in Form des angeschlossenen ersten Eindrahtdatenbusabschnitts (b1) und der Bezugspotenzialleitung (GND) geschaltet ist. Da der Innenwiderstand des dominierenden Schalters (S_{1L}) vorzugsweise kleiner als der Innenwiderstand des Spannungsteiles aus dem oberen Widerstand (R_{0H}) und dem unteren Widerstand (R_{0L}) ist, wird dadurch in der betreffenden Halbtaktperiode der mindestens zwei Halbtaktperioden (T_{1H},T_{2H}) einer Systemtaktperiode (T) durch das Schließen des dominierenden Schalters (S_{1L}) der Spannungspegel auf dem Eindrahtdatenbus (b1,b2,b3) von dem besagten mittleren Potenzial (V_{M}) in einem zweiten Spannungsbereich (V_{B2}) auf das Potenzial des Bezugspotenzials (V₀), das sich im ersten Spannungsbereich (V_{B1}) befindet, gezogen. Der dominierende Schalter (S_{1L}) wird dabei durch den Systemtakt auf Masterseite (TCKout₁) angesteuert. Ist dieser dominierende Schalter (S_{1L}) nicht geschlossen, so können Daten bidirektional in der anderen Halbtaktperiode der mindestens zwei Halbtaktperioden (T_{1H},T_{2H}) einer Systemtaktperiode (T) übertragen werden. Auf Seiten des Bus-Masters speist dazu eine geschaltete Stromquelle (S_{1H},I₁) Strom in den Eindrahtdatenbus (b1,b2,b3) ein, wenn die Sendeleitung (TDAout₁) aus dem Inneren des Bus-Masters (BM) aktiv ist. Hierzu schließt die Sendeleitung (TDAout₁) aus dem Inneren des Bus-Masters (BM) den Schalter (S_{1H}) der steuerbaren Stromquelle (S_{1H},I₁). Hierdurch liefert die steuerbare Stromquelle (S_{1H}, I₁) Strom in den Eindrahtdatenbus (b1,b2,b3). Vorzugsweise ist dieser Strom größer als der Strom, den der Pull-Schaltkreis bestehend aus dem oberen Widerstand (R_{0H}) und dem unteren Widerstand (R_{0L}) abführen kann. Somit wandert das Potenzial des Eindrahtdatenbusses (b1,b2,b3) oder des angeschlossenen ersten Eindrahtdatenbusabschnitts (b1) des Eindrahtdatenbusses (b1,b2,b3) in diesem Fall von dem in dem zweiten Spannungsbereich (V_{B2}) liegenden mittleren Potenzial (V_{M}) zu einem in dem dritten Spannungsbereich (V_{B3}) liegenden Potenzial nahe der Versorgungsspannung (V_{IO1}) für die schaltbare Stromquelle (S_{1H},I₁) des Bus-Masters (BM). Wird jedoch der dominierende Schalter (S_{1L}) geschlossen, so hebt dieser den Einfluss der schaltbaren Stromquelle (S_{1H},I₁) des Bus-Masters (BM) und des Pull-Schaltkreises bestehend aus dem oberen Widerstand (R_{0H}) und dem unteren Widerstand (R_{0L}) (wieder) auf. Beide sind bei geeigneter Auslegung des dominierenden Schalters (S_{1L}) nicht in der Lage, das Potenzial auf dem Eindrahtdatenbus (b1,b2,b3) oder zumindest auf dem beispielhaft angeschlossenen ersten Eindrahtdatenbusabschnitt (b1) des Eindrahtdatenbusses (b1,b2,b3) gegen den insoweit "dominierenden" Schalter (S_{1L}) zu bestimmen.

In gleicher Weise arbeitet die zweite schaltbare Stromquelle auf der Busknoten-Seite. Auf der Busknoten-Seite speist dazu eine geschaltete Stromquelle (S_{2H},I₂) Strom in den Eindrahtdatenbus (b1,b2,b3) bzw. den angeschlossenen Eindrahtdatenbusabschnitt (b1,b2,b3) des Eindrahtdatenbusses (b1,b2,b3) ein, wenn die Sendeleitung (TDAout₂) aus dem Inneren des Busknotens aktiv ist. Hierzu schließt die Sendeleitung (TDAout₂) aus dem Inneren des Busknotens den Schalter (S_{2H}) der steuerbaren Stromquelle (S_{2H},I₂). Hierdurch liefert die Stromquelle (I₂) der steuerbaren Stromquelle (S_{2H},I₂) Strom in den Eindrahtdatenbus (b1,b2,b3) bzw. den angeschlossenen ersten Eindrahtdatenbusabschnitt (b1) des Eindrahtdatenbusses (b1,b2,b3). Vorzugsweise ist dieser Strom wieder größer als der Strom, den der Pull-Schaltkreis bestehend aus dem oberen Widerstand (R_{0H}) und dem unteren Widerstand (R_{0L}) abführen kann. Somit wandert das Potenzial des Eindrahtdatenbusses (b1,b2,b3) bzw. des angeschlossenen Eindrahtdatenbusabschnitts (b1) in diesem Fall von dem in dem zweiten Spannungsbereich (V_{B2}) liegenden mittleren Potenzial (V_{M}) zu einem in dem dritten Spannungsbereich (V_{B3}) liegenden Potenzial nahe der Versorgungsspannung (V_{IO2}) für die schaltbare Stromquelle (S_{2H},I₂) des Bus-Masters (BM). Wird jedoch der dominierende Schalter (S_{1L}) geschlossen, so hebt dieser wieder den Einfluss der schaltbaren Stromquelle (S_{2H},I₂) des Busknotens und des Pull-Schaltkreises bestehend aus dem oberen Widerstand (R_{0H}) und dem unteren Widerstand (R_{0L}) (wieder) auf. Beide sind bei geeigneter Auslegung des dominierenden Schalters (S_{1L}) (siehe oben) nicht in der Lage, das Potenzial auf dem Eindrahtdatenbus (b1,b2,b3) oder auf dem angeschlossenen ersten Eindrahtdatenbusabschnitt (b1) des Eindrahtdatenbusses (b1,b2,b3) gegen den dominierenden Schalter (S_{1L}) zu bestimmen. Auch wenn die schaltbare Stromquelle (S_{1H}, I₁) des Bus-Masters (BM) ebenfalls hinzugeschaltet wird, wird bei geeigneter Auslegung des dominierenden Schalters (S_{1L}) dieser das Potenzial auf dem Eindrahtdatenbus (b1,b2,b3) oder auf dem angeschlossenen ersten Eindrahtdatenbusabschnitt (b1) des Eindrahtdatenbusses (b1,b2,b3) weiterhin bestimmen.

Auf der Busknoten-Seite vergleicht ein erster Komparator (C_{2H}) das Potenzial auf dem Eindrahtdatenbus (b1,b2,b3) oder dem angeschlossenen ersten Eindrahtdatenbusabschnitt (b1) des Eindrahtdatenbusses (b1,b2,b3) mit einem ersten Schwellwert (V_{2H}). Gleichzeitig vergleicht ein zweiter Komparator (C_{2L}) das Potenzial auf dem Eindrahtdatenbus (b1,b2,b3) oder dem angeschlossenen ersten Eindrahtdatenbusabschnitt (b1) des Eindrahtdatenbusses (b1,b2,b3) mit einem zweiten Schwellwert (V_{2L}). Der zweite Schwellwert (V_{2L}) unterscheidet sich vom ersten Schwellwert (V_{2H}) und bestimmt die Grenze zwischen dem ersten Spannungsbereich (V_{B1}) und dem zweiten Spannungsbereich (V_{B2}). Der erste Schwellwert (V_{2H}) bestimmt die Grenze zwischen dem zweiten Spannungsbereich (V_{B2}) und dem dritten Spannungsbereich (V_{B3}). Der zweite Komparator (C_{2L}) gewinnt den Systemtakt aus dem Signal auf dem Eindrahtdatenbus (b1,b2,b3) oder dem angeschlossenen ersten Eindrahtdatenbusabschnitt (b1) des Eindrahtdatenbusses (b1,b2,b3) zurück. Dieses Signal wird ins Innere des Busknotens als durch den Busknoten empfangenes Taktsignal (TCKin₂) weitergegeben. Der erste Komparator (C_{2H}) gewinnt die Dateninformation aus dem Signal auf dem Eindrahtdatenbus (b1,b2,b3) oder dem angeschlossenen ersten Eindrahtdatenbusabschnitt (b1) des Eindrahtdatenbusses (b1,b2,b3) als durch den Busknoten empfangene Daten (TDAin₂) zurück. Dabei enthalten die durch den Busknoten empfangenen Daten auch noch Anteile des Systemtaktes. Dies kann durch einfaches Abtasten beispielsweise in einem FlipFlop mit der Flanke eines leicht verzögerten Systemtakts oder alternativ durch Verzögerung der empfangenen Daten und Abtastung mit einem nicht verzögerten Systemtakt leicht behoben werden. Ggf. müssen die Signale vor der Verwendung noch aufbereitet werden (D_{2H}, D2L).

In einer zweckmäßigen Ausprägung der Erfindung könnte das Datenausgangssignal (TDAin2) durch den ersten Komparator (C_{2H}) auf einen ersten logischen Pegel, z.B. auf "1" geschaltet werden, wenn das Potenzial auf dem Eindrahtdatenbus (b1,b2,b3) oder dem angeschlossenen ersten Eindrahtdatenbusabschnitt (b1) des Eindrahtdatenbusses (b1,b2,b3) kleiner als der erste Schwellwert (V_{2H}) ist und auf z.B. logisch "0", wenn das Potenzial niedriger als dieser Schwellwert ist. In einer vorteilhaften Ausprägung der Erfindung könnte das Systemtaktsignal (TCKin₂) durch den zweiten Komparator (C_{2L}) auf "1" geschaltet werden, wenn das Potenzial auf dem Eindrahtdatenbus (b1,b2,b3) oder dem angeschlossenen ersten Eindrahtdatenbusabschnitt (b1) des Eindrahtdatenbusses (b1,b2,b3) kleiner als der zweite Schwellwert (V_{2L}) ist und umgekehrt, wenn das Potenzial niedriger als dieser Schwellwert ist.

In ähnlicher Weise tastet der Bus-Master (BM) mittels eines dritten Komparators (C_{1H}) den Zustand auf dem Eindrahtdatenbus (b1,b2,b3) oder dem angeschlossenen ersten Eindrahtdatenbusabschnitt (b1) des Eindrahtdatenbusses (b1,b2,b3) ab. Hierzu vergleicht der dritte Komparator (C_{1H}) das Potenzial auf dem Eindrahtdatenbus (b1,b2,b3) oder dem angeschlossenen ersten Eindrahtdatenbusabschnitt (b1) des Eindrahtdatenbusses (b1,b2,b3) mit einem dritten Schwellwert (V_{1H}) und gewinnt dadurch die auf der Datenleitung befindlichen Daten zurück, die jedoch auch hier noch Anteile des Systemtaktes aufweisen. Auch hier hilft eine geeignete Abtastung. Auf diese Weise werden die durch den Bus-Master (BM) empfangenen Daten (TDAin₁) gewonnen. In einer zweckmäßigen Ausprägung der Erfindung könnte das Datenausgangssignal (TDAin₁) auf 1 durch den dritten Komparator (C_{1H}) geschaltet werden, wenn das Potenzial auf dem Eindrahtdatenbus (b1,b2,b3) oder dem angeschlossenen ersten Eindrahtdatenbusabschnitt (b1) des Eindrahtdatenbusses (b1,b2,b3) kleiner als der dritte Schwellwert (V_{1H}) ist und umgekehrt, wenn das Potenzial niedriger als dieser Schwellwert ist. Der dritte Schwellwert (V_{1H}) ist vorzugsweise bis auf einen kleinen Toleranzbereich von vorzugsweise deutlich kleiner 25% dieses Wertes gleich dem ersten Schwellwert (V_{2H}).

In der weiteren Verarbeitung können nun Schaltungen aus dem Stand der Technik für einen Datenbus mit separater Datenleitung und Systemtaktleitung verwendet werden, so dass hier auf die Beschreibung verzichtet werden kann. Beispielhaft sei auf die WO-A-2006 102 284 verwiesen.

Es ergibt sich nun folgende Tabelle der Spannungspegel und logischen Werte als eine mögliche Implementation der Erfindung. Andere Pegel und korrespondierende logische Werte sind ebenso möglich, wie für den Fachmann klar ist. Man beachte, dass hier in diesem Beispiel TCKout₁=0 den dominierenden Schalter (S_{1L}) schließt. Dies kann selbstverständlich auch invertiert implementiert werden.

| **Senden** | | | **betrachtete Eindrahtdatenleitung/-leitungsabschnitt** | **Empfangen** | | |
|---|---|---|---|---|---|---|
| **TCKout₁** | **TDAout₁** | **TDAout₂** | **b1, b2, b3, bₙ** | **TCKin₂** | **TDAin₁** | **TDAin₂** |
| 0 | 0 | 0 | V₀ | 0 | 0 | 0 |
| 0 | 0 | 1 | V₀ | 0 | 0 | 0 |
| 0 | 1 | 0 | V₀ | 0 | 0 | 0 |
| 0 | 1 | 1 | V₀ | 0 | 0 | 0 |
| 1 | 0 | 0 | V_{M} | 1 | 0 | 0 |
| 1 | 0 | 1 | V_{IO2} | 1 | 1 | 1 |
| 1 | 1 | 0 | V_{IO1} | 1 | 1 | 1 |
| 1 | 1 | 1 | V_{IO1/2} | 1 | 1 | 1 |

Vorzugsweise stimmen der erste Schwellwert (V_{2H}) und der dritte Schwellwert (V_{1H}) überein, wodurch Bus-Master und Busknoten die gleiche Datensequenz erkennen. Durch entsprechend gesteuerte, zeitliche Abtastung können diese Daten dann geeignet den Zeitschlitzen (TIN0,TIN1,TDO) zugeordnet werden.

Im Gegensatz zu den Schriften DE-B-10 2015 004 434, DE-B-10 2015 004 433, DE-B-10 2015 004 435 und DE-B-10 2015 004 436 weist der Busknoten typischerweise ein Transfer-Gate (TG) auf, das die Funktion eines Schalters hat und den ersten Eindrahtdatenbusabschnitt (b1) mit einem nachfolgenden zweiten Eindrahtdatenbusabschnitt (b2) verbinden kann. Ist das Transfer-Gate (TG) geöffnet, so verbindet vorzugsweise ein zweiter Schalter (S_{3L}) den nachfolgenden zweiten Eindrahtdatenbusabschnitt (b2) (dauerhaft) mit dem Bezugspotenzial (GND) oder einem anderen geeigneten Potenzial. Hierdurch liegt der nachfolgende Eindrahtdatenbus (b2,b3) auf einem definierten Potenzial, ohne dass ein Systemtakt und damit Daten übertragen werden.

Wenn das Transfer-Gate (TG) geschlossen ist, ist der zweite Schalter (S_{3L}) geöffnet, so dass das Potenzial auf dem zweiten Eindrahtbusabschnitt (b2) gleich demjenigen auf dem ersten Eindrahtbusabschnitt (b1) ist, da diese nun über das Transfer-Gate (TG) miteinander verbunden sind.

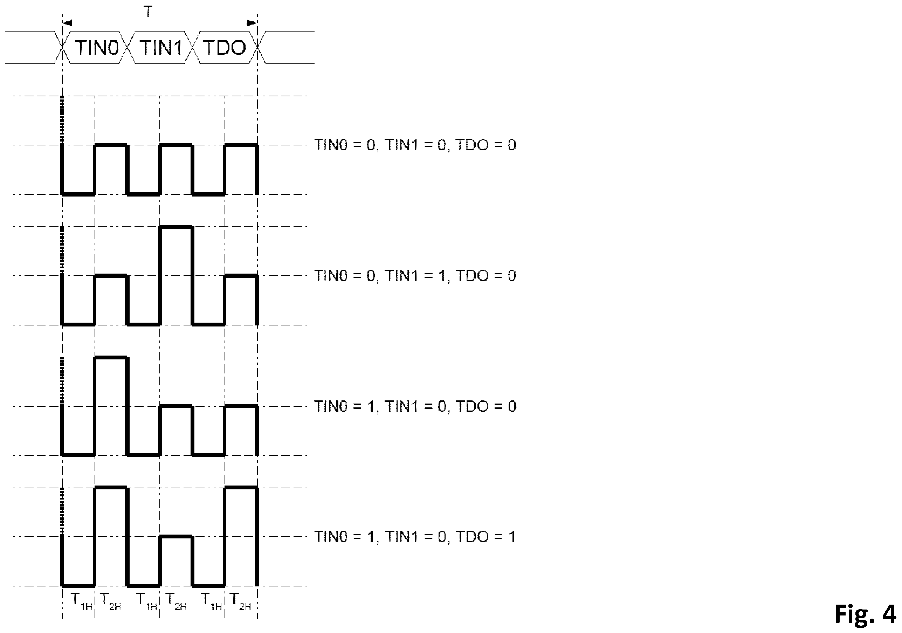

Fig. 4 zeigt eine beispielhafte Protokollsequenz von drei aufeinanderfolgenden Zeitschlitzen (TIN0,TIN1,TDO). In anderen Implementationen der Erfindung kann ein Zeitschlitzpaket auch mehr als drei Zeitschlitze (TIN0, TIN1, TDO) umfassen. Im ersten Zeitschlitz (TINO) werden typischerweise Kontrolldaten übertragen, die dem TMS-Signal des Standard-Boundary-Scan (IEEE 1149) entsprechen. Dieses Signal steuert typischerweise den Zustand des endlichen Automaten gemäß dem Zustandsdiagram der Fig. 1. Im zweiten Zeitschlitz werden typischerweise die Daten übertragen, die dem TDI-Signal des Standard-Boundary-Scans (IEEE 1149) entsprechen. In diesen beiden Zeitschlitzen überträgt der Bus-Master (BM) Daten auf den Busknoten. Sollte parallel auch der Busknoten senden, so überschreibt der Busknoten den Bus-Master (BM), wenn dessen schaltbare Stromquelle (S_{1H}, I₁) ausgeschaltet ist. Umgekehrt kann der Bus-Master (BM) den Busknoten überschreiben, wenn die schaltbare Stromquelle (S_{2H},I₂) des Busknotens ausgeschaltet ist. Ein Überschreiben des Bus-Masters (BM) durch den Busknoten kann der Bus-Master (BM) dadurch detektieren, dass die gesendeten Daten (TDAout₁) im Hinblick auf ihren logischen Inhalt darauf durch eine Logik im Bus-Master (BM) überprüft werden, ob diese mit den empfangenen Daten (TDAin₁) in der betreffenden Halbtaktperiode übereinstimmen, in der der Systemtakt (TCKout₁) den dominierenden Schalter (S_{1L}) nicht schließt. Im Falle einer solchen Asynchronizität kann der Bus-Master durch permanentes Halten des Spannungspegels auf dem Eindrahtdatenbus (b1,b2,b3) oder dem angeschlossenen ersten Eindrahtdatenbusabschnitt (b1) des Eindrahtdatenbusses (b1,b2,b3) im dritten Spannungsbereich (V_{B3}) bei geeigneter Auslegung der State-Machine des Test-Controllers (TAPC ) der Busknoten diese wieder re-synchronisieren. Hierzu muss die State-Machine des Test-Controllers (TAPC) des Busknotens so ausgelegt sein, dass ein permanentes im dritten Spannungsbereich (V_{B3}) im Kontrollfeld, also hier beispielsweise im ersten Zeitschlitz (TIN0), zu einem Reset in Form der Einnahme eines sogenannten "Idle-States" (TLR) als einem abwartenden Zustand des Test-Controllers (TAPC) führt. Dies ist bei einem Zustandsdiagramm eines JTAG-Controllers gemäß IEEE 1149-Standard der Fall. Dieses permanente Halten des Spannungspegels auf dem Eindrahtdatenbus (b1,b2,b3) oder auf dem angeschlossenen ersten Eindrahtdatenbusabschnitt (b1) des Eindrahtdatenbusses (b1,b2,b3) im dritten Spannungsbereich (V_{B3}) kann durch ein dauerhaftes Einschalten der schaltbaren Stromquelle (S_{1H}, I₁) des Bus-Masters (BM) für die Dauer des Reset-Vorgangs erfolgen.

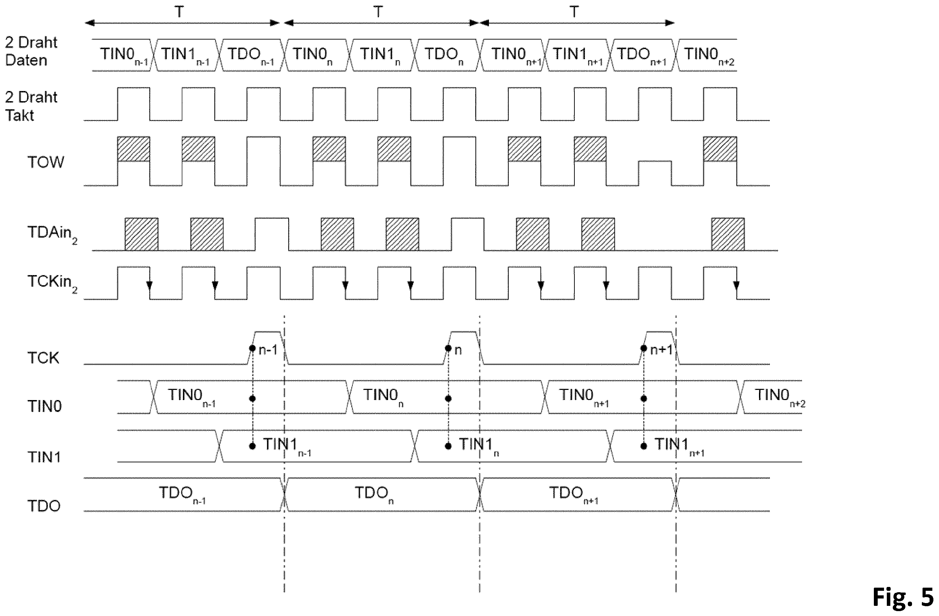

Fig. 5 zeigt eine beispielhafte Abfolge von Signalen. Eingabe sind die mit "2 Draht Daten" bezeichneten Zweidraht basierenden Daten. In dem Beispiel sind drei aufeinanderfolgende Zeitschlitzpakete (n-1,n,n+1) mit beispielhaft je drei Zeitschlitzen (TIN0,TIN1,TDO) gezeigt. Die Verwendung von mehr als drei Zeitschlitzen je Zeitschlitzpakete ist selbstverständlich denkbar. Die Bedeutung der jeweiligen Zeitschlitze innerhalb eines Zeitschlitzpakets hängt nur von der zeitlichen Position ab und ändert sich nicht. Wenn in dieser Beschreibung vom ersten Zeitschlitz (TIN0), zweiten Zeitschlitz (TIN1) und dritten Zeitschlitz (TDO) die Rede ist, so ist das eine reine Bezeichnung und bezieht sich nicht auf die Position innerhalb eines Zeitschlitzpaketes. Vorzugsweise ist die zeitliche Positionierung der einzelnen mindestens drei Zeitschlitze (TIN0, TIN1, TDO) innerhalb der Zeitschlitzpakete immer gleich oder zumindest durch einen Algorithmus vorhersagbar. Auch zeigt die Fig. 5 den zugehörigen Systemtakt (2 Draht Takt). Im Zeitschlitzpaket n-1 liefert der Busknoten im Zeitschlitz TDOₙ₋₁ eine logische 1 und im Zeitschlitzpakte n im Zeitschlitz TDOₙ eine logische 1 und im Zeitschlitzpakte n+1 im Zeitschlitz TDOₙ₊₁ eine logische 0. Die vom Bus-Master (BM) gesendeten Daten in den Zeitschlitzen TIN0ₙ₋₁, TIN1ₙ₋₁, TIN0ₙ, TIN1ₙ, TIN0ₙ₊₁, TIN1ₙ₊₁ sind in ihrem logischen Gehalt nicht festgelegt und darum schraffiert. Das mit "bₙ" bezeichnete Signal soll den Potenzialverlauf auf dem Eindrahtdatenbus (b1,b2,b3...bₙ,-..bₘ) oder einem angeschlossenen n-ten Eindrahtdatenbusabschnitt (bₙ) des Eindrahtdatenbusses (b1,b2,b3...bₙ,...bₘ) schematisch veranschaulichen. Aus diesem Potenzialverlauf auf dem betroffenen Eindrahtdatenbusabschnitt (b_{b}) erzeugt beispielhaft der erste Komparator (C_{2H}) die durch den betroffenen Busknoten empfangenen Daten (TDAin₂). Der zweite Komparator (C_{2L}) erzeugt beispielhaft aus dem Potenzialverlauf auf dem betroffenen Eindrahtdatenbusabschnitt (b_{b}) das durch den Busknoten empfangene Taktsignal (TCKin₂), das dem rekonstruierten Systemtakt entspricht. Bei geeigneter Synchronisierung von betroffenem Busknoten und Bus-Master erzeugt der betroffene Busknoten einen internen Systembasistakt (TCK), der erst in der zweiten Halbtaktperiode der Systemtaktperiode (T) des dritten Zeitschlitzes (TDOₙ) einen Puls mit der Dauer einer Halbtaktperiode zeigt. Mit der steigenden Flanke dieses Signals tastet der Busknoten in diesem Beispiel die logischen Werte auf der Leitung (TDAin₂) ab. Mit der fallenden Flanke zu Beginn des nächsten Zeitschlitzpaketes wird der in diesem Beispiel zu sendende Wert (TDO) geändert. TDAout₂ wird jedoch erst im dritten Zeitschlitz (TDOₙ₊₁) des folgenden Zeitschlitzpaketes aktiv, wenn der betroffene Busknoten senden darf. Dem Fachmann ist klar, dass die Steuerung nicht nur mittels der in Fig. 5 dargestellten Steuerung auf Basis der fallenden Flanke des Systemtaktes (TCK) möglich ist sondern auch anhand der steigenden Flanke.

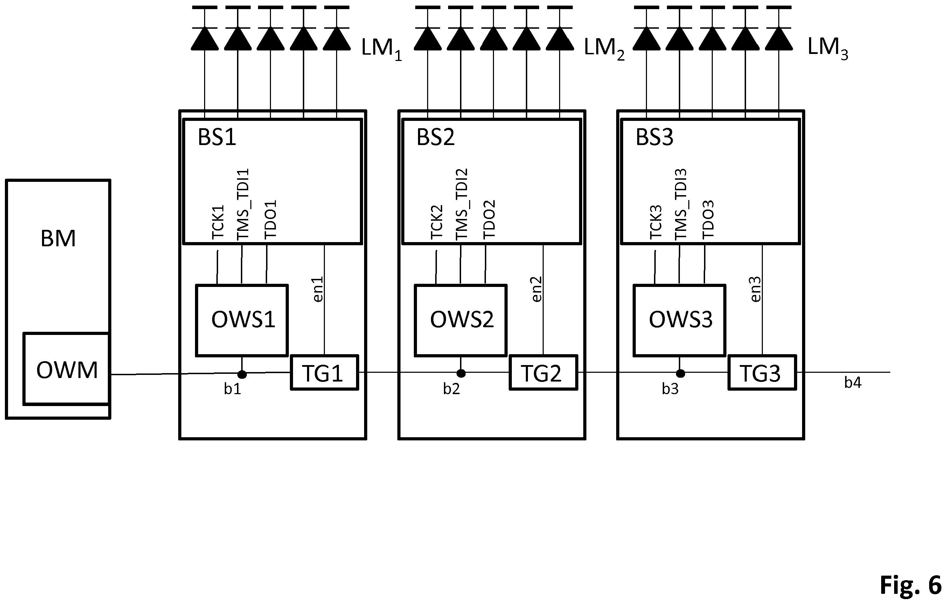

Fig. 6 zeigt einen beispielhaften Eindrahtdatenbus (b1,b2,b3) mit drei Busknoten (BS1,BS2,BS3) und drei Eindrahtdatenbusabschnitten (b1,b2,b3) und einem Bus-Master (BM). Der erste Eindrahtdatenbusabschnitt (b1) verbindet den Bus-Master (BM) mit dem ersten Busknoten (BS1).

Der zweite Eindrahtdatenbusabschnitt (b2) verbindet den zweiten Busknoten (BS2) mit dem ersten Busknoten (BS1). Der dritte Eindrahtdatenbusabschnitt (b3) verbindet den dritten Busknoten (BS2) mit dem zweiten Busknoten (BS2).

Der Eindrahtdatenbus wird durch einen Bus-Master (BM) mittels einer Master-Eindrahtdatenbusschnittstelle (OWM) gesteuert, an die der erste Eindrahtdatenbusabschnitt (b1) angeschlossen ist.

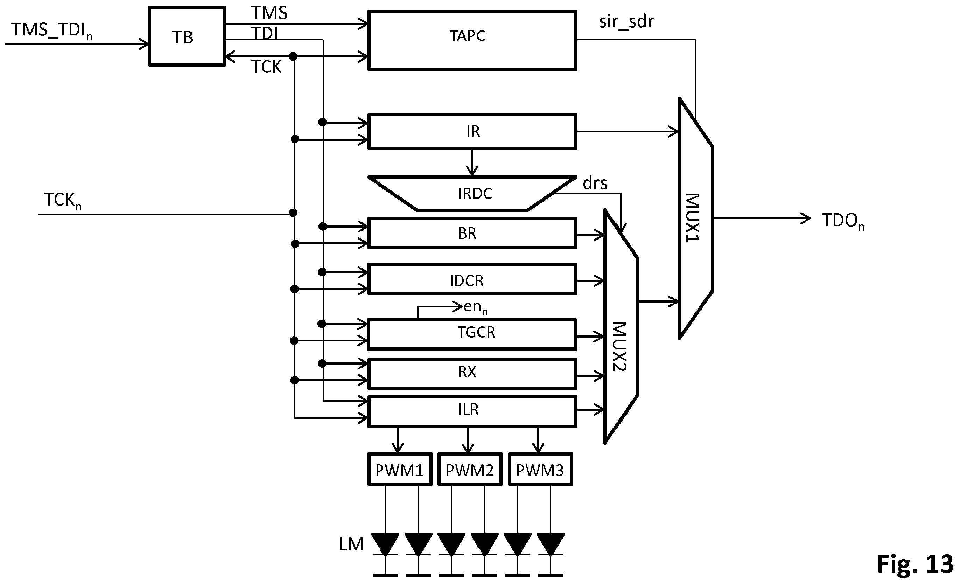

Die erste Eindrahtdatenbusschnittstelle (OWS1) ist mit dem ersten Eindrahtdatenbusabschnitt (b1) verbunden. Sie empfängt über diesen ersten Eindrahtdatenbusabschnitt (b1) Daten vom Bus-Master und sendet solche zu diesem. Intern stellt sie einen ersten rekonstruierten Systemtakt (TCK1) bereit, mit dem die interne JTAG-Schnittstelle des ersten Bus-knotens betrieben wird. Des Weiteren stellt sie das erste kombinierte TMS-TDI-Signal (TMS_TDI1) bereit, das in diesem Beispiel im Zeitmultiplex das Test-Mode-Signal (TMS) und das Dateneingangssignal (TDI) umfasst. Mit dem Test-Mode-Signal (TMS) wird der endliche Automat (finite state machine) des Test-Controllers (TAPC) der JTAG-Schnittstelle des ersten Busknotens gesteuert. Die Daten des TDI-Signalanteils werden zum Beschicken der Schieberegister der JTAG-Schnittstelle des ersten Busknotens benutzt. Umgekehrt liefert die JTAG-Schnittstelle mit dem seriellen TDO Ausgangssignal Daten aus den Registern der JTAG-Schnittstelle des ersten Busknotens. Durch ein erstes Transfer-Gate (TG1) kann der erste Eindrahtdatenbusabschnitt (b1) mit dem nachfolgenden zweiten Eindrahtdatenbusabschnitt (b2) verbunden werden. Hierzu beschreibt der Bus-Master ein hier nicht gezeichnetes Transfergate-Control-Register (TGCR) (siehe z.B. Fig. 13) über den JTAG-Bus und setzt ein Flag, das die erste Enable-Leitung (en1) setzt oder löscht. In Abhängigkeit von dem Signal auf der ersten Enable-Leitung (en1) wird das erste Transfer-Gate (TG1) des ersten Bus-knotens geöffnet oder geschlossen. Somit kann mittels eines Befehls vom Bus-Master (BM) der Eindrahtdatenbus (b1,b2,b3) verlängert und verkürzt werden.

Die zweite Eindrahtdatenbusschnittstelle (OWS2) ist mit dem zweiten Eindrahtdatenbusabschnitt (b2) verbunden. Sie empfängt über diesen ersten Eindrahtdatenbusabschnitt (b2) Daten vom Bus-Master (BM), wenn der erste Busknoten (BS1) sein Transfer-Gate (TG1) geschlossen hat. Die zweite Eindrahtdatenbusschnittstelle (OWS2) sendet auch Daten zu dem Bus-Master (BM). Intern stellt sie einen zweiten rekonstruierten Systemtakt (TCK2) bereit, mit dem die interne JTAG-Schnittstelle des zweiten Busknotens (BS2) betrieben wird. Des Weiteren stellt sie das zweite kombinierte TMS-TDI-Signal (TMS_TDI2) bereit, das in diesem Beispiel im Zeitmultiplex das Test-Mode-Signal (TMS) und das Dateneingangssignal (TDI) umfasst. Mit dem Test-Mode-Signal (TMS) wird der endliche Automat (finite state machine) des Test-Controllers (TAPC) der JTAG-Schnittstelle des zweiten Busknotens (BS2) gesteuert. Die Daten des TDI-Signalanteils werden zum Beschicken der Schieberegister der JTAG-Schnittstelle des zweiten Busknotens benutzt. Umgekehrt liefert die JTAG-Schnittstelle des zweiten Busknotens mit dem seriellen TDO Ausgangssignal Daten aus den Registern der JTAG-Schnittstelle des zweiten Busknotens. Durch ein zweites Transfer-Gate (TG2) kann der zweite Eindrahtdatenbusabschnitt (b2) mit dem dritten Eindrahtdatenbusabschnitt (b3) verbunden werden. Hierzu beschreibt der Bus-Master ein hier nicht gezeichnetes Transfer-gate-Control-Register (TGCR) (siehe Fig. 13) über den JTAG-Bus und setzt ein Flag, das die zweite Enable-Leitung (en2) setzt oder löscht. In Abhängigkeit von dem Signal auf der zweiten Enable-Leitung (en2) wird das zweite Transfer-Gate (TG2) des zweiten Busknotens geöffnet oder geschlossen. Somit kann mittels eines Befehls vom Bus-Master (BM) der Eindrahtdatenbus (b1,b2,b3) noch weiter verlängert und verkürzt werden.

Die dritte Eindrahtdatenbusschnittstelle (OWS3) ist mit dem dritten Eindrahtdatenbusabschnitt (b3) verbunden. Sie empfängt über diesen dritten Eindrahtdatenbusabschnitt (b3) Daten vom Bus-Master (BM), wenn der erste Busknoten (BS1) sein Transfer-Gate (TG1) geschlossen hat und wenn der zweite Busknoten (BS2) ebenfalls sein zweites Transfer-Gate (TG2) geschlossen hat. Die dritte Eindrahtdatenbusschnittstelle (OWS3) sendet auch Daten zu dem Bus-Master (BM). Intern stellt sie einen dritten rekonstruierten Systemtakt (TCK3) bereit, mit dem die interne JTAG-Schnittstelle des dritten Busknotens (BS2) betrieben wird. Des Weiteren stellt sie das dritte kombinierte TMS-TDI-Signal (TMS_TDI3) bereit, das in diesem Beispiel im Zeitmultiplex das Test-Mode-Signal (TMS) und das Dateneingangssignal (TDI) für die JTAG-Schnittstelle des dritten Busknotens (BS3) umfasst. Mit dem Test-Mode-Signal (TMS) wird der endliche Automat (finite state machine) des Test-Controllers (TAPC) der JTAG-Schnittstelle des dritten Busknotens (BS3) gesteuert. Die Daten des TDI-Signalanteils werden zum Beschicken der Schieberegister der JTAG-Schnittstelle des dritten Bus-knotens (BS3) benutzt. Umgekehrt liefert die JTAG-Schnittstelle des dritten Busknotens (BS3) mit dem seriellen TDO-Ausgangssignal Daten aus den Registern der JTAG-Schnittstelle des dritten Busknotens (BS3). Durch ein drittes Transfer-Gate (TG3) kann der dritte Eindrahtdatenbusabschnitt (b3) mit weiteren Eindrahtdatenbusabschnitten (b_{b}) verbinden. Hier soll der dritte Busknoten aber beispielhaft den Eindrahtdatenbus (b1,b2,b3) abschließen.

Jeder der Busknoten ist mit Gruppen von Leuchtmitteln (LM1,LM2,LM3) verbunden, die durch den jeweiligen Busknoten (BS1,BS2,BS3) gesteuert werden. Andere Verbraucher elektrischer Energie sind ebenso einsetz- und ansteuerbar.

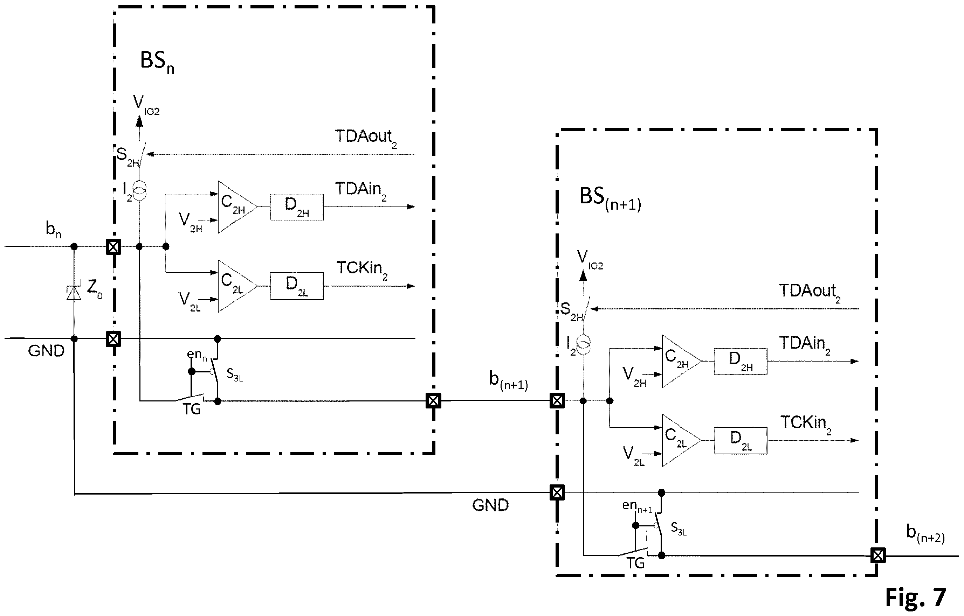

Fig. 7 entspricht der Aneinanderreihung zweier Busknotendatenbusschnittstellen in Form von zwei rechten Hälften der Fig. 3. Ein vorausgehender n-ter Eindrahtdatenbusabschnitt (b_{b}) ist mit einem n-ten Busknoten (BSₙ) verbunden. Dieser n-te Busknoten (BSₙ) kann mittels seines Transfergates (TG) diesen vorausgehenden n-ten Eindrahtdatenbusabschnitt (b_{b}) mit dem n+1-ten Eindrahtdatenbusabschnitt (b₍ₙ₊₁₎) verbinden. Sofern das Transfer-Gate (TG) des n-ten Busknotens (BSₙ) geöffnet ist, legt ein dritter Schalter (S_{3L}) das Potenzial des n+1-ten Eindrahtdatenbusabschnitts(b₍ₙ₊₁₎) und damit aller nachfolgenden Eindrahtdatenbusabschnitte (b₍ₙ₊₂₎) auf ein definiertes Potenzial und verhindert damit die versehentliche Datenübertragung.

Der n+1-te Busknoten (BS₍ₙ₊₁₎) kann mittels seines Transfer-Gates (TG) wieder diesen vorausgehenden n+1-ten Eindrahtdatenbusabschnitt (b₍ₙ₊₁₎) mit dem n+2-ten Eindrahtdatenbusabschnitt (b₍ₙ₊₂₎) verbinden. Sofern das Transfer-Gate des n+1-ten Busknotens (BS₍ₙ₊₁₎) geöffnet ist, legt ein dritter Schalter (S_{3L}) wieder das Potenzial des n+2-ten Eindrahtdatenbusabschnitts (b₍ₙ₊₂₎) und damit aller nachfolgenden Eindrahtdatenbusabschnitte (b₍ₙ₊₃₎), sofern vorhanden, auf ein definiertes Potenzial und verhindert damit die versehentliche Datenübertragung.

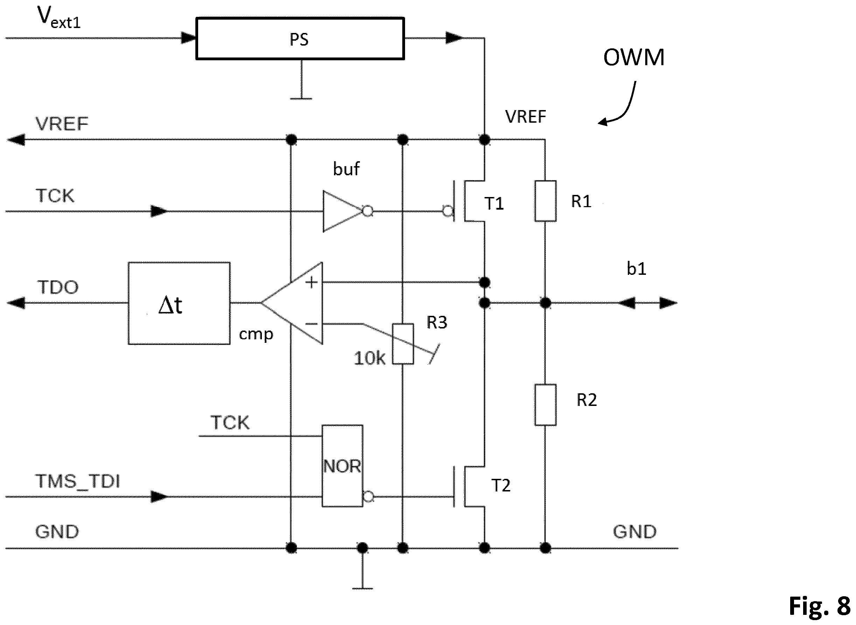

Fig. 8 zeigt einen Implementierungsvorschlag für eine Master-Eindrahtdatenbusschnittstelle (OWM) mit z.B. umgekehrten Spannungsvorzeichen. Ein Spannungsregler (PS) erzeugt aus einer externen Versorgungsspannung (Vₑₓₜ₁) eine Referenzspannung (VREF). Der einmal pro Busknoten (BS1,BS2,BS3) vorhandene unterer Widerstand (R_{0L}) und der oberer Widerstand (R_{0H}) des Spannungsteilerpaares, das beispielhaft den Pull-Schaltkreis bildet, werden auf Seiten des Bus-Masters (BM) durch den ersten Widerstand (R1) und den zweiten Widerstand (R2) gebildet. Der Pull-Schaltkreis hält den Eindrahtdatenbus (b1,b2,b3) im zweiten Spannungsbereich (V_{B2}) auf einem mittleren Potenzial (V_{M}), wenn keiner der anderen Schalter (S_{1L},S_{1H},I₁,S_{2H},I₂) aktiv ist. Hier ist beispielhaft der erste Eindrahtdatenbusabschnitt (b1) am Ausgang der Master-Eindrahtdatenbusschnittstelle (OWM) angeschlossen. Der Schalter (S_{1H}) der steuerbaren Stromquelle (S_{1H},I₁) jedes Busknotens (BS1,BS2,BS3) (Sender des Bus-knotens) wird auf Seiten des Bus-Masters durch den ersten Transistor (T1) gebildet. Der dominierende Schalter (S_{1L}) jedes Busknotens (BS1,BS2,BS3) wird auf Seiten des Bus-Masters (BM) durch den zweiten Transistor (T2) gebildet. Dieser zweite Transistor (T2) ist in diesem Beispiel ein N-Kanal-Transistor. Der erste Transistor (T1) ist in diesem Beispiel ein P-Kanal-Transistor. Über einen z.B. invertierenden Pufferschaltkreis (buf) wird der erste Transistor (T1) mit dem Systemtakt (TCK) angesteuert. Über ein NOR-Gatter (NOR) wird der zweite Transistor (T2) mit dem kombinierten TMS-TDI Signal (TMS_TDI) angesteuert, wenn das Systemtaktsignal (TCK) inaktiv ist. Durch den Spannungsteiler (R3) wird eine Referenzspannung erzeugt, mit der der Komparator (cmp) den Spannungspegel auf dem angeschlossenen ersten Eindrahtdatenbusabschnitt (b1) vergleicht und das Datensignal (TDO) für die weitere Verarbeitung innerhalb des Bus-Masters (BM) erzeugt.

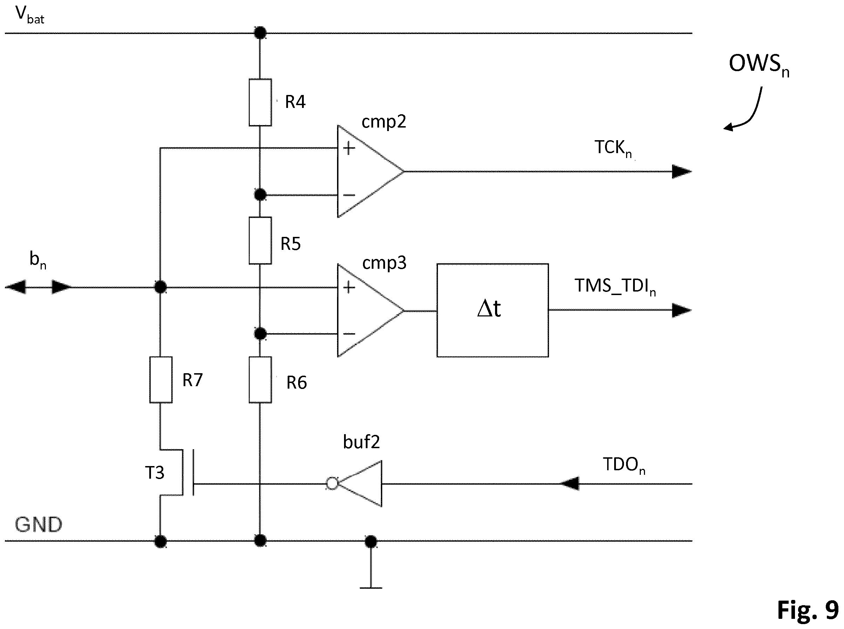

Fig. 9 zeigt eine beispielhafte Implementation der n-ten Eindrahtdatenbusschnittstelle (OWSₙ) eines n-ten Busknotens (BSₙ) der Busknoten (BS1,BS2,BS3) mit z.B. umgekehrten Spannungsvorzeichen passend zur Master-Eindrahtdatenbusschnittstelle (OWM) der Fig. 8. Die Eindrahtdatenbusschnittstelle (OWSₙ) des n-ten Busknotens (BSₙ) ist beispielhaft an den n-ten Eindrahtdatenbusabschnitt (bₙ) angeschlossen. Der Schalter der steuerbaren Stromquelle (S_{2H}, I₂) für den Sender des Busknotens wird durch den dritten Transistor (T3) gebildet. Dessen Innenwiderstand wird durch den seriell geschalteten siebten Widerstand (R7) bestimmt. Durch den Spannungsteiler aus dem vierten Widerstand (R4), dem fünften Widerstand (R5) und den sechsten Widerstand (R6) werden zwei Referenzspannungen aus der Versorgungsspannung (V_{bat}) des Busknotens erzeugt. Mit diesen zwei Referenzspannungen vergleichen ein zweiter Komparator (cmp2) und ein dritter Komparator (cmp3) das Potenzial auf dem beispielhaft angeschlossenen n-ten Eindrahtdatenbusabschnitt (bₙ). Sie erzeugen hieraus den rekonstruierten Systemtakt (TCKₙ) des n-ten Busknotens (BSₙ) und das n-te kombinierte TMS-TDI-Signal (TMS_TDIₙ) innerhalb des n-ten Busknotens (BSₙ) für die Ansteuerung des Test-Controllers (TAPC) der JTAG-Schnittstelle innerhalb des n-ten Busknotens (BSₙ). Hierbei werden Takt und Daten durch eine Verzögerungseinheit (Δt) für das kombinierte TMS-TDI-Signal (TMS_TDIₙ) wieder synchronisiert. Das Ausgangssignal der JTAG-Schnittstelle des n-ten Busknotens (BSₙ) wird in diesem Beispiel genutzt, um über einen invertierenden zweiten Pufferschaltkreis (buf2) den dritten Transistor (T3) anzusteuern. Dem Fachmann ist es ein Leichtes, die zeitliche Struktur der Signale durch eine geeignete Logik sicherzustellen.

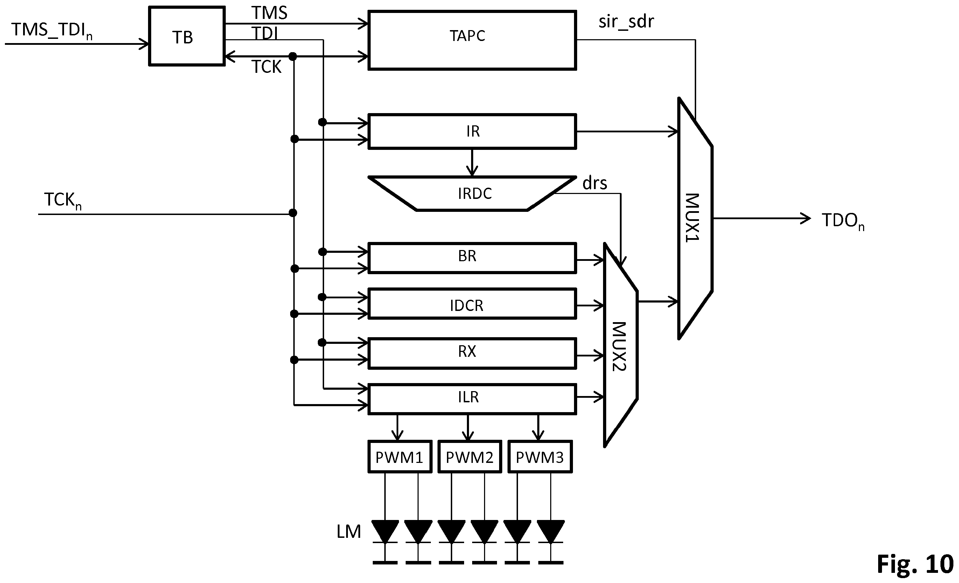

Fig. 10 zeigt die innere Struktur einer erfindungsgemäßen JTAG-Schnittstelle. Diese ist zu der in dem IEEE 1149-Standard vorgesehenen Architektur kompatibel, so dass auf dem Markt erhältliche Software genutzt werden kann, was einen erheblichen Vorteil darstellt.

In diesem Beispiel wird das kombinierte TMS-TDI-Signal (TMS_TDIₙ) in einer Testdatenaufbereitung (TB) synchron zum Systemtakt (TCK) in das Test-Mode-Signal (TMS) und die seriellen Eingangsdaten (TDI) zerlegt. Mit dem Test-Mode-Signal (TMS) wird wieder der Test-Controller (TAPC) synchron zum Takt entsprechend dem bereits aus dem Stand der Technik bekannten und im Zusammenhang mit der Fig. 1 beschriebenen Zustandsdiagramm gesteuert. Dieses Zustandsdiagramm eines Test-Controllers (TAPC) kennzeichnet im Sinne der Erfindung eine JTAG-Schnittstelle, da durch Einhaltung dieses Zustandsdiagramms erst Software-Kompatibilität hergestellt wird. Durch das Steuersignal (sir_sdr) für den ersten Multiplexer (MUX1) schaltet der Test-Controller zwischen dem Instruktionsregister (IR) und den Datenregistern (DR) mittels des ersten Multiplexers (MUX1) um. Der serielle Dateneingang (TDI) wird auf alle Datenregister (BR, IDCR, RX, ILR), das Instruktionsregister (IR) und ggf. weitere Datenregister und ggf. weitere Datenregister geleitet. Alle diese Register sind typischerweise zweistufig ausgeführt. Das bedeutet, dass sie über ein Schieberegister einer Bit-Länge m und parallel dazu über ein Schattenregister der gleichen Länge m verfügen. Das Schieberegister dient dem Datentransport, während das Schattenregister die gültigen Daten enthält. Wie oben beschrieben, werden die Daten in Abhängigkeit vom Zustand des Test-Controllers (TAPC) vom Schieberegister in das Schattenregister geladen oder vom Schattenregister in das Schieberegister geladen oder geschoben oder die Daten ruhen. In dem Beispiel der Fig. 10 wird die JTAG-Schnittstelle von einem Instruktionsdekoder (IRDC) in Abhängigkeit vom Inhalt des Instruktionsregisters (IR) gesteuert. Beispielsweise ist es denkbar, dass der betrachtete Busknoten nur dann senden darf, wenn das Schattenregister des Instruktionsregisters (IR) an bestimmten Bit-Positionen bestimmte Werte, also eine bestimmte Sendeadresse enthält. Eine solche Adressierung kann aber auch in einem separaten Senderegister (SR) vorgenommen werden.

Besonders bevorzugt verfügt die JTAG-Schnittstelle über ein Busknotenadressregister (BKADR). Dieses gibt die Identifikationsnummer des Busknotens an. Des Weiteren verfügt die JTAG-Schnittstelle bevorzugt über ein Senderegister (SR). Dieses Senderegister (SR) wird durch den Bus-Master (BM) gesetzt und gibt die Nummer des Busknotens an, der senden soll/darf. Nur dann, wenn beide Adressen, die Adresse im Busknotenadressregister (BKADR) und die Adresse im Senderegister (SR) übereinstimmen, darf der betrachtete Busknoten (BSₙ) zur vorbestimmten Zeit senden. Um die Busknotenadressen in den Busknotenadressregistern (BKADR) der Busknoten bei der Initialisierung des Eindrahtdatenbussystems zu setzen, sind zu Anfang alle Transfer-Gates (TG) aller Busknoten geöffnet. Dies kann vorzugsweise durch einen speziellen Befehl an alle erreichbaren Instruktionsregister (IR) aller an den Eindrahtdatenbus (b1,b2,b3) angeschlossenen erfindungsgemäßen JTAG-Schnittstellen und erreichbaren Busknoten geschehen. Hierfür müssen die Instruktionsregister (IR) dieser JTAG-Schnittstellen in den niederwertigsten Bits, das sind die zuerst beschriebenen Schieberegisterbits, übereinstimmen. Der Bus-Master (BM) vergibt nach einem festgelegten Algorithmus dann die erste Busadresse an den ersten und einzigen Busknoten (BS1), der direkt mit ihm verbunden ist, durch Beschreiben des ersten Busknotenadressregister (BKADR) des ersten Busknotens (BS1). Dann testet der Bus-Master (BM) typischer-, aber nicht notwendiger Weise die Verbindung. Vorzugsweise kann das Busknotenadressregister (BKADR) des betrachteten Busknotens nur beschrieben werden, wenn das Transfer-Gate (TG) des betrachteten Busknotens offen, also nicht geschlossen ist. Hierdurch wird sichergestellt, dass nur der letzte Busknoten, also der erste Busknoten in der Folge von Busknoten vom Bus-Master (BM) aus, der sein Transfer-Gate (TG) nicht geschlossen hat, eine Busknotenadresse in sein Busknotenadressregister (BKADR) übernimmt. Nach einer solchen Übernahme wird das Transfer-Gate (TG) typischerweise automatisch oder per Software-Befehl des Bus-Masters (BM) geschlossen. Damit wird die im Busadressregister gespeicherte Busknotenadresse "eingefroren". Gleichzeitig kann nun die Adressierung des nachfolgenden Busknotens erfolgen. Um ein geordnetes Rücksetzen des Bussystems zu ermöglichen, wird beispielsweise ein für alle Busknoten gleicher Befehl im Instruktionsregister (IR) vorgesehen, der alle Transfer-Gate aller Busknoten öffnet, so dass eine Neuvergabe von Adressen erfolgen kann. Sofern nach einer Adressvergabe der Busknoten unter dieser Busknotenadresse nicht antwortet, ist der Busknoten entweder defekt oder existiert nicht. Im letzteren Fall kennt dann der Bus-Master die Position aller Busknoten und deren Anzahl.

Die beispielhafte JTAG-Schnittstelle der Fig. 10 umfasst ein standardgemäßes Bypass-Register (BR), das zum Vorbeileiten von Daten durch die JTAG-Schnittstelle dient. Darüber hinaus umfasst es in diesem Beispiel ein Identifikationsregister (IDCR) zum Auslesen einer Seriennummer des Schaltkreises und weitere Datenregister (RX), die dem JTAG-Standard entsprechen. Diese können beispielsweise Testregister und andere Register sein.

Erfindungsgemäß kann nun ein Beleuchtungsregister (ILR) vorgesehen sein. Im Beleuchtungsregister (ILR) legt der Bus-Master (BM) Daten zur Einstellung der Energieversorgungen für die Leuchtmittel (LM) ab. Typischerweise handelt es sich bei den Energieversorgungen um ein oder mehrere (hier drei) PWM-Treiber (PWM1,PWM2,PWM3), die eine PWM-modulierte Ausgangsspannung oder einen entsprechend modulierten Strom erzeugen.

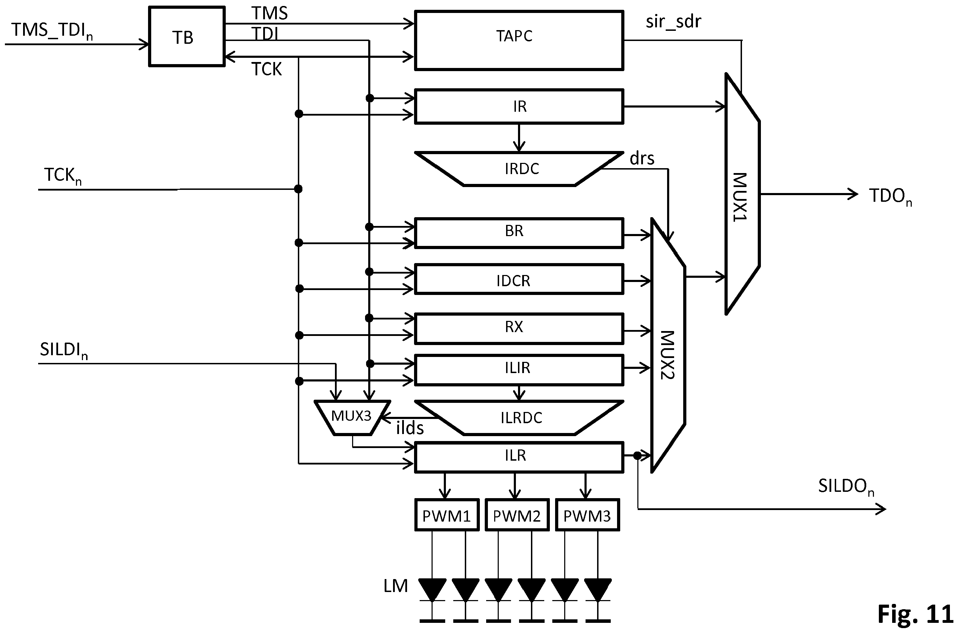

Fig. 11 zeigt ein ähnliches Diagramm wie das der Fig. 10 mit dem Unterschied, dass die JTAG-Schnittstelle zusätzlich ein Beleuchtungsinstruktionsregister (ILIR) aufweist. Dieses steuert über den Dekoder (ILRDC) einen dritten Multiplexer (MUX3). Dieser kann die seriellen Eingabedaten für das Beleuchtungsregister (ILR) zwischen einem seriellen Eingang für Beleuchtungsdaten (SILDIₙ) und dem seriellen Testdateneingang (TDI) mittels eines Beleuchtungsdatenauswahlsignals (ilds) umschalten. Gleichzeitig wird der Ausgang des Beleuchtungsregisters (ILR) auf den seriellen Ausgang für Beleuchtungsdaten (SILDOₙ) kopiert.

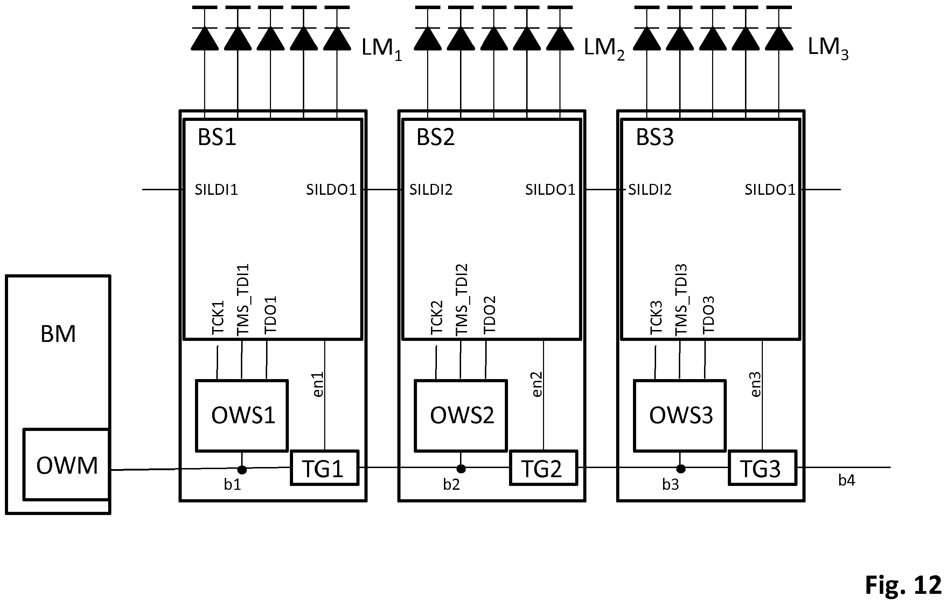

Fig. 12 zeigt die mögliche direkte Verbindung mehrerer Schaltkreise mit JTAG-Controllern entsprechend Fig. 11 über eine Verkettung mittels der Eingänge für Beleuchtungsdaten (SILDI1,SILDI2,SILDI3) und entsprechender Ausgänge für Beleuchtungsdaten (SILDO1,SILDO2,SILDO3).

Hierdurch ist es möglich, ohne komplizierte Adressierung schnell Daten für ganze Gruppen von Leuchtmitteln zu übertragen, da nur noch ein Baustein adressiert werden muss.

Fig. 13 zeigt eine JTAG-Schnittstelle ähnlich derjenigen der Fig. 10 mit dem Unterschied, dass Sie ein separates Transfer-Gate-Control-Register (TGCR) aufweist. Anstatt das Flag für das Öffnen und Schließen des Transfer-Gate (TG) im Instruktionsregister (IR) zu platzieren, kann auch ein separates Transfer-Gate-Control-Register (TGCR) vorgesehen werden, das die entsprechende Enable-Leitung (enₙ) des entsprechenden Busknotens (BSₙ) ansteuert.

### BEZUGSZEICHENLISTE

- b1: erster Eindrahtdatenbusabschnitt
- b2: zweiter Eindrahtdatenbusabschnitt
- b3: dritter Eindrahtdatenbusabschnitt
- bₙ: n-ter Eindrahtdatenbusabschnitt
- BKADR: Busknotenadressregister
- BM: Bus-Master
- BR: Bypass-Register
- BS1: beispielhafter erster Busknoten
- BS2: beispielhafter zweiter Busknoten
- BS3: beispielhafter dritter Busknoten
- BSₙ: beispielhafter n-ter Busknoten (Der relevante Busknoten wird an verschiedenen Stellen dieser Offenbarung mit BSₙ bezeichnet)
- buf: Pufferschaltkreis
- buf2: zweiter Pufferschaltkreis
- C_{2H}: erster Komparator auf Busknoten Seite. Der erste Komparator vergleicht den Spannungspegel auf dem Eindrahtdatenbus (b1,b2,b3) bzw. auf dem angeschlossenen Eindrahtdatenbusabschnitt (b1,b2,b3) mit einem ersten Schwellwert (V_{2H}) und gibt über eine erste Aufbereitung (D_{2H}) das durch den Busknoten empfangene Datensignal an das Innere der Schaltung des Busknotens, typischerweise der integrierten Schaltung oder des zu testenden oder zu steuernden Systems weiter. Der erste Komparator detektiert das Wechseln des Spannungspegels auf dem Eindrahtdatenbus (b1,b2,b3) bzw. auf dem angeschlossenen Eindrahtdatenbusabschnitt (b1,b2,b3) vom dritten Spannungsbereich (V_{B3}) auf der einen Seite in den ersten Spannungsbereich (V_{B1})oder zweiten Spannungsbereich (V_{B2}) auf der anderen Seite und umgekehrt
- C_{2L}: zweiter Komparator auf Busknoten Seite. Der zweite Komparator vergleicht den Spannungspegel auf dem Eindrahtdatenbus (b1,b2,b3) bzw. auf dem angeschlossenen Eindrahtdatenbusabschnitt (b1,b2,b3) mit einem zweiten Schwellwert (V_{2L}) und gibt über eine zweite Aufbereitung (D_{2L}) das durch den Busknoten empfangene Taktsignal an das Innere der Schaltung des Busknotens, typischerweise der integrierten Schaltung oder des zu testenden oder zu steuernden Systems weiter. Der zweite Komparator detektiert das Wechseln des Spannungspegels auf dem Eindrahtdatenbus (b1,b2,b3) bzw. auf dem angeschlossenen Eindrahtdatenbusabschnitt (b1,b2,b3) vom ersten Spannungsbereich (V_{B1}) auf der einen Seite in den dritten Spannungsbereich (V_{B3}) oder zweiten Spannungsbereich (V_{B2})auf der anderen Seite und umgekehrt
- C_{1H}: dritter Komparator auf Master Seite. Der dritte Komparator vergleicht den Spannungspegel auf dem Eindrahtdatenbus (b1,b2,b3) bzw. auf dem angeschlossenen Eindrahtdatenbusabschnitt (b1,b2,b3) mit einem dritten Schwellwert (V_{1H}) und gibt das durch den Master empfangene Datensignal an das Innere der Schaltung des Masters, typischerweise der Host-Prozessor, weiter. Der dritte Komparator detektiert das Wechseln des Spannungspegels auf dem Eindrahtdatenbus (b1,b2,b3) bzw. auf dem angeschlossenen Eindrahtdatenbusabschnitt (b1,b2,b3) vom dritten Spannungsbereich (V_{B3})auf der einen Seite in den ersten Spannungsbereich (V_{B1})oder zweiten Spannungsbereich (V_{B2}) auf der anderen Seite und umgekehrt
- CIR: Zustand "Instruktionsregisterdaten laden" des Test-Controllers
- CDR: Zustand "Datenregisterdaten laden" des Test-Controllers
- cmp: Komparator
- cmp2: zweiter Komparator
- cmp3: dritter Komparator
- D_{1H}: erste Aufbereitung
- D_{2H}: zweite Aufbereitung
- DR: Datenregister der JTAG-Schnittstelle (Es sind typischerweise mehrere Datenregister parallel geschaltet und werden über den zweiten Multiplexer (MUX2) während der Lesens der Datenregister (DR) ausgewählt.)
- drs: Auswahlsignal für das Datenregister, das gelesen werden soll.
- Δt: Verzögerungseinheit für das kombinierte TMS-TDI-Signal (TMS_TDIₙ)
- EDR1: Zustand "Datenregister Exit 1" des Test-Controllers (TAPC)
- EDR2: Zustand "Datenregister Exit 2" des Test-Controllers (TAPC)
- EIR1: Zustand "Instruktionsregister Exit 1" des Test-Controllers (TAPC)
- EIR2: Zustand "Instruktionsregister Exit 2" des Test-Controllers (TAPC)
- en1: erste Enable-Leitung zum Öffnen und Schließen des ersten Transfer-Gates (TG1) des ersten Busknotens (BS1)
- en2: zweite Enable-Leitung zum Öffnen und Schließen des zweiten Transfer-Gates (TG2) des zweiten Busknotens (BS2)
- en3: dritte Enable-Leitung zum Öffnen und Schließen des dritten Transfer-Gates (TG3) des dritten Busknotens (BS3)
- enₙ: n-tete Enable-Leitung zum Öffnen und Schließen des dritten Transfer-Gates (TG3) des n-ten Busknotens (BSₙ)
- GND: Bezugspotenzialleitung. Diese liegt typischerweise aber nicht notwendi-gerweise auf Masse. Sie besitzt das Bezugspotenzial (V₀).
- I₁: Stromquelle der steuerbaren Stromquelle (S_{1H}, I₁) für den Sender des Masters, also typischerweise des Host-Prozessors.
- I₂: Stromquelle der steuerbaren Stromquelle (S_{2H}, I₂) für den Sender des Busknotens, also der integrierten Schaltung oder des zu testenden oder steuernden Systems.
- IDCR: Identifikationsregister
- Ilds: Beleuchtungsdatenauswahlsignal
- ILR: Beleuchtungsregister
- ILIR: Beleuchtungsinstruktionsregister
- IR: Instruktionsregister der JTAG-Schnittstelle
- IRDC: Instruktionsdekoder
- LED: Leuchtdiode. Es kann sich im Sinne dieser Erfindung auch um die Parallel- und/oder Serienschaltung mehrerer LEDs handeln.
- LM1: Leuchtmittelgruppe 1, die durch den ersten Busknoten (BS1) gesteuert wird
- LM2: Leuchtmittelgruppe 2, die durch den zweiten Busknoten (BS2) gesteuert wird
- LM3: Leuchtmittelgruppe 3, die durch den dritten Busknoten (BS3) gesteuert wird
- Bus-Master: Masterschaltkreis. Der Bus-Master ist typischerweise der Host-Prozessor, über den der integrierte Schaltkreis, der Busknoten, gesteuert wird.
- MUX1: erster Multiplexer innerhalb der JTAG-Schnittstelle zum Umschalten zwischen den Datenregistern (DR) und dem Instruktionsregister (IR)
- MUX2: zweiter Multiplexer innerhalb der JTAG-Schnittstelle zum Auswählen des aktiven Datenregisters (DR)
- MUX3: dritter Multiplexer zum Umschalten zwischen einem seriellen Eingang für Beleuchtungsdaten (SILDIₙ) und den seriellen Eingangsdaten (TDI)
- NOR: invertierender ODER-Schaltkreis
- OWM: Master-Eindrahtdatenbusschnittstelle
- OWS1: erste Eindrahtdatenbusschnittstelle
- OWS2: zweite Eindrahtdatenbusschnittstelle
- OWS3: dritte Eindrahtdatenbusschnittstelle
- OWSₙ: Eindrahtdatenbusschnittstelle des n-ten Busknotens
- PCM: Puls-Code-Modulation
- PDM: Puls-Dichte-Modulation
- PDR: Zustand "Pause Datenregister" des Test-Controllers (TAPC)
- PFM: Puls Frequenz Modulation
- PIR: Zustand "Pause Instruktionsregister" des Test-Controllers (TAPC)
- POM: Pulse-On-Time Modulation und/oder Pulse-Off-Time-Modulation
- PS: Spannungsregler
- PWM: Puls-Weiten-Modulation. (Dieser Begriff umfasst im Sinne dieser Offenbarung alle bekannten Arten der Puls-Modulation wie beispielsweise PFM, PCM, PDM, POM etc.)
- PWM1: erste PWM-Einheit
- PWM2: zweite PWM-Einheit
- PWM3: dritte PWM-Einheit
- R₀: Innenwiderstand des Pull-Schaltkreises (R_{0H}, R_{0L}), der als vierte reale Spannungsquelle den Eindrahtdatenbus (b1,b2,b3) bzw. den angeschlossenen Eindrahtdatenbusabschnitt (b1,b2,b3) auf einem mittleren Potenzial (V_{M}) hält, wenn die anderen Sender (S_{1L}, S_{1H}, I₁, S_{2H}, I₂) nicht aktiv sind
- R_{0L}: unterer Widerstand des Spannungsteilerpaares, das beispielhaft den Pull-Schaltkreis bildet. Der Pull-Schaltkreis hält den Eindrahtdatenbus (b1,b2,b3) bzw. den angeschlossenen Eindrahtdatenbusabschnitt (b1,b2,b3) im zweiten Spannungsbereich (V_{B2}) auf einem mittleren Potenzial (V_{M}), wenn keiner der anderen Sender (S_{1L}, S_{1H}, I₁, S_{2H}, I₂) aktiv ist.
- R_{0H}: oberer Widerstand des Spannungsteilerpaares, das beispielhaft den Pull-Schaltkreis bildet. Der Pull-Schaltkreis hält den Eindrahtdatenbus (b1,b2,b3) bzw. den angeschlossenen Eindrahtdatenbusabschnitt (b1,b2,b3) im zweiten Spannungsbereich (V_{B2}) auf einem mittleren Potenzial (V_{M}), wenn keiner der anderen Sender (S_{1L}, S_{1H}, I₁, S_{2H}, I₂) aktiv ist.
- R1: erster Widerstand
- R_{1H}: Innenwiderstand der zweiten schaltbaren realen Spannungsquelle, die durch die schaltbare Stromquelle (S_{1H}, I₁) des Masters gebildet wird
- R2: zweiter Widerstand
- R_{2H}: Innenwiderstand der dritten schaltbaren realen Spannungsquelle, die durch die schaltbare Stromquelle (S_{1H}, I₁) des Busknotens gebildet wird
- R3: Spannungsteiler
- R4: vierter Widerstand
- R5: fünfter Widerstand
- R6: sechster Widerstand
- R7: siebter Widerstand zur Einstellung des Innenwiderstands des Schalter der steuerbaren Stromquelle (S_{2H}, I₂) für den Sender des Busknotens
- RUN: Zustand "Warten" des Test-Controllers (TAPC)
- RX: weitere Datenregister (DR), die dem JTAG-Standard entsprechen
- S_{1L}: dominierender Schalter. Der dominierende Schalter zwingt typischerweise die Datenleitung (TOW) auf das Potenzial des Bezugspotenzials (V₀), in dem er im Falle des Einschaltens die Datenleitung (TOW) mit der Bezugspotenzialleitung (GND) verbindet.
- S_{1H}: Schalter der steuerbaren Stromquelle (S_{1H}, I₁) für den Sender des Masters, also typischerweise des Host-Prozessors
- S_{2H}: Schalter der steuerbaren Stromquelle (S_{2H}, I₂) für den Sender des Busknotens
- SDRS: Zustand "Start des Datenregisterschiebens" im Test-Controller (TAPC)
- SILDIₙ: serieller Eingang für Beleuchtungsdaten
- SILDI1: erster serieller Eingang für Beleuchtungsdaten des ersten Busknotens (BS1)
- SILDI2: zweiter serieller Eingang für Beleuchtungsdaten des zweiten Busknotens (BS2)
- SILDI3: dritter serieller Eingang für Beleuchtungsdaten des dritten Busknotens (BS3)
- SILDOₙ: serieller Ausgang für Beleuchtungsdaten
- SILDO1: erster serieller Ausgang für Beleuchtungsdaten des ersten Busknotens (BS1)
- SILDO2: zweiter serieller Ausgang für Beleuchtungsdaten des zweiten Busknotens (BS2)
- SILDO3: dritter serieller Ausgang für Beleuchtungsdaten des dritten Busknotens (BS3)
- SIRS: Zustand "Start des Instruktionsregisterschiebens" im Test-Controller (TAPC)
- SIR: Zustand "Schieben Instruktionsregister" des Test-Controllers (TAPC)
- sir_sdr: Steuersignal für den ersten Multiplexer (MUX1) zwischen Instruktionsregister (IR) und Datenregistern (DR)
- SDR: Zustand "Schieben Datenregister" des Test-Controllers (TAPC)
- SR: Senderegister
- Busknoten: Busknoten-Schaltkreis. Der Busknoten ist typischerweise der integrierte Schaltkreis oder ein sonstiges elektrisches System, das durch den Host-Prozessor, den Bus-Master, über die Eindrahtdatenbus (b1,b2,b3) bzw. zumindest einen angeschlossenen Eindrahtdatenbusabschnitt (b1,b2,b3) gesteuert wird.
- T: Systemtaktperiode
- T1: erster Transistor
- T_{1H}: erste Halbtaktperiode von mindestens zwei Halbtaktperioden (T_{1H}, T_{2H}) der Systemtaktperiode (T)
- T2: zweiter Transistor
- T_{2H}: zweite Halbtaktperiode von mindestens zwei Halbtaktperioden (T_{1H}, T_{2H}) der Systemtaktperiode (T)
- T3: dritter Transistor
- TAPC: Test-Controller
- TB: Datenaufbereitung
- TCK: Takteingang (Testtakteingang) und Systemtakt
- TCK1: erster rekonstruierter Systemtakt innerhalb des ersten Busknotens (BS1)
- TCK2: zweiter rekonstruierter Systemtakt innerhalb des zweiten Busknotens (BS2)
- TCK3: dritter rekonstruierter Systemtakt innerhalb des dritten Busknotens (BS3)
- TCKₙ: n-ter rekonstruierter Systemtakt innerhalb des n-ten Busknotens (BSₙ)
- TCKin₂: durch den betrachteten Busknoten empfangenes Taktsignal (rekonstruierter Systemtakt).
- TCKout,: durch den Bus-Master zu sendendes Taktsignal (Systemtakt).
- TDAin₁: durch den Bus-Master (BM) empfangene Daten.
- TDAin₂: durch den Busknoten (BS1, B, BS3) empfangene Daten.
- TDAout,: Sendedaten aus dem Inneren des Bus-Masters (BM).
- TDAout₂: Sendedaten aus dem Inneren des Busknotens (BS1,BS2,BS3).
- TDI: serieller Dateneingang (Testdateneingang)
- TDO: dritter Zeitschlitz. Der dritte Zeitschlitz wird typischerweise zur Übertragung des TDO-Signals des JTAG-Test-Ports nach IEEE-Standard 1149 vom Busknoten zum Bus-Master verwendet. Es ist aber nicht zwingend notwendig, dass dieser Zeitschlitz auch an der ersten zeitlichen Position platziert wird. Andere zeitliche Reihenfolgen sind möglich.
- TDo: serieller Datenausgang (Testdatenausgang)
- TIN0: erster Zeitschlitz. Der erste Zeitschlitz wird typischerweise zur Übertragung des TMS-Signals des JTAG-Test-Ports nach IEEE 1149-Standard vom Bus-Master (BM) zum jeweiligen Bus-Knoten (BS1,BS2,BS3) verwendet. Es ist aber nicht zwingend notwendig, dass dieser Zeitschlitz auch an der ersten zeitlichen Position platziert wird. Andere zeitliche Reihenfolgen sind möglich.
- TIN1: zweiter Zeitschlitz. Der zweite Zeitschlitz wird typischerweise zur Übertragung des TDI-Signals des JTAG-Test-Ports nach IEEE 1149-Standard vom Bus-Master zum Busknoten (BS1,BS2,BS3) verwendet. Es ist aber nicht zwingend notwendig, dass dieser Zeitschlitz auch an der ersten zeitlichen Position platziert wird. Andere zeitliche Reihenfolgen sind möglich.
- TLR: Zustand "Testlogik zurücksetzen".
- TMS: Mode-Eingang (Testmode-Eingang) bzw. Test-Mode-Signal
- TMS_TDI1: erstes kombiniertes TMS-TDI-Signal innerhalb des ersten Busknotens (BS1)
- TMS_TDI2: zweites kombiniertes TMS-TDI-Signal innerhalb des zweiten Busknotens (BS2)
- TMS_TDI3: drittes kombiniertes TMS-TDI-Signal innerhalb des dritten Busknotens (BS3)
- TMS_TDIₙ: n-tes kombiniertes TMS-TDI-Signal innerhalb des n-ten Busknotens (BSₙ)
- TRST: optionaler Rücksetzeingang (Testrücksetzeingang)
- TG1: erstes Transfer-Gate des beispielhaft ersten Busknotens (BS1)
- TG2: zweites Transfer-Gate des beispielhaft zweiten Busknotens (BS2)
- TG3: drittes Transfer-Gate des beispielhaft dritten Busknotens (BS3)
- TGCR: Transfer-Gate-Control-Register
- UDR2: Zustand "Datenregister schreiben" des Test-Mode-Controllers
- UIR2: Zustand "Instruktionsregister schreiben" des Test-Mode-Controllers
- V₀: Bezugspotenzial im ersten Spannungsbereich (V_{B1}), das sich zumindest annähernd auf einem Eindrahtdatenbusabschnitt (b1,b2,b3) oder dem Eindrahtdatenbus (b1,b2,b3) einstellt, wenn der dominierende Schalter (S_{1L}) geschlossen ist. Die Bezugspotenzialleitung (GND) liegt auf dem Bezugspotenzial.
- V_{bat}: Versorgungsspannung des Busknotens
- V_{M}: Potenzial im zweiten Spannungsbereich (V_{B2}), dass sich einstellt, wenn kein anderer Sender (S_{1L}, S_{1H}, I₁, S_{2H}, I₂) aktiv ist und sich somit der Pull-Schaltkreis (R_{0H}, R_{0L}) durchsetzt
- V_{1H}: dritter Schwellwert. Der dritte Schwellwert separiert den dritten Spannungsbereich (V_{B3}) vom ersten Spannungsbereich (V_{B1}) und zweiten Spannungsbereich (V_{B2}) auf Bus-Master-Seite. Der dritte Schwellwert ist vorzugsweise gleich oder ähnlich dem ersten Schwellwert (V_{2H}).
- V_{2H}: erster Schwellwert. Der erste Schwellwert separiert den dritten Spannungsbereich (V_{B3}) vom ersten Spannungsbereich (V_{B1}) und zweiten Spannungsbereich (V_{B2}) auf Busknoten-Seite. Der erste Schwellwert ist vorzugsweise gleich oder ähnlich dem dritten Schwellwert (V_{1H}).
- V_{2L}: zweiter Schwellwert. Der zweite Schwellwert separiert den ersten Spannungsbereich (V_{B1}) vom dritten Spannungsbereich (V_{B3}) und zweiten Spannungsbereich (V_{B2}) auf der Busknoten-Seite.
- V_{B1}: erster Spannungsbereich, der zum zweiten Spannungsbereich (V_{B2}) hin durch den zweiten Schwellwert (V_{2L}) begrenzt wird
- V_{B2}: zweiter Spannungsbereich zwischen dem ersten Spannungsbereich (V_{B1}) und dem dritten Spannungsbereich (V_{B3}), der zum ersten Spannungsbereich (V_{B1}) hin durch den zweiten Schwellwert (V_{2L}) begrenzt wird und der zum dritten Spannungsbereich (V_{B1}) hin durch den ersten Schwellwert (V_{2H}) des Busknotens und/oder durch den dritten Schwellwert (V_{1H}) des Masters begrenzt wird
- V_{B3}: dritter Spannungsbereich, der zum zweiten Spannungsbereich (V_{B2}) hin durch den ersten Schwellwert (V_{2H}) des Busknotens und/oder durch den dritten Schwellwert (V_{1H}) des Bus-Masters begrenzt wird
- Vₑₓₜ₁: externe Versorgungsspannung
- V_{IO}: Versorgungsspannung für den Pull-Schaltkreis, hier dem Spannungsteiler (R_{0H}, R_{0L})
- V_{IO1}: Versorgungsspannung der schaltbaren Stromquelle (S_{1H}, I₁) des Bus-Masters, also des Host-Prozessors. Der Spannungspegel liegt im dritten Spannungsbereich (V_{B3})
- V_{IO2}: Versorgungsspannung der schaltbaren Stromquelle (S_{2H}, I₂) des Busknotens, also der integrierten Schaltung oder des zu testenden oder steuernden Systems. Der Spannungspegel liegt im dritten Spannungsbereich (V_{B3})
- VREF: Referenzspannung
- Z₀: Zenerdiode zur Spannungsbegrenzung auf einem Eindrahtdatenbusabschnitt (b1,b2,b3) oder dem Eindrahtdatenbus (b1,b2,b3)

## Patentansprüche

1. Datenbussystem mit einer Bezugspotenzialleitung (GND) und einem Eindrahtdatenbus (b1,b2,b3) zur Übertragung von Daten zwischen einen Bus-Master (BM) und zwischen mindestens zwei Busknoten (BS1,BS2,BS3),
- wobei der Eindrahtdatenbus (b1,b2,b3) durch die Busknoten (BS1,BS2,BS3) in mindestens zwei Eindrahtdatenbusabschnitte (b1,b2,b3) unterteilt wird und durch einen Busknoten, den abschließenden Busknoten (BS3) abgeschlossen wird und
- wobei jeder der Busknoten (BS1,BS2,BS3) bis auf einen ersten Busknoten (BS1) durch einen vorausgehenden Eindrahtdatenbusabschnitt (b2,b3) der Eindrahtdatenbusabschnitte (b1,b2,b3) mit einem vorausgehenden Busknoten (BS1,BS2) der Busknoten (BS1,BS2,BS3) und der eine erste Busknoten (BS1) durch einen vorausgehenden Eindrahtdatenbusabschnitt (b1) der Eindrahtdatenbusabschnitte (b1,b2,b3) mit dem Bus-Master (BM) verbunden ist und
- wobei jeder Busknoten (BS1,BS2,BS3) bis auf einen abschließenden Busknoten (BS3) durch einen nachfolgenden Eindrahtdatenbusabschnitt (b2,b3) der Eindrahtdatenbusabschnitte (b1,b2,b3) mit einem nachfolgenden Busknoten (BS3,BS4) der Busknoten (BS1,BS2,BS3) verbunden ist, und
- wobei es über einen Bus-Master (BM) mit einer Master-Eindrahtdatenbusschnittstelle (OWM) verfügt und
- wobei die Master-Eindrahtdatenbusschnittstelle (OWM) des Bus-Masters (BM) dazu vorgesehen ist mittels eines Datenbusprotokolls mit mehr als zwei physikalischen Spannungs- und/oder Strompegeln bidirektional Daten über den Eindrahtdatenbus (b1,b2,b3) oder zumindest einen Eindrahtdatenbusabschnitt (b1,b2,b3) der Eindrahtdatenbusabschnitte (b1,b2,b3), im Folgenden als betrachteter Eindrahtdatenbusabschnitt (b1,b2,b3) bezeichnet, zu senden und von diesem zu empfangen und
- wobei der betrachtete Eindrahtdatenbusabschnitt (b1,b2,b3) nur eine einzige Signalleitung umfasst und
- wobei an den betrachteten Eindrahtdatenbusabschnitt (b1,b2,b3) eine Eindrahtdatenbusschnittstelle (OWS1,OWS2,OWS3) eines Busknotens (BS1,BS2,BS3) der Busknoten (BS1,BS2,BS3), im Folgenden als betrachteter Busknoten bezeichnet, elektrisch angeschlossen ist und
- wobei die Eindrahtdatenbusschnittstelle (OWS1,OWS2,OWS3) des betrachteten Busknotens dazu vorgesehen ist mittels eines Datenbusprotokolls mit mehr als zwei physikalischen Spannungs- und/oder Strompegeln Daten von dem betrachteten Eindrahtdatenbusabschnitt (b1,b2,b3) zu empfangen und
- wobei die Eindrahtdatenbusschnittstelle (OWS1,OWS2,OWS3) des betrachteten Busknotens dazu vorgesehen ist mittels eines Datenbusprotokolls mit mehr als zwei physikalischen Spannungs- und/oder Strompegeln Daten über den betrachteten Eindrahtdatenbusabschnitt (b1,b2,b3) zu senden und
- wobei der betrachtete Busknoten (BS1,BS2, BS3) wiederum mit einer Master-Eindrahtdatenbusschnittstelle (OWM1,OWM2,OWM3) versehen ist und
- wobei die Master-Eindrahtdatenbusschnittstelle (OWM1,OWM2,OWM3) des betrachteten Busknotens (BS1,BS2,BS3) dazu vorgesehen ist mittels eines Datenbusprotokolls mit mehr als zwei physikalischen Spannungs- und/oder Strompegeln bidirektional Daten über zumindest einen nachfolgenden Eindrahtdatenbusabschnitt (b2,b3) der Eindrahtdatenbusabschnitte (b1,b2,b3), im Folgenden als nachfolgender Eindrahtdatenbusabschnitt (b2,b3) bezeichnet, zu einem nachfolgenden Busknoten (BS2,BS3) zu senden und von diesem zu empfangen und
- wobei der betrachtete Busknoten (BS1,BS2,BS3) über ein erstes Bus-Master-Control-Register (OWMCR) verfügt, das dazu ausgelegt ist, die Master-Eindrahtdatenbusschnittstelle (OWM1,OWM2,OWM3) des betrachteten Busknotens (BS1,BS2,BS3) zusteuern und
- wobei der Bus-Master (BM) über die Master-Eindrahtdatenbusschnittstelle (OWM) des Bus-Masters (BM) und den Eindrahtdatenbus (b1,b2,b3) oder den betrachteten Eindrahtdatenbusabschnitt (b1,b2,b3) und die Eindrahtdatenbusschnittstelle (OWS1,OWS2,OWS3) des betrachteten Busknotens das Bus-Master-Control-Register (OWMCR) des betrachteten Busknotens (BS1,BS2,BS3) beschreiben kann und somit den Zustand der Master-Eindrahtdatenbusschnittstelle (OWM1, OWM2, OWM3) des betrachteten Busknotens (BS1,BS2,BS3) steuern kann.

## Claims

1. A data bus system comprising a reference potential line (GND) and a single-wire data bus (b1, b2, b3) for transmitting data between a bus master (BM) and between at least two bus nodes (BS1, BS2, BS3),
- wherein the single-wire data bus (b1, b2, b3) is divided by the bus nodes (BS1, BS2, BS3) into at least two single-wire data bus sections (b1, b2, b3) and is terminated by a bus node, the terminating bus node (BS3), and
- wherein each of the bus nodes (BS1, BS2, BS3), except for a first bus node (BS1), is connected by a preceding single-wire data bus section (b2, b3) of the single-wire data bus sections (b1, b2, b3) to a preceding bus node (BS1, BS2) of the bus nodes (BS1, BS2, BS3), and the one first bus node (BS1) is connected by a preceding single-wire data bus section (b1) of the single-wire data bus sections (b1, b2, b3) to the bus master (BM), and
- wherein each bus node (BS1, BS2, BS3), except for a terminating bus node (BS3), is connected by a subsequent single-wire data bus section (b2, b3) of the single-wire data bus sections (b1, b2, b3) to a subsequent bus node (BS3, BS4) of the bus nodes (BS1, BS2, BS3), and
- wherein it is provided with a bus master (BM) with a master single-wire data bus interface (OWM), and
- wherein the master single-wire data bus interface (OWM) of the bus master (BM) is provided to bidirectionally send and receive data via the single-wire data bus (b1, b2, b3) or at least one single-wire data bus section (b1, b2, b3) of the single-wire data bus sections (b1, b2, b3), in the following referred to as the considered single-wire data bus section (b1, b2, b3), by means of data bus protocol with more than two physical voltage and/or current levels, and
- wherein the considered single-wire data bus section (b1, b2, b3) only has a single signal line, and
- wherein a single-wire data bus interface (OWS1, OWS2, OWS3) of one bus node (BS1, BS2, BS3) of the bus nodes (BS1, BS2, BS3), in the following referred to as considered bus node, is electrically connected to the considered single-wire data bus section (b1, b2, b3), and
- wherein the single-wire data bus interface (OWS1, OWS2, OWS3) of the considered bus node is provided to receive data from the considered single-wire data bus section (b1, b2, b3) by means of a data bus protocol with more than two physical voltage and/or current levels, and
- wherein the single-wire data bus interface (OWS1, OWS2, OWS3) of the considered bus node is provided to send data via the considered single-wire data bus section (b1, b2, b3) by means of a data bus protocol with more than two physical voltage and/or current levels, and
- wherein the considered bus node (BS1, BS2, BS3) is in turn provided with a master single-wire data bus interface (OWM1, OWM2, OWM3), and
- wherein the master single-wire data bus interface (OWM1, OWM2, OWM3) of the considered bus node (BS1, BS2, BS3) is provided to bidirectionally send data via at least a subsequent single-wire data bus section (b2, b3) of the single-wire data bus sections (b1, b2, b3), in the following referred to as the subsequent single-wire data bus section (b2, b3), by means of a data bus protocol with more than two physical voltage and/or current levels to a subsequent bus node (BS2, BS3) and to receive data therefrom, and
- wherein the considered bus node (BS1, BS2, BS3) is provided with a first bus master control register (OWMCR) configured to control the master single-wire data bus interface (OWM1, OWM2, OW3) of the considered bus node (BS1, BS2, BS3), and
- wherein the bus master (BM) can write the bus master control register (OWMCR) of the considered bus node (BS1, BS2, BS3) via the master single-wire data bus interface (OWM) of the bus master (BM) and the single-wire data bus (b1, b2, b3) or the considered single-wire data bus section (b1, b2, b3) and the single-wire data bus interface (OWS1, OWS2, OWS3) of the considered bus node and can thus control the state of the master single-wire data bus interface (OWM1, OWM2, OWM3) of the considered bus node (BS1, BS2, BS3).

## Revendications

1. Système de bus de données doté d'un conducteur de potentiel de référence (GND) et d'un bus de données à un fil (b1, b2, b3) destiné à la transmission de données entre un maître bus (BM) et au moins deux noeuds de bus (BS1, BS2, BS3),
- dans lequel le bus de données à un fil (b1, b2, b3) est divisé par les noeuds de bus (BS1, BS2, BS3) en au moins deux sections de bus de données à un fil (b1, b2, b3) et est terminé par un noeud de bus (le noeud de bus terminal (BS3)), et
- dans lequel chacun des noeuds de bus (BS1, BS2, BS3) jusqu'à un premier noeud de bus (BS1) est relié à un noeud de bus précédent (BS1, BS2) des noeuds de bus (BS1, BS2, BS3) par une section précédente de bus de données à un fil (b2, b3) des sections de bus de données à un fil (b1, b2, b3) et l'un premier noeud de bus (BS1) est relié au maître bus (BM) par une section précédente de bus de données à un fil (b1) des sections de bus de données à un fil (b1, b2, b3) et
- dans lequel chaque noeud de bus (BS1, BS2, BS3) jusqu'à un noeud de bus terminal (BS3) est relié à un noeud de bus suivant (BS3, BS4) des noeuds de bus (BS1, BS2, BS3) par une section suivante de bus de données à un fil (b2, b3) des sections de bus de données à un fil (b1, b2, b3), et
- dans lequel il dispose d'un maître bus (BM) dotée d'une interface maîtresse de bus de données à un fil (OWM) et
- dans lequel l'interface maîtresse de bus de données à un fil (OWM) du maître bus (BM) est prévue pour émettre et recevoir des données bidirectionnelles par le biais du bus de données à un fil (b1, b2, b3) ou au moins d'une section de bus de données à un fil (b1, b2, b3) des sections de bus de données à un fil (b1, b2, b3), désignée par la suite comme section considérée de bus de données à un fil (b1, b2, b3), au moyen d'un protocole de bus de données avec plus de deux niveaux physiques de tension et/ou d'intensité et
- dans lequel la section considérée de bus de données à un fil (b1, b2, b3) ne comporte qu'un unique conducteur de signal et
- dans lequel à la section considérée de bus de données à un fil (b1, b2, b3) est électriquement connectée une interface de bus de données à un fil (OWS1, OWS2, OWS3) d'un noeud de bus (BS1, BS2, BS3) des noeuds de bus (BS1, BS2, BS3), désigné par la suite comme noeud de bus considéré, et
- dans lequel l'interface de bus de données à un fil (OWS1, OWS2, OWS3) du noeud de bus considéré est prévue pour recevoir des données de la section considérée de bus de données à un fil (b1, b2, b3) au moyen d'un protocole de bus de données avec plus de deux niveaux physiques de tension et/ou d'intensité et
- dans lequel l'interface de bus de données à un fil (OWS1, OWS2, OWS3) du noeud de bus considéré est prévue pour émettre des données par le biais de la section considérée de bus de données à un fil (b1, b2, b3) au moyen d'un protocole de bus de données avec plus de deux niveaux physiques de tension et/ou d'intensité et
- dans lequel le noeud de bus considéré (BS1, BS2, BS3) est aussi prévu avec une interface maîtresse de bus de données à un fil (OWM1, OWM2, OWM3) et
- dans lequel l'interface maîtresse de bus de données à un fil (OWM1, OWM2, OWM3) du noeud de bus considéré (BS1, BS2, BS3) est prévue pour émettre des données bidirectionnelles à un noeud de bus suivant (BS2, BS3) et en recevoir de celui-ci par le biais au moins d'une section suivante de bus de données à un fil (b2, b3) des sections de bus de données à un fil (b1, b2, b3), désignée par la suite comme section suivante de bus de données à un fil (b2, b3), au moyen d'un protocole de bus de données avec plus de deux niveaux physiques de tension et/ou d'intensité et
- dans lequel le noeud de bus considéré (BS1, BS2, BS3) dispose d'un premier registre de contrôle de maître bus (OWMCR), lequel est configuré pour commander l'interface maîtresse de bus de données à un fil (OWM1, OWM2, OWM3) du noeud de bus considéré (BS1, BS2, BS3) et
- dans lequel le maître bus (BM) peut, par le biais de l'interface maîtresse de bus de données à un fil (OWM) du maître bus (BM) et du bus de données à un fil (b1, b2, b3) ou de la section considérée de bus de données à un fil (b1, b2, b3) et de l'interface maîtresse de bus de données à un fil (OWS1, OWS2, OWS3) du noeud de bus considéré, écrire sur le registre de contrôle de maître bus (OWMCR) du noeud de bus considéré (BS1, BS2, BS3) et ainsi peut commander l'état de l'interface maîtresse de bus de données à un fil (OWM1, OWM2, OWM3) du noeud de bus considéré (BS1, BS2, BS3).
